(19)

Europäisches
Patentamt
European
Patent Office
Office européen
des brevets

(11) **EP 1 927 124 B1**

(12) **EUROPÄISCHE PATENTSCHRIFT**

(45) Veröffentlichungstag und Bekanntmachung des Hinweises auf die Patenterteilung:
**10.06.2015 Patentblatt 2015/24**

(21) Anmeldenummer: **06777051.1**

(22) Anmeldetag: **24.08.2006**

(51) Int Cl.:
*H01J 37/32* *(2006.01)*    *C23C 16/00* *(2006.01)*
*C23C 16/04* *(2006.01)*    *C23C 16/40* *(2006.01)*
*C23C 16/455* *(2006.01)*   *C23C 16/511* *(2006.01)*
*G10K 1/064* *(2006.01)*    *H05H 1/24* *(2006.01)*

(86) Internationale Anmeldenummer:
**PCT/EP2006/008302**

(87) Internationale Veröffentlichungsnummer:
**WO 2007/022976 (01.03.2007 Gazette 2007/09)**

(54) **VERFAHREN UND VORRICHTUNG ZUR INNENSEITIGEN PLASMABEHANDLUNG VON HOHLKÖRPERN**

METHOD AND DEVICE FOR THE PLASMA TREATMENT OF THE INTERIOR OF HOLLOW BODIES

PROCEDE ET DISPOSITIF DE TRAITEMENT AU PLASMA A L'INTERIEUR DE CORPS CREUX

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **24.08.2005  DE 102005040266**

(43) Veröffentlichungstag der Anmeldung:
**04.06.2008  Patentblatt 2008/23**

(73) Patentinhaber: **Schott AG**
**55122 Mainz (DE)**

(72) Erfinder:
• **BICKER, Matthias**
**55126 Mainz (DE)**
• **HORMES, Robert**
**CH-9116 Wolfertswil (CH)**

• **LOHMEYER, Manfred**
**55299 Nackenheim (DE)**

(74) Vertreter: **Herden, Andreas F.**
**Blumbach - Zinngrebe**
**PatentConsult**
**Patentanwälte**
**Alexandrastrasse 5**
**65187 Wiesbaden (DE)**

(56) Entgegenhaltungen:
**EP-A- 1 251 190     EP-A1- 0 773 167**
**WO-A-00/35256      WO-A-01/66818**
**WO-A-2004/031438   WO-A2-02/36850**
**DE-A1- 3 116 026   DE-A1- 4 316 349**
**DE-A1- 10 253 512  JP-A- 5 255 857**

EP 1 927 124 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft allgemein das innenseitige Plasmabehandeln hohlkörperförmiger Substrate, insbesondere von Substraten mit kleinen Durchmessern, wie etwa typische Pharmaverpackungen.

Aus der EP 1 206 389 B1 sind ein Verfahren und eine Vorrichtung zur sterilen Verpackung von Stoffen in Kunststoffbehältnisse bekannt. Dabei wird eine Plasmabehandlung, z.B. eine Plasmasterilisation, durchgeführt, bei der ein räumlich und/oder zeitlich selektives Anregen des Plasmas in verschiedenen Bereichen der Wände des Behältnisses vorgenommen. Mit dem Verfahren und der Vorrichtung soll eine aseptische, im Falle von Pharmaprodukten sogar eine pyrogenfreie Verpackung von Flüssigkeiten in Kunststoffbehältern, wie Ampullen, Flaschen oder Vials durchführbar und mit weiteren Bearbeitungsschritten kombinierbar sein.

Die EP 1 251 190 A1 beschreibt ein Verfahren zum gleichmäßigen Beschichten von Hohlkörpern, wobei das eine offene Ende des Hohlkörpers mit einem Deckel gasdicht verschlossen wird, der Hohlkörper in einen Plasma induzierten CVD Reaktor eingesetzt wird, an den Hohlkörper Vakuum angelegt wird, eine Beschichtungstemperatur eingestellt wird und die Plasma induzierte Beschichtung erfolgt.

Weiterhin ist aus der DE 196 29 877 C1 ein CVD-Verfahren und eine Vorrichtung zur Innenbeschichtung von Hohlkörpern bekannt, bei welchem die Beschichtungsqualität schon während der Herstellung vorausgesagt werden kann. Dabei wird ein Plasma-Impuls-Verfahren verwendet, bei dem das Plasma durch eine zeitliche Abfolge von Zündimpulsen gezündet wird, wobei sowohl während der Aufheizphase als auch während der Beschichtungsphase die zeitliche Korrelation der Lichtimpulse eines Sauerstoffplasmas mit den Zündimpulsen, sowie die Intensität mindestens einer Emissionslinie des Beschichtungsgases gemessen und ausgewertet wird.

Die DE 196 34 795 C2 beschreibt eine Plasma-CVD-Anlage mit einem Array von Mikrowellen-Plasmaelektroden und einer Steuerschaltung. Je zwei benachbarte Plasmaelektroden werden dabei durch die Steuerschaltung zu verschiedenen Zeiten mit Mikrowellenimpulsen beaufschlagt, wobei die Dauer der Impulse kurz gegenüber der Dauer eines üblicherweise für Plasma-Impuls-CVD-Verfahren eingesetzte Impulse.

Aus der DE 44 38 359 C2 ist ein Behälter aus Kunststoff mit einer Sperrbeschichtung bekannt, wobei die Sperrbeschichtung aus einem Schichtpaket mit sequentiell angeordneten Sperrschichten aus einem oder mehreren anorganischen Oxiden, Nitriden oder Oxinitriden oder einer Mischung davon bestehenden anorganischen und einem organischen polymeren Material besteht. Das Schichtpaket enthält dabei wenigstens zwei Sperrschichten aus dem anorganischen Material. Die Schichten werden bevorzugt mittels Plasmapolymerisation abgeschieden.

Eine Innenbeschichtung von Hohlkörpern ist aus weiteren Druckschriften bekannt. So ist aus der DE 31 16 026 A1 ein Verfahren zur Herstellung von biokompatiblen Schichten auf Innenseiten und/oder Außenseiten von Gefäßprothesen und für den Kontakt mit Blut oder anderen biologischen Flüssigkeiten bestimmte Schläuche bekannt. Dabei wird eine Abscheidung von Schichten mit einem Niederdruckplasma in einem Reaktionsrohr beschrieben, an das ein kombiniertes Pump- und Gasmischungssystem sowie ein Gaszuführungssystem angeschlossen ist. Das Plasma zur Beschichtung mit Materialien wie Kohlenstoff, Silizium, Polyacrylnitril, Polytetrafluoräthylen wird über konzentrische, induktiv mit einer Hochfrequenzleistung versorgte Ringelektroden erreicht.

Die EP 1 251 190 A1 offenbart ein Verfahren zum Beschichten von beispielsweise als Spritzenkörper ausgeführten Hohlkörpern über ein in einem Reaktor für chemisches Abscheiden aus der Gasphase (CVD) gezündetes Plasma.

Das Verfahren und die Vorrichtung aus der WO 02/36850 A2 dient auch zur Innen-Beschichtung von Hohlkörpern. Dabei wird ein über eine Einstrahlung von Mikrowellen erzeugtes Plasma aber nicht im Innenraum der Hohlkörper erzeugt.

Die WO 2004/031438 A1 beschreibt ein Verfahren zur Plasmabehandlung von hohlkörperförmigen Werkstücken, bei dem ein Prozessgas während der Plasmabehandlung zwischen gegenüberliegenden Seiten des Behandlungsraumes eingebracht bzw. abgeführt, d.h. abgepumpt, wird. Das zur Beschichtung von Hohlkörpern wie Plastikschläuchen eingesetzte und beschriebene Beschichtungsverfahren nutzt eine 13,56 MHz HF-Quelle zur Plasmaerzeugung und arbeitet mit Beschichtungsdrucken von 0,3 - 15 mbar.

Eine Ringelektrode wird rotationssymmetrisch an der Rohrkalibrierhülse gehalten, die gleichzeitig das Gegenpotential zur Ringelektrode bildet. Zwar können die Rohrkalibrierhülsen zur Anpassung an verschiedene Rohrdurchmesser austauschbar sein, jedoch ist der Umrüstaufwand nicht unerheblich.

Schließlich beschreibt die EP 0 773 167 A1 ein Verfahren und eine Vorrichtung zur Herstellung von u.a. flaschenartig ausgeführten Kunststoffbehältern, die mit einem Kohlenstofffilm überzogen werden. Dabei wird neben einer in den Behälter eingesetzten Elektrode eine äußere Elektrode eingesetzt, die einen Vakuumraum bildet.

Auch in der JP 05 255 857 A1 ist eine Filmabscheidung mittels eines CVD-Plasmas in rohrförmigen Hohlkörpern beschrieben, die beim Beschichtungsvorgang gedreht werden können.

Der Erfindung liegt die Aufgabe zugrunde, die Plasmabehandlung von kleinen und/oder langgestreckten Hohlkörpern mit engen Querschnitten zu verbessern. Die Beschichtung von derartigen hohlkörperförmigen Werkstücken ist eine technische Herausforderung, die trotz vieler bestehenden Herangehensweisen bisher nur ungenügend gelöst wurde.

Diese Aufgabe wird bereits in höchst überraschend einfacher Weise durch den Gegenstand der unabhängigen Ansprüche gelöst. Vorteilhafte Ausgestaltungen und Weiterbildungen der Erfindung sind in den Unteransprüchen angegeben.

Demgemäß sieht die Erfindung ein Verfahren zur Plasmabehandlung von Werkstücken vor, bei welchem in einer Reaktorkammer ein Behandlungsbereich wenigstens teilweise evakuiert, ein Prozessgas in den Behandlungsbereich, wie etwa den Hohlraum des Werkstücks eingeleitet und mittels eingestrahlter elektromagnetischer Energie ein Plasma in der Umgebung zumindest eines Teils der Oberfläche des Werkstücks erzeugt wird. Dabei wird das Plasma während einer Anregung von Gas durch eine Glimmentladung in einem von der Reaktorkammer separierten Raum durch Einstrahlen von elektromagnetischer Energie ins eingeleitete Prozessgas gezündet und das Prozessgas durchströmt den Behandlungsbereich zwischen gegenüberliegenden Enden des Bereichs während der Plasmabehandlung. Bei der Anregung entstehen energiereiche Spezies in Form von angeregten Teilchen und energiereicher Strahlung, welche die Zündung des Plasmas unterstützen.

Eine entsprechende Vorrichtung zur Plasmabehandlung von Werkstücken, die insbesondere zur Durchführung des vorstehenden definierten Verfahrens eingerichtet ist, umfasst eine Reaktorkammer, ein Behandlungsbereich in der Reaktorkammer, eine Einrichtung zum wenigstens teilweise Evakuieren des Behandlungsbereichs in der Reaktorkammer, eine Einrichtung zur Einstrahlung elektromagnetischer Energie in den Behandlungsbereich für die Erzeugung eines Plasmas im Behandlungsbereich eingeleitetem Prozessgas und eine Einrichtung zur Einleitung von Prozessgas in den Behandlungsbereich, wobei die Einrichtung zur Einleitung von Prozessgas und die Einrichtung zum Evakuieren des Behandlungsbereichs so angeordnet sind, dass das Prozessgas im Betrieb den Behandlungsbereich zwischen gegenüberliegenden Enden des Bereichs durchströmt. Die Vorrichtung enthält ferner eine Einrichtung zur Erzeugung einer Glimmentladung in einem von der Reaktorkammer separierten Raum, um angeregte Spezies in der Behandlungszone zur Erzeugung des Plasmas bereitzustellen.

Mit der Erfindung werden vorzugsweise Werkstücke behandelt, die zumindest in einem lokalen Bereich dielektrische Eigenschaften besitzen. Damit wird erreicht, dass die elektromagnetische Strahlung nicht durch leitende Oberflächen des Werkstück abgeschirmt werden kann.

Die Plasmabehandlung kann ausschließlich auf der Innenseite oder ausschließlich auf der Außenseite des Werkstücks des Hohlkörpers durchgeführt werden. Ebenso kann auch eine beidseitige Plasmabehandlung, also sowohl auf der Innenseite als auch auf der Außenseite des Hohlkörpers vorgenommen werden. Dabei können die Plasmabehandlungen vorteilhaft auf der Innenseite und der Außenseite des Hohlkörpers auch verschieden sein oder sich verschiedenartig auf die Oberflächen auswirken. Dies ist beispielsweise möglich, indem in die Umgebung und den Hohlraum unterschiedliche Prozessgase eingeleitet werden.

Die Erfindung erlaubt besonders vorteilhaft die Plasmabehandlung von kleinen Werkstücken, die zudem noch sehr langgestreckt sein können. So können gemäß einer weiterbildung der Erfindung Werkstücke behandelt werden, die zylinderförmig oder zylinderähnlich geformt ist und einen maximalen Außendurchmesser zwischen 1mm bis 50mm, vorzugsweise zwischen 3mm bis 30mm, bevorzugt von 5mm bis 20mm und eine Höhe von 10mm bis 200mm, vorzugsweise von 30mm bis 150mm, besonders bevorzugt von 50mm bis 100mm aufweisen. Gemäß noch einer Weiterbildung der Erfindung werden zylinderförmig oder zylinderähnlich geformte Werkstücke mit einem maximalen Innen-Durchmesser zwischen 1mm bis 50mm, vorzugsweise gelöst. Vorteilhafte Ausgestaltungen und Weiterbildungen der Erfindung sind in den Unteransprüchen angegeben.

Demgemäß sieht die Erfindung ein Verfahren zur Plasmabehandlung von Werkstücken vor, bei welchem in einer Reaktorkammer ein Behandlungsbereich wenigstens teilweise evakuiert, ein Prozessgas in den Behandlungsbereich, wie etwa den Hohlraum des Werkstücks eingeleitet und mittels eingestrahlter elektromagnetischer Energie **ein Plasma in der Umgebung zumindest eines Teils der Oberfläche des Werkstücks erzeugt wird** gezündet wird. **Dabei wird das Plasma während einer Anregung von Gas durch eine Glimmentladung in einem von der Reaktorkammer separierten Raum durch Einstrahlen von elektromagnetischer Energie ins eingeleitete Prozessgas gezündet und** das Prozessgas durchströmt den Behandlungsbereich zwischen gegenüberliegenden Enden des Bereichs während der Plasmabehandlung. **Bei der Anregung energiereiche Spezies in Form von angeregten Teilchen und energiereicher Strahlung entsteht und die Zündung des Plasmas unterstützt.**

Eine entsprechende Vorrichtung zur Plasmabehandlung von Werkstücken, die insbesondere zur Durchführung des vorstehenden definierten Verfahrens eingerichtet ist, umfasst eine Reaktorkammer, ein Behandlungsbereich in der Reaktorkammer, eine Einrichtung zum wenigstens teilweise Evakuieren des Behandlungsbereichs in der Reaktorkammer, eine Einrichtung zur Einstrahlung elektromagnetischer Energie in den Behandlungsbereich für die Erzeugung eines Plasmas im Behandlungsbereich eingeleitetem Prozessgas und eine Einrichtung zur Einleitung von Prozessgas in den Behandlungsbereich, wobei die Einrichtung zur Einleitung von Prozessgas und die Einrichtung zum Evakuieren des Behandlungsbereichs so angeordnet sind, dass das Prozessgas im Betrieb den Behandlungsbereich zwischen gegenüberliegenden Enden des Bereichs durchströmt. **Die Vorrichtung zeichnet sich durch eine Einrichtung zur Erzeugung einer Glimmentladung in einem von der Reaktorkammer separierten Raum, um angeregte Spezies in der Behandlungszone zur Erzeugung des Plasmas bereitzustellen, aus.**

Mit der Erfindung werden vorzugsweise Werkstücke behandelt, die zumindest in einem lokalen Bereich dielektrische Eigenschaften besitzen. Damit wird erreicht, dass die elektromagnetische Strahlung nicht durch leitende Oberflächen des Werkstück abgeschirmt werden kann.

Die Plasmabehandlung kann ausschließlich auf der Innenseite oder ausschließlich auf der Außenseite des Werkstücks des Hohlkörpers durchgeführt werden. Ebenso kann auch eine beidseitige Plasmabehandlung, also sowohl auf der Innenseite als auch auf der Außenseite des Hohlkörpers vorgenommen werden. Dabei können die Plasmabehandlungen vorteilhaft auf der Innenseite und der Außenseite des Hohlkörpers auch verschieden sein oder sich verschiedenartig auf die Oberflächen auswirken. Dies ist beispielsweise möglich, indem in die Umgebung und den Hohlraum unterschiedliche Prozessgase eingeleitet werden.

Die Erfindung erlaubt besonders vorteilhaft die Plasmabehandlung von kleinen Werkstücken, die zudem noch sehr langgestreckt sein können. So können gemäß einer Weiterbildung der Erfindung Werkstücke behandelt werden, die zylinderförmig oder zylinderähnlich geformt ist und einen maximalen Außendurchmesser zwischen 1mm bis 50mm, vorzugsweise zwischen 3mm bis 30mm, bevorzugt von 5mm bis 20mm und eine Höhe von 10mm bis 200mm, vorzugsweise von 30mm bis 150mm, besonders bevorzugt von 50mm bis 100mm aufweisen. Gemäß noch einer Weiterbildung der Erfindung werden zylinderförmig oder zylinderähnlich geformte Werkstücke mit einem maximalen Innen-Durchmesser zwischen 1mm bis 50mm, vorzugsweise Dazu kann das Prozeßgas über eine Kanüle in den Hohlraum eingelassen werden, deren Öffnung zumindest 2/3, besser zumindest 3/4, vorzugsweise 9/10, besonders bevorzugt 95/100 der Längserstreckung des Hohlraums von der Öffnung am ersten Ende des Werkstücks entfernt ist. Für die Kanüle wird vorzugsweise dielektrisches Material, insbesondere Keramik eingesetzt.

Um die Oberfläche langgestreckter und/oder kleiner Werkstücke mit engen Querschnitten gleichmäßig plasmabehandeln zu können, ist erfindungsgemäß auch ein Verfahren und eine Vorrichtung vorgesehen, bei welchen in einer Reaktorkammer mittels einer Evakuierungseinrichtung ein Behandlungsbereich wenigstens teilweise evakuiert, ein Prozeßgas in den Behandlungsbereich, insbesondere in den Hohlraum des Werkstücks eingeleitet und mittels eingestrahlter elektromagnetischer Energie ein Plasma in dem im Behandlungsbereich eingeleiteten Prozeßgas gezündet wird, wobei das Prozeßgas über wenigstens eine Kanüle in den Behandlungsbereich eingelassen wird, deren innerer Öffnungsdurchmesser zwischen 0,1 und 5,0mm, vorzugsweise zwischen 0,2mm und 3,0mm, besonders bevorzugt zwischen 0,3mm und 2,0mm liegt und deren Wandstärke zwischen 0,05mm und 3,0mm, vorzugsweise zwischen 0,1mm und 2,0mm, besonders bevorzugt zwischen 0,15mm und 1,0mm liegt.

Gemäß noch einer besonders bevorzugten Ausführungsform der Erfindung wird das Werkstück durch eine Öffnung an einem ersten Ende evakuiert und das Prozeßgas durch eine weitere Öffnung an einem zweiten Ende des Werkstücks, welches dem ersten Ende gegenüberliegt, eingeleitet. Die Öffnungen können dabei auch unterschiedliche Querschnitte aufweisen. Auf diese Weise wird eine Durchströmung des Prozeßgases in Richtung zwischen den beiden Öffnungen erreicht. Um dabei eine besonders homogene Abscheidung zu erreichen, kann in Weiterbildung zusätzlich vorgesehen sein, die elektromagnetische Energie in axialer Richtung, besonders bevorzugt axial-symmetrisch zum Werkstück einzukoppeln.

Mittels der Erfindung wird eine kontinuierliche gerichtete Gasströmung erzielt, welche den Bereich des Reaktors, in dem das Plasma gezündet wird, insbesondere den zu behandelnden Hohlraum durchströmt. Im Gegensatz dazu können sich bei bisher bekannten Beschichtungsvorrichtungen beim Einfüllen des Prozeßgases Totzonen ausbilden, in denen kaum noch Strömung vorhanden ist. Dies wird um so kritischer, je enger die zu beschichtenden Querschnitte sind. Damit wird ein Austausch des Prozeßgases in diesen Bereichen zumindest verlangsamt, was sich unter anderem nachteilig auf aufgebrachte Beschichtungen auswirken kann.

Unabhängig davon, ob das Prozeßgas durch eine Kanüle oder durch eine zweite Öffnung des Werkstücks eingeführt wird, wird in bevorzugter Weiterbildung der Erfindung ein axialsymmetrischer Fluß des Prozeßgases durch den Hohlraum des Werkstücks hergestellt, um eine gleichmäßige Beschichtung zu erzielen. Allgemein ist es insbesondere auch für die bevorzugten kleinen Abmessungen der Werkstücke besonders günstig, wenn die elektromagnetische Energie in axialer Richtung des Werkstücks, besonders bevorzugt axialsymmetrisch in den Hohlraum oder die Umgebung des Werkstücks eingekoppelt wird. Auf diese Weise wird eine möglichst homogene Feldverteilung im Bereich der zu beschichtenden Oberfläche des Werkstücks und damit eine homgenere Beschichtung ermöglicht. Bei Spritzenkörpern erfolgt die Einkopplung demgemäß vorzugsweise axialsymmetrisch zu dessen Zylinderachse.

Das Plasmabehandeln kann insbesondere das Plasmabeschichten, weiterhin auch eine Plasma-Aktivierung, Plasma-Vorbehandlung, Plasma-Reinigung, Plasma-Immersion oder Plasma-Modifikation umfassen. Vorteilhaft können auch mehrere, zumindest zwei dieser Behandlungsschritte mittels des erfindungsgemäßen Verfahrens, beziehungsweise der korrespondierenden Vorrichtung durchgeführt werden.

Durch die Plasmabehandlung kann eine Schicht abgeschieden werden, welche zumindest einen der Stoffe $SiO_x$, $SiO_xC_y$, $SiO_xN_y$, $SiN_y$, $TiO_x$, $Al_xO_yN_z$, $Al_xN_z$, $Al_xO_y$, $C_xH_y$, $C_xF_y$, $TiN_x$ enthält. Die Schichtdicken liegen vorzugsweise bei größer 5 Nanometern, insbesondere größer 20 Nanometern, besonders bevorzugt größer 50 Nanometern.

Das erfindungsgemäße Verfahren, beziehungsweise die entsprechende erfindungsgemäße Vorrichtung kann weiterhin in eine Herstellungs- und / oder Behandlungskette integriert sein. So können durch die Plasmabehandlung schon innerhalb der Prozesskette vorteilhafte Eigenschaften am Werkstück erreicht werden, die sich bereits innerhalb der nachfolgenden Prozesskette beispielsweise durch Verzicht auf weitere Behandlungsschritte oder durch eine bessere erzielbare Ausbeute auswirken, wie beispielsweise eine sterile oder eine kratzbeständige Oberfläche.Die Erfindung ist insbesondere für verschiedene Arten von Pharmaverpackungen geeignet. So kann der Hohlraum des Werkstücks besonders vorteilhaft bei der auch Plasmabehandlung sterilisiert werden. Dabei kann die Plasmabehandlung auch dem alleinigen Zweck der Sterilisierung dienen. Werden die Hohlräume der Werkstücke sterilisiert, so können sich in vorteilhafter Weiterbildung der Erfindung an die Plasmabehandlung auch Weiterverarbeitungsschritte in steriler Umgebung anschließen. Diese können bis zur versand- oder verkaufsfertigen Form der Werkstücke, beispielsweise einschließlich des Einfüllens von Medikamenten und/oder der sterilen Verpackung der Werkstücke reichen.

Bei einer solchen Integration des erfindungsgemäßen Verfahrens in eine Produktionslinie zur Herstellung. verpackter Pharma-Erzeugnisse kann eine Produktions- oder Behandlungslinie beispielsweise folgende Schritte enthalten: Herstellen des Werkstücks (z.B. Spritzguss, Spritzblasen, Heißumformung wie z.B. bei Heißumformung von Rohrglas), Reinigen des Werkstücks, Plasma-Behandlung, Silikonisierung, Befüllen, Sterilisieren, Verpacken. Bei einer weiteren vorteilhaften Ausführungsform der Erfindung kann auch auf eine zusätzliche Sterilisierung verzichtet werden, wenn die mit der Plasmabehandlung erzielte Sterilisierung bereits ausreicht und die nachfolgenden Schritte in steriler Umgebung stattfinden.

Die erfindungsgemäße Plasma-Behandlung bietet bereits vor dem Gebrauch des Produkts (d.h. z.B. vor Gebrauch einer vorbefüllten Spritze bzw. vor dem Öffnen eines Packmittels) einen Vorteil, besonders bevorzugt schon innerhalb der industriellen Fertigungskette, da unter anderem wenigstens eine der Eigenschaften Lagerstabilität des im Packmittel abgefüllten Produkts, Sterilität oder Kratzbeständigkeit verbessert werden kann.

Insbesondere auch für die Plasmabehandlung von Pharmabehältern hat es sich als vorteilhaft herausgestellt, wenn ein gepulstes Plasma zur Plasmabehandlung erzeugt wird. Dazu umfasst die Einrichtung zur Einstrahlung elektromagnetischer Energie in den Hohlraum eine Einrichtung zur Erzeugung gepulster elektromagnetischer Energie. Durch ein gepulstes Plasma können in den Pulspausen Prozeßabgase abgeführt werden. Damit wird beispielsweise bei der Plasmabeschichtung vermieden, daß sich größere Partikel des Beschichtungsmaterials im Plasma bilden und auf der Oberfläche des Hohlraums des Werkstücks niederschlagen können. Auch können wesentlich höhere Spitzenleistungen verglichen mit einem kontinuierlichen Plasma eingesetzt werden, was wiederum die Sterilisierung beschleunigt oder wesentlich verbessert.

Besonders bei kleinen Pharmaverpackungen mit engen Querschnitten hat sich überraschend gezeigt, daß eine gleichmäßige Beschichtung nicht unbedingt dann erzielt wird, wenn die elektromagnetische Energie möglichst ungehindert den Hohlraum durchdringen kann. Vielmehr hat sich gezeigt, daß zumindest eine lokale Abschirmung vorgesehen werden kann, welche das Werkstück umgibt und eingestrahlte elektromagnetische Energie lokal von Bereichen des Hohlraums des Werkstücks abschirmt. Durch die Abschirmung kann vermieden werden, daß lokal ein besonders heißes Plasma im Hohlraum entsteht, welches die Beschichtung negativ beeinflussen und insbesondere auch das Werkstück beschädigen kann.

Um die Produkteigenschaften insbesondere auch von Pharmaverpackungen zu verbessern, wird besonders bevorzugt zumindest eine Barriereschicht mit der Plasmabehandlung abgeschieden. Eine solche Barriereschicht kann eine Barriere gegen das Ein-oder Ausdringen von Gasen, wie Sauerstoff, Wasserdampf, oder $CO_2$ sein. Weiterhin kann zumindest eine Barriereschicht abgeschieden werden, die eine Barrierewirkung gegen Bestandteile aus dem Werkstück, wie beispielweise Ausgangs- oder Neben- oder Endverbindungen aus der Herstellung des Werkstücks aufweist. So kann eine geeignete Barriereschicht die Migration von Substanzen aus dem Substrat verhindern oder zumindest bremsen. Auch kann die Ionen-Auslaugung von Gläsern oder das Auslösen von Substanzen aus Polymeren, beziehungsweise aus Kunststoff-Behältern vermieden oder verlangsamt werden. Weiterhin kann auch zumindest eine Barriereschicht mit einer chemischen Barrierewirkung abgeschieden werden.

Eine bevorzugte Ausführungsform der Erfindung betrifft eine Vorrichtung und ein Verfahren zur innenseitigen Plasmabehandlung von Spritzenkörpern. Diese sind aufgrund ihrer im allgemeinen langgestreckten zylindrischen Form und dem sich anschließenden Luer-Konus, beziehungsweise der Düse, auf welchen die Kanüle aufgesteckt wird, schwierig zu beschichten. Mittels der Erfindung, bei welcher das Prozeßgas im wesentlichen den Spritzenkörper in axialer Richtung durchströmt, können jedoch gute, gleichmäßige Ergebnisse bei der Plasmabehandlung erzielt werden.

Aufgrund der sehr engen Querschnitte von Spritzen, vor allem im Bereich des Luer-Konus, beziehungsweise der Düse, ist eine (Innen)-beschichtung von Spritzen eine technische Herausforderung, die mit dem bisher vorliegenden Stand der Technik nicht gelöst wurde. Die Zündung eines Plasmas in dem engen Querschnitt und die gleichmäßige Beschichtung ist aufgrund der engen Querschnitte mit konventioneller Beschichtungstechnologie bisher nicht gelöst worden. Speziell bei Ausführungsformen von Spritzen mit asymmetrischen Querschnitten, beziehungsweise mit einer Geometrie, bei welcher die Mittenachsen von Düse und Zylinderkörper seitlich zueinander versetzt sind, ist die technische Herausforderung besonders groß.

Zweckmäßig ist es dabei insbesondere, wenn der Hohlraum der Spritze durch deren Kolbenöffnung evakuiert wird. Eine Vorrichtung gemäß dieser Ausführungsform der Erfindung weist dazu dementsprechend eine Anschlußeinrichtung zum Anschluß einer Evakuierungseinrichtung an die Kolbenöffnung der Spritze auf.

Um eine erfindungsgemäße Durchströmung des Prozeßgases in axialer Richtung zu erreichen ist es weiterhin besonders vorteilhaft, wenn das Prozeßgas durch den der Kolbenöffnung gegenüberliegenden Luer-Konus, beziehungsweise durch die Düse zugeführt wird. Auch die umgekehrte Konfiguration ist aber möglich, wobei dann dementsprechend das Prozeßgas durch die Kolbenöffnung des Spritzenkörpers zugeführt wird.

Es kann weiterhin zweckmäßig sein, eine Außenbeschichtung des Werkstücks vorzunehmen. Eine Vorrichtung, die für eine Außenbeschichtung von Werkstücken eingerichtet ist, umfaßt dazu dementsprechend eine Einrichtung zum wenigstens teilweise Evakuieren der Umgebung eines Werkstücks in der Reaktorkammer. Die Außenbeschichtung kann ebenso wie eine Innenbeschichtung durch eine Plasmabeschichtung erfolgen. In diesem Fall ist eine Einrichtung zur Einleitung von Prozeßgas in die Umgebung des Werkstücks in der Reaktorkammer vorgesehen. Es können aber auch andere Beschichtungsverfahren, insbesondere auch PVD-Verfahren wie etwa Sputtern oder Aufdampfen eingesetzt werden. Mögliche Funktionsschichten sind beispielsweise Kratzschutz-, beziehungsweise Hartstoff-Schichten. Solche Funktionsschichten sind beispielsweise bei sehr kratzempfindlichen cyclo-olefinischen Polymeren und - Copolymeren von Vorteil.

Weiterhin können absorbierende oder reflektierende Beschichtungen für bestimmte Wellenlängen, vorzugsweise im IR-, sichtbaren oder UV-Bereich abgeschieden werden. Diese können unter anderem auch eine dekorative Wirkung haben. Viele Substrate, insbesondere Kunststoffe altern unter Bestrahlung mit ultraviolettem Licht. Das Aufbringen einer selektiven Reflexionsschicht gegen UV-Bestrahlung oder einer UV-Absorber-Schicht auf der Außenfläche des Substrats ermöglicht, die Degradation des Substrats zu verhindern. Eine weitere aufgebrachte Kratzschutzschicht kann die optische Funktionsschicht und das Substrat gegen Verkratzen schützen. Demgemäß kann in Weiterbildung der Erfindung innen und/oder außen eine UV-reflektierende und/oder absorbierende Schicht abgeschieden werden, welche den Inhalt des Werkstücks oder das Werkstück selbst vor einer Degradation durch ultraviolettes Licht schützt.

Gemäß noch einer Weiterbildung der Erfindung ist vorgesehen, daß eine farbgebende Schicht, vorzugsweise eine blau erscheinende Schicht abgeschieden wird. Pharmazeutische Produkte werden häufig Strahlensterilisiert, z.B. mit Gamma-Strahlung. Durch die Bestrahlung verändert das Substrat (z.B. Kunststoff oder Glas) seinen Farbeindruck. Beispielsweise verfärben sich Kunststoffe unter Gamma-Bestrahlung häufig gelblich. Nach Stand der Technik wird dem Kunststoff dazu ein Farbstoff, z.B. ein blauer Farbstoff, zugesetzt, um diese Verfärbung in einen marktseitig akzeptierten Grünton zu kompensieren. Erfindungsgemäß kann dieser Farbstoff zumindest teilweise oder vollständig durch eine optische Funktionsschicht ersetzt werden, z.B. ein Schichtdesign, das einen blauen Farbeindruck bewirkt, so dass nach Bestrahlung und Verfärbung des Kunststoffs der gelbe Farbeindruck analog kompensiert oder dass sogar die Farbauffälligkeit deutlich geringer als bei eingefärbten Kunststoffen ausfällt.

Um unter anderem ein ansprechenderes Erscheinungsbild zu erhalten, kann weiterhin auch eine ver- oder entspiegelnde Schicht abgeschieden werden. Eine solche Schicht kann ebenso wie eine farbgebende, UV- oder Infrarotreflektierende Schicht als mehrlagiges dielektrisches Interferenzschichtsystem abgeschieden werden.

Die Erfindung kann sehr vorteilhaft dafür verwendet werden, eine Kunststoff-Oberfläche des Werkstücks, vorzugsweise ein Kunststoff-Werkstück zu behandeln. Für Pharma-Verpackungen setzen sich Kunststoffe immer mehr durch, allerdings sind Kunststoffe hinsichtlich verschiedener Eigenschaften beispielsweise gegenüber Glas schlechter. So sind die Barriereeigenschaften von Kunststoff nicht mit Glas vergleichbar, auch lassen sich Kunststoffe schlechter bedrucken oder mit anderen Kunststoffen beschichten. Dieses Nachteile können aber durch geeignete Plasmabehandlungen, wie insbesondere das Abscheiden geeigneter Beschichtungen oder die Aktivierung der Oberflächen kompensieren. Vorzugsweise werden Kunststoff-Oberflächen von Werkstücken behandelt, welche zumindest eine der nachfolgenden Materialien enthalten: polycyclische Kohlenwasserstoffe, wie z.B. zyklische Polymere oder Copolymere, bevorzugt zyklische polyolefinische Copolymere oder Polymere, besonders bevorzugt COC, insbesondere Topas® oder COP (cycloolefinisches Polymer), insbesondere Zeonor®, Polycarbonate, bevorzugt autoklavierbare Polycarbonate wie Apec® oder besonders bevorzugt Makrolon®, Polyester, wie Polyethylenterphthalate (PET), oder PETG (Glykolmodifiziertes PET-Copolyester), Polystyrol, Polyethylen, wie MDPE (Medium density Polyethylen), insbesondere aber HDPE (High density Polyethylen) oder LDPE (Low density.Polyethylen), Polypropylen, auch orientiertes Polypropylen (o-PP), oder biaxial orientiertes Polypropylen (BOPP), Polymethylmetacrylat, PES (Polyethersulfon), Polyethylene Naphtalate (PEN), SAN (Styrol-Acrylnitril-Copolymer), Fluorhaltige Polymere, vorzugsweise Polychlortriofluorethylene (PCTFE), besonders bevorzugt Aclar®, EVOH, Polyamid, vorzugsweise Nylon6®, PVC, PVDC (Polyvinylidenchlorid), PMMI, PA, ABS, MABS, PMP, PSI.

Auch Glas-Werkstücke oder Glas-Oberflächen von Werkstücken können mit der Erfindung plasmabehandelt werden. Bevorzugt werden dabei Alkali-, Erdalkali- oder Aluminium-haltige Gläser, vorzugsweise Borsilikat-Gläser, wie etwa Fiolax-Glas, sowie Hüttenglas, beispielsweise Kalk-Natron-Glas. Neben Glas-Werkstücken können ebenso auch Glaskeramik- oder Keramik-Werkstücke plasmabehandelt werden.

Die erfindungsgemäße Vorrichtung wird vorzugsweise integrierbar in eine Produktionslinie ausgelegt. Insbesondere kann die Vorrichtung zumindest teilweise in steriler Umgebung betrieben werden. In weiterer Ausgestaltung weist die Vorrichtung mehrere Beschichtungsplätze auf. Diese können beweglich gestaltet sein, so daß die Werkstücke an einer Zuführposition in Reaktoren eingeführt, die Reaktoren auf einem Transportweg zu einer Entnahmeposition transportiert und dort entnommen werden, wobei die Werkstücke zwischen Zuführ- und Entnahmeposition plasmabehandelt werden. Demgemäß weist eine Vorrichtung für diese Ausgestaltung der Erfindung entlang eines Transportweges bewegbare Reaktoren zur Plasmabehandlung von Werkstücken, eine Zuführposition zur Zuführung der Werkstücke zu den Reaktoren, eine Entnahmeposition zur Entnahme der Werkstücke aus den Reaktoren, und einer Einrichtung zur Plasmabehandlung zwischen Zuführ- und Entnahmeposition mit einer Einrichtung zur Einstrahlung elektromagnetischer Energie in den Hohlraum auf. Die Vorrichtung ist dabei vorzugsweise als Rundläufer oder als Linearmaschine ausgebildet. Bei einem Rundläufer werden die Reaktoren auf einem umlaufenden Transportweg, beispielsweise auf einem Karussell befördert, während bei einer Linearmaschine die Reaktoren zwischen Zuführ- und Entnahmeposition geradlinig transportiert werden.

Um eine gleichzeitige Plasmabehandlung mehrerer Werkstücke vornehmen zu können, hat es sich bei einer solchen Mehrplatz-Behandlungsvorrichtung als sehr vorteilhaft herausgestellt, wenn die mehreren Beschichtungsplätze jeweils separate Energiequellen zur Bereitstellung elektromagnetischer Energie aufweisen. Weiterhin ist es günstig, wenn die Vorrichtung separate Vorräume für die Beschichtungsplätze aufweist, die mit den Beschichtungsbereichen verbunden sind und an einer gemeinsamen Vakuumerzeugungseinrichtung, vorzugsweise über eine weitere Kammer verbunden sind, wobei in den Vorräumen jeweils Einrichtungen zur Anregung des Prozeßgases angeordnet sind, die jeweils an separate zweite Energiequellen angeschlossen sind.

Um die elektromagnetische Energie in das Prozeßgas einzukoppeln, ist in weiterer Ausgestaltung der Erfindung vorgesehen, daß die Einrichtung zur Einstrahlung elektromagnetischer Energie zumindest eine der Einrichtungen

- einen Koaxialleiter,
- einen Hohlleiter, vorzugsweise ein Rechteckhohlleiter,
- einen Schlitz zur Einköpplung in einen Beschichtungsreaktor,
- eine Antenne, die in den Hohlraum eines Werkstücks einführbar ist,
- eine Kombination der vorstehenden Einrichtungen, vorzugsweise einen Rechteckhohlleiter und einen daran ausgangsseitig angeschlossenen Koaxialleiter umfasst.

Da die Feldverteilung insbesondere bei Werkstücken mit engem Querschnitt des Hohlraumes oft kritisch ist, bietet es sich weiterhin an, Abstimmelemente zur Optimierung der Einkopplung vorzusehen. Demgemäß enthält die Einrichtung zur Einstrahlung elektromagnetischer Energie weiterhin vorzugsweise wenigstens eines der Abstimmelemente: einen Stub-Tuner (3-Stift-Tuner), einen Kurzschluss-Schieber, verschiebbare Bauteile, die die elektromagnetische Feldverteilung verändern.

Die vorgenannten Abstimmelemente und Kopplungseinrichtungen sind insbesondere für Mikrowellen-Quellen als Energiequellen zur Erzeugung des Plasmas im Prozeßgas geeignet. Außer einer Mikrowellen-Quelle kann aber auch eine Hochfrequenz-Quelle (HF-Quelle) oder Radiofrequenz-Quelle (RF-Quelle) eingesetzt werden. Als Mikrowellen werden dabei elektromagnetische Wellen mit einer Frequenz ab 1 GHz verstanden. Für Hochfrequenz-Quellen (HF-Quelle) oder Radiofrequenz-Quellen (RF-Quelle) können Elektroden für die Einstrahlung elektromagnetischer Energie in den Hohlraum eingesetzt werden, wobei Energie durch Anlegen eines (Wechsel)-stroms an die Elektroden eingekoppelt wird. Auch für HF- oder RF-Quellen können Einrichtungen zur Impedanzanpassung, wie z.B. eine Matchbox mit Regelkreis und variablen Impedanzen (Kapazitäten oder Induktivitäten) vorgesehen werden.

Als Prozeßgase können unter anderem Träger- oder Reaktionsgase, wie sauerstoff- oder stickstoffhaltige oder Wasserstoff-haltige Trägergase, vorzugsweise aus der Gruppe Sauerstoff, Ozon, Stickstoff, Ammoniak, Stickoxide, Wasserstoff eingesetzt werden.

Um Beschichtungen abzuscheiden, werden bevorzugt folgende Prozeßgas-Komponenten verwendet:

anorganische oder organische Siliziumverbindungen, vorzugsweise HMDSO oder HMDSN, oder TMDSO oder TMCTS oder TEOS oder TMS oder $SiCl_4$, $SiH_4$ oder Tetraisocyanato-Silan, organische oder anorganische Aluminiumverbindungen, vorzugsweise Aluminiumchlorid, Titanorganische Verbindungen, vorzugsweise TIPT, Titananorganische Verbindungen, vorzugsweise $TiCl_4$, Kohlenwasserstoffe, vorzugsweise Acetylen, Methan, Propan, Butan, Fluorhaltige Verbindungen, vorzugsweise fluorierte Kohlenwasserstoffe, Edelgase wie Argon, Helium, Xenon, Krypton.

Vorzugsweise weist eine erfindungsgemäße Vorrichtung dabei eine Gasversorgungseinrichtung mit zumindest zwei Behältern für verschiedene Gase auf, deren Mischung für die Plasmabehandlung verwendet wird.

Um das Zünden eines Plasmas in den Zuleitungen zur Reaktorkammer zu vermeiden, ist gemäß einer Weiterbildung der Erfindung eine Abschirmung für die elektromagnetische Energie zur Entkopplung der Zuleitung der Reaktorkammer zur Evakuierungseinrichtung vorgesehen.

In bevorzugter Ausgestaltung weist die Vorrichtung weiterhin einen Vorraum zum Reaktorraum auf, wobei die Einrichtung zum Evakuieren an den Vorraum angeschlossen ist. Mit einem solchen Vorraum kann die Vorrichtung schnell durch Montage jeweils angepaßter Halteeinrichtungen auf dem Vorraum auf verschiedene zu beschichtende Werkstücke angepaßt werden.

Beispielsweise kann die Vorrichtung einen Vorraum oder Unterraum zum Reaktorraum als Bestandteil der Zuleitung aufweisen. Dieser wird mit der Abschirmung dann wenigstens zum Teil vom Reaktorraum entkoppelt. Die Entkopplung erfolgt beispielsweise durch ein elektrisch leitfähiges Trennstück. Möglich ist hierfür unter anderem ein Gitter oder ein Metall-Körper mit Gasdurchlässen. Entkopplung bedeutet insbesondere, dass für den verwendeten Produktions- / Beschichtungs-Prozess keine Energie oder nur so wenig Energie in den Unterraum zum Reaktorraum gelangt, dass dort kein Plasma durch die Energiequelle gezündet werden kann.

Ebenso kann auch eine Entkopplung von der Gasquelle erfolgen. Das Gas wird in den Reaktorraum zu- und über den Vor- oder Unterraum oder anders ausgestaltete Zuleitungen zur Evakuierungseinrichtung abgeführt. Ab dem Zünden des Plasmas im Hohlraum des Werkstücks ist die Stoffmengenkonzentration des Ausgangsgases im Unterraum dann deutlich reduziert, so daß kein Plasma in den Zuleitungen, insbesondere in dem Vorraum mehr gezündet werden kann. In der Regel wird eine Kombination der Abschirmung der elektromagnetischen Energie und des Gasanfalls in den Zuleitungen eingesetzt, so daß in erster Linie nur eine Beschichtung im Reaktorraum stattfindet, der Unterraum wird also gar nicht oder deutlich weniger beschichtet als das Werkstück.

Es hat sich überraschend gezeigt, daß mit einer derartigen Zündvorrichtung, die gar nicht im Bereich des dadurch gezündeten Plasmas angeordnet ist, eine sichere Zündung des Plasmas gelingt. Eine derartige Zündeinrichtung kann auch allgemein bei anderen Reaktortypen und Verfahren für die Plasmabehandlung von Werkstücken eingesetzt werden.

Um die Glimmentladung zu zünden, kann beispielsweise eine Zündelektrode vorgesehen werden, an die vorzugsweise eine Hochspannung als Gleich- oder Wechselspannung angelegt wird. Die Spannung liegt entweder vor der Plasmabehandlung, bzw. spätestens zu Beginn der Beschichtung an und führt zu einem Zünden der Glimmentladung. Durch diese Glimmentladung allein wird aber noch kein Plasma im Reaktor gezündet, vielmehr werden angeregte Spezies im Bereich, in dem das Plasma gezündet werden soll, bereitgestellt. Dies kann sowohl durch aus der Glimmentladung diffundierende Ionen Elektronen, angeregte Neutralteilchen, als auch durch Photoionisation aufgrund von UV-Licht aus der Glimmentladung erfolgen. Aufgrund der freien Ladungsträger wird dann ein leichteres Zünden des Plasmas ermöglicht.

Die Zündung des Plasmas erfolgt erst durch Anlegen der Energie aus der Energiequelle, etwa einer Mikrowellen-Quelle. In Weiterbildung der Erfindung kann die Glimmentladung mit einer vorzugsweise optischen Überwachungseinrichtung kontrolliert werden.

Die Glimmentladung wird dabei vorzugsweise durch wenigstens einen der folgenden Parameter gezündet:

i) durch eine Hochspannung im Bereich von 0,1 kV - 100 kV

Um **die** Glimmentladung zu zünden, kann beispielsweise eine Zündelektrode vorgesehen werden, an die vorzugsweise eine Hochspannung als Gleich- oder Wechselspannung angelegt wird. Die Spannung liegt entweder vor der Plasmabehandlung, bzw. spätestens zu Beginn der Beschichtung an und führt zu einem Zünden der Glimmentladung. Durch diese Glimmentladung allein wird aber noch kein Plasma im Reaktor gezündet, vielmehr werden angeregte Spezies im Bereich, in dem das Plasma gezündet werden soll, bereitgestellt. Dies kann sowohl durch aus der Glimmentladung diffundierende Ionen Elektronen, angeregte Neutralteilchen, als auch durch Photoionisation Aufgrund von UV-Licht erfolgen, welches von der Glimmentladung erfolgen. Aufgrund der freien Ladungsträger wird dann ein leichteres Zünden des Plasmas ermöglicht.

Die Zündung des Plasmas erfolgt erst durch Anlegen der Energie aus der Energiequelle, etwa einer Mikrowellen-Quelle. In Weiterbildung der Erfindung kann die Glimmentladung mit einer vorzugsweise optischen Überwachungseinrichtung kontrolliert werden.

Die Glimmentladung wird dabei vorzugsweise durch wenigstens einen der folgenden Parameter gezündet:

i) durch eine Hochspannung im Bereich von 0,1 kV - 100 kV oder ein Glasfaserbündel zu einem optischen Detektor geleitet wird.

Insbesondere für die Behandlung kleiner Werkstücke, beispielsweise pharmazeutische Produkte, wie Spritzenkörper, Vials, Blutentnahmeröhrchen oder Karpulen kann eine besonders raumsparende Anordnung weiterhin erzielt werden, wenn die Einrichtung zur Einstrahlung elektromagnetischer Energie in die Reaktorkammer einen Koaxialleiter umfaßt, wobei der Koaxialleiter einen axial verlaufenden Kanal aufweist, durch den das prozeßgas zuführbar ist. Damit kann gleichzeitig die elektromagnetische Energie durch den Koaxialleiter und Prozeßgas durch dessen Innenleiter zugeführt werden. Eine zusätzliche Anordnung einer Gaszuführung kann auf diese Weise entfallen. In alternativer Weiterbildung der Erfindung kann die elektromagnetische Energie auch durch einen Koaxialleiter eingestrahlt und der Behandlungsbereich durch den Koaxialleiter evakuiert werden. In weiterer Ausgestaltung kann auch noch eine Zündeinrichtung, insbesondere eine Zündelektrode zur Erzeugung einer Glimmentladung im Kanal durch den Innenleiter vorgesehen werden. Es ist besonders bevorzugt, den Koaxialleiter in axialer Richtung des zu behandelnden Werkstücks anzuordnen, so daß der Koaxialleiter in axialer Richtung des Werkstücks verläuft. Bei einem zylinderförmigen oder zylinderähnlicehn Werkstück, wie etwa einem Spritzenkörper verläuft der Koaxialleiter dementsprechend vorzugsweise in Richtung entlang der Mittenachse des Zylinders des Spritzenkörpers. Damit wird entsprechend eine möglichst symmetrische Feldverteilung im oder am Spritzenkörper erzielt.

Weiterhin kann ein Füllkörper vorgesehen werden, welcher einen Hohlraum eines zu behandelnden Werkstücks zumindest teilweise ausfüllt. Indem mit zumindest einen Füllkörper, ein Hohlraum eines zu behandelnden Werkstücks zumindest teilweise ausgefüllt wird, kann die Temperaturverteilung auf dem Werkstück während und nach der Plasmabehandlung gleichmäßiger gehalten werden, verglichen mit einer Plasmabehandlung ohne einen solchen Füllkörper. Der Füllkörper kann gleichzeitig ein Fixierungs- und/oder Vakuum-Abdichtungselement für einen weiteren Hohlraum des Werkstücks sein. Beispielsweise ist bei einigen Spritzenkörpern ein den Luer-Konus oder die Düse umgebender Rand vorhanden, welcher einen Hohlraum bildet. In diesem Hohlraum kann sich unter Umständen ebenfalls ein unerwünschtes Plasma bilden. Dieser Effekt kann durch einen derartigen Füllkörper verhindert werden. Insbesondere kann dazu der Füllkörper ausgebildet sein, hochfrequente elektromagnetische Energie zu absorbieren oder reflektieren. Vorzugsweise verhindert dabei der Füllkörper eine Zündung eines Plasmas in unmittelbarer Umgebung des ausgefüllten Bereichs. Geeignet für den Füllkörper -auch in Kombination- sind unter anderem polymere, keramische oder metallische Materialien. Gleichzeitig kann der Füllkörper den Zylinder des Spritzenkörpers als weiteren Hohlraum abdichten und/oder das Werkstück fixieren, so daß der Füllkörper als Abdicht- und/oder Fixierungselement wirkt. Insbesondere kann ein solcher Füllkörper in einen Koaxial-Innenleiter integriert sein. Dabei muß der Füllkörper kein separates Teil sein, dieser kann auch zumindest teilweise aus einem Abschnitt des Innenleiter-Materials gebildet werden. Als Kunststoffe für den Füllkörper eignen sich unter anderem steife Polymere, wie beispielsweise Teflon, POM oder Polykarbonat. Soll der Füllkörper auch als Dichtelement wirken, können zusätzlich oder alternativ insbesondere auch Elastomere, wie Silikon , Bromobutyl - Elastomer, oder Polyisoprene-Bromobutyl-Elastomer verwendet werden.

Überraschend konnte außerdem gezeigt werden, daß das Plasmaabscheiden von Funktionsschichten auf Pharmaverpackungen mit engem Querschnitt, wie beispielsweise Spritzenkörpern, Vials, Blutentnahmeröhrchen oder Karpulen mit sehr geringen mittleren Leistungen erzielt werden konnte. Im speziellen konnten derartige Behälter bei einem gepulsten Plasma mit mittleren Leistungen von höchstens 300 Watt, sogar von höchstens 100 Watt beschichtet werden.

Alternativ oder zusätzlich kann das Werkstück während der Plasma-Behandlung auch durch einen Gasstrom gekühlt werden. Wird beispielsweise eine Innenbeschichtung vorgenommen, kann das Werkstück außen durch einen Gasstrom -im einfachsten Fall einen Luftstrom unter Atmosphärendruckgekühlt werden. Ebenso kann auch bei einer Außenbeschichtung durch Hindurchleiten eines Gasstroms durch den Hohlraum des Werkstücks hindurch eine Kühlung vorgenommen werden.

Die Erfindung wird nachfolgend anhand von Ausführungsbeispielen und unter Bezugnahme auf die beigefügten Zeichnungen näher erläutert. Dabei verweisen gleiche Bezugszeichen in den Zeichnungen auf gleiche oder ähnliche Teile.

Es zeigen:

Fig. 1    eine schematische Querschnittansicht eines Beispiels für einen erfindungsgemäßen Durchflußreaktor,

Fig. 2 und 3    alternative Anordnungen zu dem in Fig. 1 gezeigten Durchflußreaktor,

Fig. 4    einen Durchflußreaktor zur Außenbeschichtung,

Fig. 5 bis 7    Varianten des in Fig. 4 dargestellten Reaktors,

Fig. 8    eine Variante der in Fig. 1 oder 3 gezeigten Beispiele mit Elektroden zur Einspeisung der elektromagnetischen Energie,

Fig. 9    eine Variante des in Fig. 8 gezeigten Reaktors für eine Außenbeschichtung,

Fig. 10a, 10b    zwei Ausführungsbeispiele für Umkehrströmungsreaktoren,

Fig. 11 - 15    Details von Koaxial-Innenleitern zur Zuführung von elektromagnetischer Energie,

Fig. 16    ein Ausführungsbeispiel einer Mehrplatz-Beschichtungsanlage,

Fig. 17 bis 19    SIMS-Intensitäts-Sputterzeit-Profile für die Elemente / Moleküle C, 02, Si sowie für die Kette C8 von einer beschichteten COC-Spritze, beschichtet mit einem 2-Schichtsystem aus Haftvermittler- und Barriere-Schicht. Der Profilverlauf entspricht dabei der Abfolge anorganische Barriere-Schicht, Kohlenstoffhaltige Haftvermittler-Schicht, Polymer-Substrat (cyclo-olefinisches Copolymer).

Unter einem Durchfluß-Reaktor wird im folgenden eine erfindungsgemäße Vorrichtung verstanden, bei welcher in einer Reaktorkammer ein Behandlungsbereich wenigstens teilweise evakuiert, ein Prozeßgas in den Hohlraum des Werkstücks eingeleitet und mittels eingestrahlter elektromagnetischer Energie ein Plasma in dem im Behandlungsbereich eingeleiteten Prozeßgas gezündet werden kann, wobei das Prozeßgas während der Plasmabehandlung den Beschichtungsbereich zwischen gegenüberliegenden Enden des Bereichs durchströmt.

Unter einem Umkehrströmungsreaktor wird weiterhin im Sinne der Erfindung ein Reaktor verstanden, bei welchem das Prozeßgas nicht an einer der an das Vakuumsystem angeschlossenen Öffnung am ersten Ende gegenüberliegenden weiteren Öffnung, sondern innerhalb des zu beschichtenden Hohlraums eingelassen wird. Dabei ist die Stelle, an welcher das Gas einströmt, aber vorzugsweise zumindest 2/3 der Längserstreckung des Hohlraums von der Öffnung am ersten Ende des Werkstücks entfernt. Das Einlassen des Prozeßgases erfolgt dabei vorzugsweise mit einer in den Hohlraum eingeführten Kanüle.

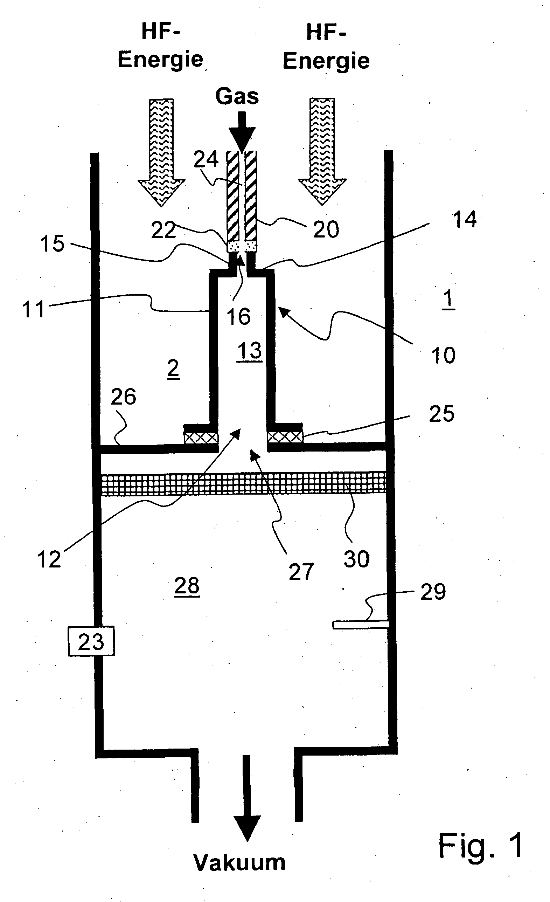

Fig. 1 zeigt in schematischem Querschnitt einen Durchflußreaktor 1, welcher zur Innenbeschichtung von hohlkörperförmigen Werkstücken eingerichtet ist. Im speziellen ist der Reaktor 1 zur Beschichtung von Pharmaverpackungen, wie etwa Spritzenkörpern oder Karpulen ausgelegt. Fig. 1 zeigt dazu einen in der Reaktorkammer 2 des Reaktors 1 angeordneten Spritzenkörper 10. Der Spritzenkörper 10 umfasst einen Zylinder 11, welcher in eine Kolbenöffnung 12 mündet, und einen zylindrischen Hohlraum 13 umschließt. An dem der Kolbenöffnung gegenüberliegenden Ende des Zylinders 11 ist dieser mit einem Deckelelement 14 mit einer zweiten zylindrischen- oder Zylinder-ähnlichen, wie beispielsweise leicht konischen Ausformung mit kleinerem Durchmesser und kleinerer Länge in Form eines Luer-Konus 15 mit einer zweiten Öffnung 16 versehen. Auf den Luer-Konus 15 wird bei der Verwendung der Spritze die Kanüle aufgesteckt. Länge und Höhe des Luer-Konus 15 sind vorzugsweise wenigstens um 20% kleiner als der maximale Durchmesser und die Höhe des Spritzenkörpers 10. Der Luer-Konus 15 weist einen engen, kanülenartigen Innendurchmesser zwischen 0,01 und 15mm, besonders bevorzugt zwischen 0,05 und 4mm auf.

Die in Fig. 1 dargestellte Vorrichtung 1 ist speziell zur innenseitigen Plasmabehandlung von derartigen Spritzenkörpern 10 eingerichtet. Das Material des Spritzenkörpers 10 weist dabei zumindest bereichsweise dielektrische Eigenschaften auf. Der Spritzenkörper ist zylinderförmig oder zylinderähnlich geformt und weist typischerweise einen maximalen Außendurchmesser zwischen 1mm bis 50mm, vorzugsweise zwischen 3mm bis 30mm und eine Höhe von 10mm bis 200mm, vorzugsweise von 30mm bis 150mm auf.

Bei diesem Beispiel wird die elektromagnetische Energie zur Erzeugung eines Plasmas mittels eines Koaxialleiters zugeführt, wobei Fig. 1 nur den Innenleiter 20 des Koaxialleiters zeigt. Mit dem Innenleiter 20 und einem daran angebrachten Dichtelement 22 wird der Spritzenkörper 10 sowohl fixiert, als auch gegenüber den umgebenden Bereichen der Reaktorkammer 2 abgedichtet. Bei dieser Ausführungsform der Erfindung wird insbesondere die elektromagnetische Energie durch den Koaxialleiter und Prozeßgas durch einen axial verlaufenden Kanal 24 im Innenleiter 20 des Koaxialleiters zugeführt.

Der Innenleiter 20 preßt den Spritzenkörper 10 außerdem auf ein eine Öffnung 27 in einer Trennplatte 26 umschließendes weiteres Dichtelement 25. Mit der Trennplatte 26 wird die Reaktorkammer 2 von einem an eine nicht dargestellte Evakuierungseinrichtung angeschlossenen Vorraum 28 separiert. Das Dichtelement 25 um die Öffnung 27 in der Bodenplatte bilden hier demgemäß eine Anschlußeinrichtung zum Anschluß einer Evakuierungseinrichtung zum zumindest teilweisen Evakuieren des Hohlraums 13 des Werkstücks 10 an die Kolbenöffnung der Spritze.

Wie anhand von Fig. 1 ersichtlich ist, wird der Hohlraum 13 des Spritzenkörpers 10 durch eine Öffnung an einem ersten Ende -hier dementsprechend die Kolbenöffnung 12- evakuiert und das Prozeßgas durch eine weitere Öffnung, nämlich die Öffnung 16 im Luer-Konus 15- an einem zweiten Ende des Spritzenkörpers 10, welches dem ersten Ende gegenüberliegt, eingeleitet. Dadurch durchströmt das Prozeßgas während der Beschichtung den Hohlraum 13 in axialer Richtung entlang seiner gesamten Länge. Aufgrund der axialsymmetrischen Anordnung von Luer-Konus 15, Zylinderwandung und Kolbenöffnung kommt es auch zu einem axialsymmetrischen Fluß des Porzeßgases durch den Hohlraum 13 des Spritzenkörpers 10.

Das Plasma im Behandlungsbereich, hier also der Hohlraum 13 wird weiterhin mittels einer Zündeinrichtung gezündet. Die Zündeinrichtung umfaßt dabei eine Einrichtung zur Anregung von Gas in dem von der Reaktorkammer separierten Vorraum 28. Im Speziellen ist die Zündeinrichtung hier eine im Vorraum 28 angeordnete Zündelektrode 29, mit welcher eine Glimmentladung gezündet und damit das im Vorraum befindiche Gas angeregt wird. Ein Zünden im Beschichtungsbereich, also hier das Innere des Spritzenkörpers 10 kann jedoch nur dann erfolgen, wenn gleichzeitig elektromagnetische Energie, beispielsweise Mikrowellen mit einer Frequenz von 2,45 GHz über den Koaxialleiter eingestrahlt werden. Die Zündung durch die im Vorraum 28 brennende Glimmentladung erfolgt erstaunlicherweise obwohl Vorraum 28 und Reaktorkammer durch die Trennwand 26 voneinander separiert sind und der Gasstrom aufgrund der Evakuierung in entgegengesetzte Richtung läuft. Überdies ist noch eine Abschirmung 30 für die elektromagnetische Energie zur Entkopplung der Zuleitung der Reaktorkammer 2 zur Evakuierungseinrichtung vorgesehen, welche das Eindringen der elektromagnetischen Wellen in den Vorraum 28 unterdrückt, um eine Zündung eines Plasmas in diesem Bereich zu vermeiden. Die Zündung mittels der Glimmentladung wird auch durch eine solche Abschirmung nicht oder zumindest nicht wesentlich beeinflußt. Ob eine Glimmentladung gezündet wurde, kann vorteilhaft mit einer Überwachungseinrichtung 23 überprüft werden. Diese kann beispielsweise eine oder mehrere Photodioden umfassen, welche optisch das Licht der Glimmentladung erfassen.

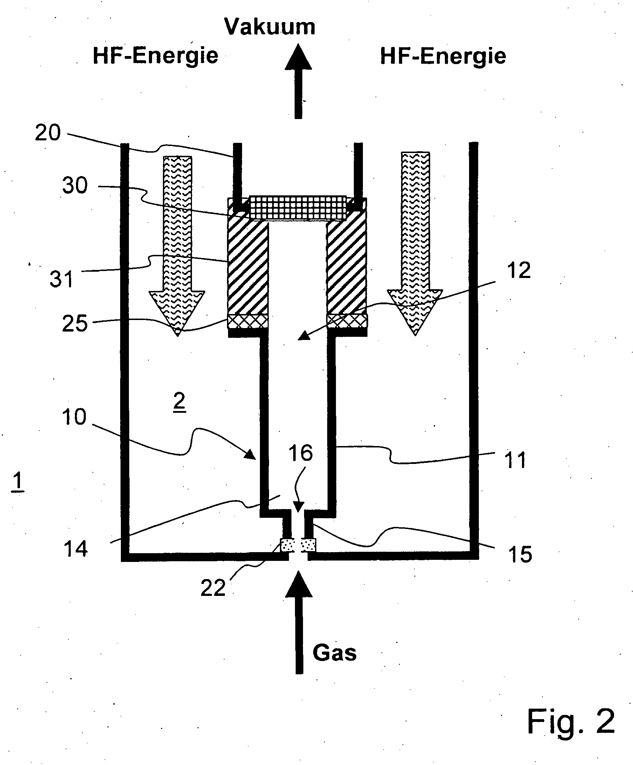

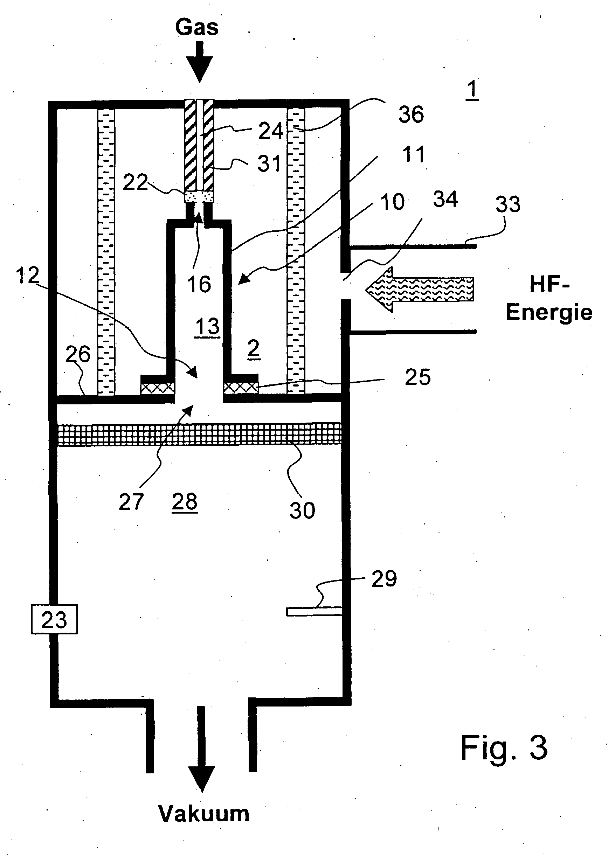

In Fig. 2 und 3 sind alternative Anordnungen eines wie in Fig. 1 dargestellen Durchflußreaktors 1 dargestellt.

Bei dem in Fig. 2 dargestellten Beispiel wird das Prozeßgas ebenfalls über den Luer-Konus 15, also die engere der beiden Öffnungen 12, 16 zugeführt. Die Anschlußeinrichtung zum Anschluß des Behandlungsbereiches, hier ebenfalls der Innenraum 13 des Spritzenkörpers 10, umfaßt bei dieser Ausführungsform der Erfindung ein mit dem Innenleiter 20 eines Koaxialleiters verbundenes Anschlußelement 31 mit Dichtelement 25, welches die Kolbenöffnung 12 des Spritzenkörpers 10 gegenüber dem übrigen Reaktorraum 2 abdichtet. Demgemäß wird hier nicht das Prozeßgas durch den Koaxialleiter zugeführt, sondern durch diesen hindurch abgeführt, sowie der Innenraum der Spritze evakuiert.

Bei dem in Fig. 3 dargestellten Beispiel wird die elektromagnetische Energie mit einem Hohlleiter 33, bevorzugt ein Rechteckhohlleiter und einen in den Reaktorraum 2 mündenden Spalt 34 anstelle eines Koaxialleiters durchgeführt. Ein dielektrisches Rohr dichtet den inneren Teil der Reaktorkammer 2 mit dem Spritzenkörper 10 gegenüber dem äußeren Teil ab, wobei die aus dem Spalt 34 austretenden elektromagnetischen Wellen das Rohr 36 passieren können. Anstelle oder zusätzlich zum dielektrischen Rohr 36 kann auch ein dielektrisches Fenster im Spalt 34 eingesetzt werden. Die Einstrahlung der elektromagnetischen Wellen erfolgt hier nicht in axialer Richtung des Spritzenkörpers 10, sondern seitlich. Bevorzugt wird eine HF- oder RF-Quelle in Verbindung mit dem Hohlleiter eingesetzt.

Der Luer-Konus 15 des Spritzenkörpers 10 wird mit einem Anschlußelement 31 und einem Dichtelement 22 dichtend an eine Gasversorgung angeschlossen. Im übrigen ist der Aufbau mit einem an eine Evakuierungseinrichtung angeschlossenen Vorraum 28, Zündelektrode 29 und einer Abschirmung 30 ähnlich zu dem in Fig. 1 dargestellten Beispiel.

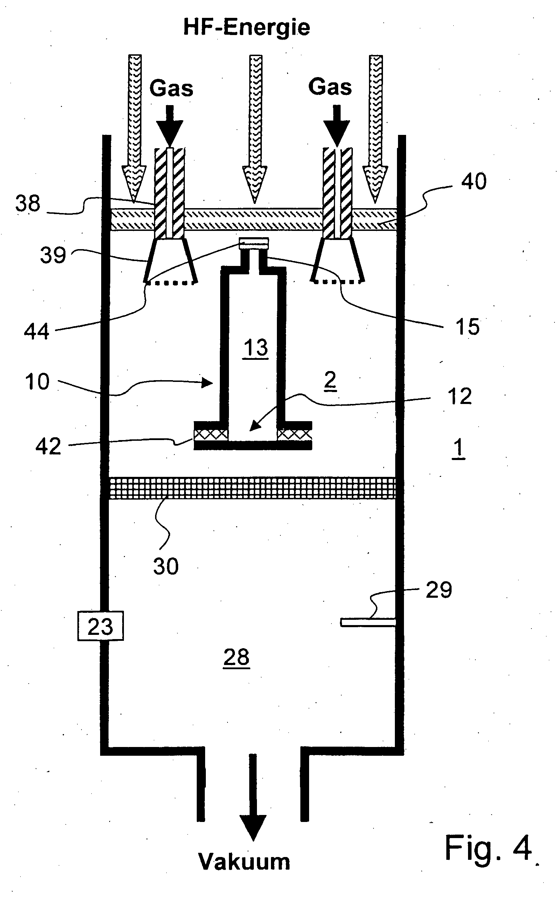

Fig. 4 zeigt eine Variante eines Durchflußreaktors 1 für die Außenbeschichtung von Werkstücken. Auch hier ist als zu beschichtendes Werkstück ein Spritzenkörper 10 dargestellt, selbstverständlich können aber auch andere Arten von Werkstücken, auch nicht hohlkörperförmige mit einer derartigen Anordnung plasmabehandelt, insbesondere plasmabeschichtet werden. Der Spritzenkörper wird für die Außembeschichtung sowohl an der Kolbenöffnung, als auch am Luer-Konus mit Dichtelementen 42, beziehungsweise 44 gegenüber dem übrigen Reaktorraum 2, der in diesem Fall den Behandlungsbereich bildet, abgedichtet. Insbesondere kann der Hohlraum 13 des Spritzenkörpers 10 während der Plasmabehandlung unter Atmosphärendruck verbleiben, während der umgegende Reaktorraum 2 über die an den Vorraum 28 angeschlossene Evakuierungseinrichtung evakuiert wird.

Bei diesem Beispiel ist der Vorraum 28 nicht über eine Trennwand, sondern nur über eine Abschirmung 30 vom Reaktorraum 2 separiert.

Über zwei oder mehrere Versorgungskanäle 38 mit daran angeschlossenen Gasverteilern 39 wird das Prozeßgas in den Behandlungsbereich eingeleitet und wird durch die Abschirmung 30 und den Vorraum 28 hindurch mit der Evakuierungseinrichtung abgesaugt. Die elektromagnetische Energie wird in diesem Beispiel aus der gleichen Richtung wie das Prozeßgas zugeführt. Ein dielektrisches Fenster 40 dichtet dabei die Reaktorkammer 2 vakuumdicht, jedoch transparent für die eingeleiteten elektromagnetischen Wellen ab. Auch bei diesem Beispiel durchströmt das Prozeßgas den Behandlungsbereich zwischen zwei gegenüberliegenden Enden.

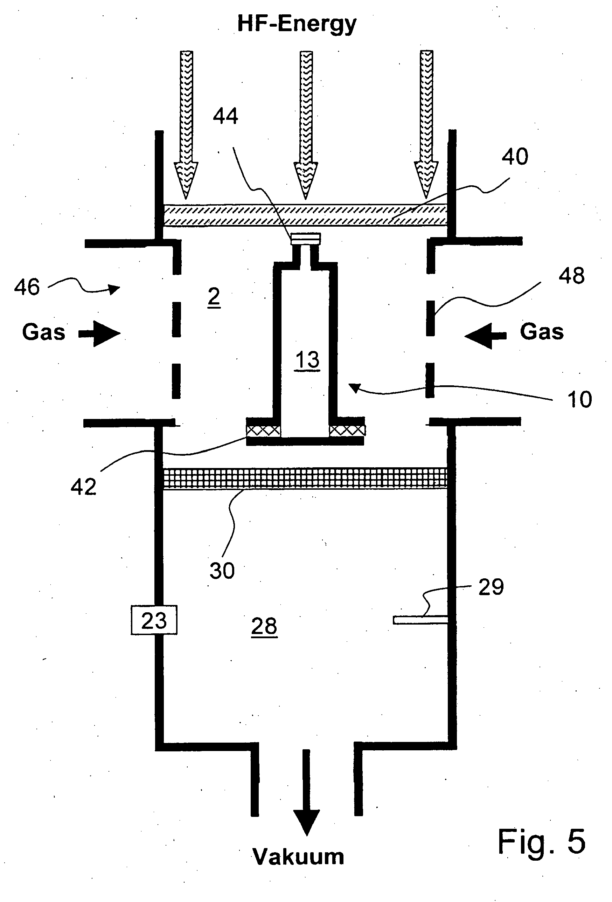

Fig. 5 zeigt eine Variante zu dem in Fig. 4 dargestellten Beispiel. Bei dieser Variante wird das Prozeßgas für eine Außenbehandlung, wie insbesondere eine äußere Beschichtung des Werkstücks seitlich zugeführt. Dazu sind in der Reaktorkammer 2 seitliche Öffnungen 46 eingelassen, die mit Abschirmungen 48 gegen das Eindringen elektromagnetischer Wellen in das Gaszuführungssystem versehen sind. Alternativ oder zusätzlich können die Abschirmungen auch als Gasverteiler wirken.

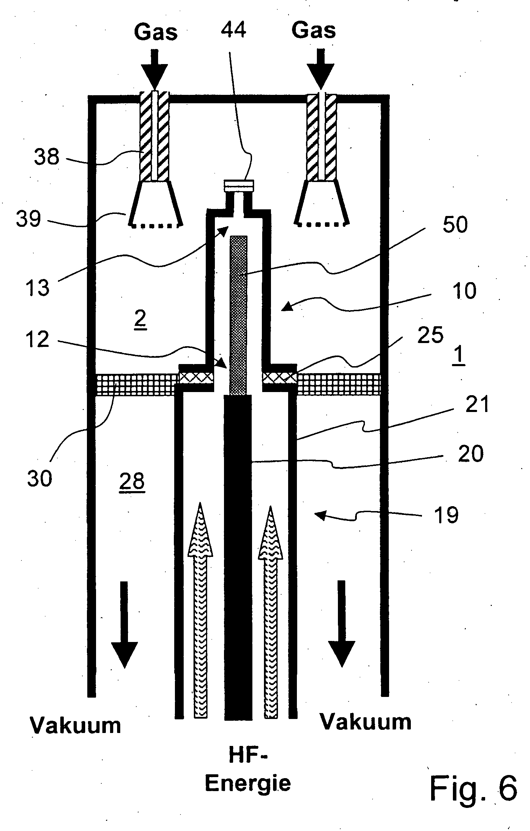

Die in Fig. 6 dargestellte Variante ist wiederum als Durchflußreaktor ausgebildet. Die Gaszuführung und das Vakuumsystem mit Vorraum 28 und Abschirmung 30 entpricht dem in Fig. 4 dargestellten Beispiel. Im Unterschied zu dem in Fig. 4 gezeigten Beispiel wird jedoch Mikrowellenenergie über einen Koaxialleiter 19 mit Innenleiter 20 und Außenleiter 21 zugeführt. Der Spritzenkörper 10 ist mittels eines Dichtelements 25 mit der Kolbenöffnung 12 dichtend mit dem Hohlleiter 19 verbunden. An den Innenleiter 20 des Hohlleiters 19 ist eine Antenne 50 angeschlossen, welche in den Hohlraum 13 des Spritzenkörpers 10 eingeführt wird. Die Antenne 50 sorgt dabei für eine bessere Einleitung und homogenere Verteilung der elektromagnetischen Felder.

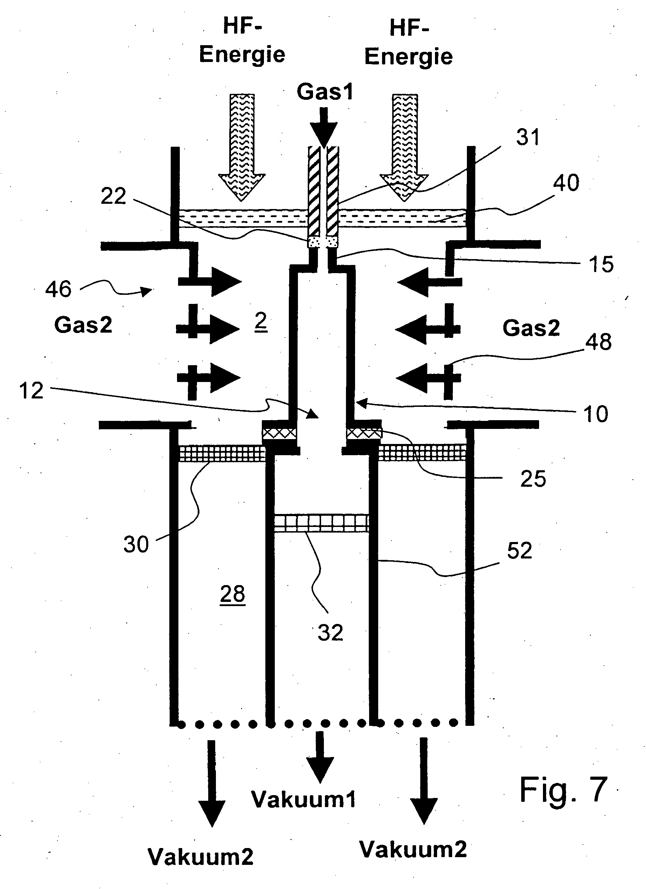

Fig. 7 zeigt einen Reaktor 1, der sowohl für einen Innen-, als auch eine Außenbeschichtung des Spritzenkörpers 10 ausgebildet ist. Dabei wird die Innenbeschichtung mit einem den inneren Behandlungsbereich, also den Hohlraum 13 des Spritzenkörpers mit zwischen gegenüberliegenden Enden durchfließendem Prozeßgas vorgenommen. Im Speziellen wird das Prozeßgas für die Innenbeschichtung über ein Anschlußelement 31 mit einem Versorgungskanal und einem Dichtelement 22 in den Luer-Konus 15 des Spritzenkörpers 10 eingefüllt und am gegenüberliegenden Ende, der Kolbenöffnung 12, wieder abgesaugt. Dazu ist die. Kolbenöffnung 12 über ein Dichtelement 25 mit einem durch den Vorraum 28 verlaufendes Rohr 52 verbunden, welches an eine erste Evakuierungseinrichtung "Vakuum 1" angeschlossen ist. Um ein Eindringen der elektromagnetischen Felder in das Rohr zu unterdrücken, ist in dem Rohr eine separate Abschirmung 32 angeordnet.

Die Gaszuführung und Abführung für das in die Umgebung der Spritze in den Reaktorraum eingeleitete Prozeßgas für eine Außenbehandlung, sowie die Zuführung der elektromagnetischen Energie durch ein für RF-, HF- oder Mikrowellen transparentes, vakuumdichtes Fenster 40 entspricht hier dem in Fig. 5 gezeigten Beispiel.

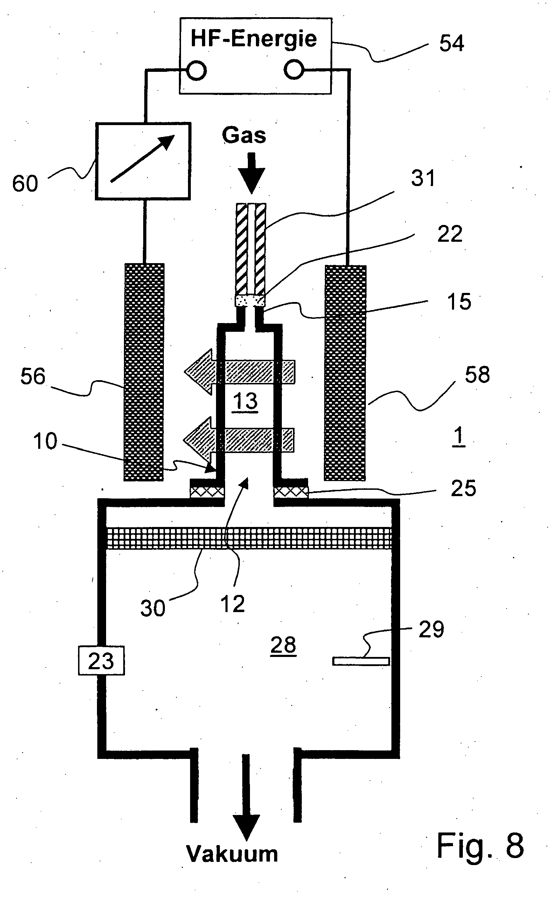

Fig. 8 zeigt eine Variante eines Durchflußreaktors ähnlich den in Fig. 1 oder 3 gezeigten Beispielen. Der Hohlraum 13 des Spritzenkörpers 13 wird wie bei den in Fig. 1 oder 3 gezeigten Beispielen vom Prozeßgas in axialer Richtung zwischen Luer-Konus 15 und der Kolbenöffnung 12 durchströmt. Anstelle einer Einstrahlung der elektromagnetischen Energie über Koaxial- oder Hohlleiter wird bei dem in Fig. 8 gezeigten Beispiel jedoch ein elektromagnetisches Feld zwischen zwei Elektroden 56, 58 erzeugt, die an einen Hochfrequenz-Generator 54 angeschlossen sind. Zusätzlich können noch ein oder mehrere Abstimmelemente 60 vorgesehen sein. Die Reaktorkammer kann wie bei diesem Beispiel durch den Hohlraum 13 des Spritzenkörpers 10 selbst gebildet werden.

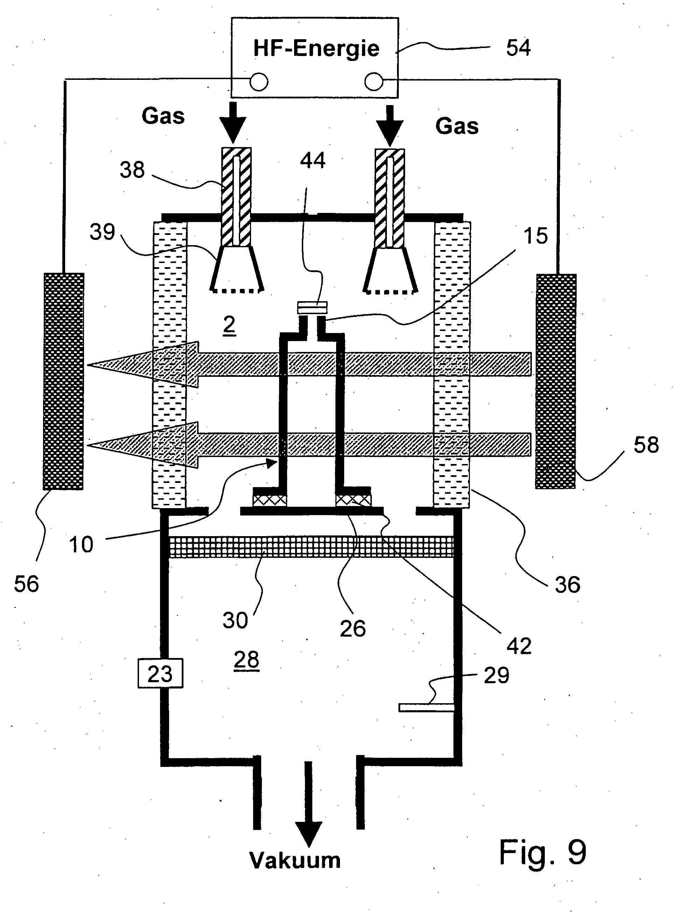

Fig. 9 zeigt eine Variante der in Fig. 8 gezeigten Anordnung, die für eine Außenbeschichtung von Werkstücken, wie dem abgebildeten Spritzenkörper 10 eingerichtet ist. Auch diese Variante ist als Durchflußreaktor ausgebildet, wobei das Prozeßgas auf einer Seite der Reaktorkammer 2 über zwei oder mehrere Versorgungskanäle 38 mit daran angeschlossenen Gasverteilern 39 in den Behandlungsbereich eingeleitet und durch in der gegenüberliegenden Trennplatte zwischen Reaktorkammer 2 und dem Vorraum 28 angeordnete Öffnungen wieder abgesaugt wird. Die Seitenwandungen der Reaktorkammer werden durch ein dielektrisches Rohr 36 gebildet oder können alternativ dielektrische Wandelemente aufweisen, so daß das von den Elektroden 56, 58 abgestrahlte Hochfrequenzfeld den Reaktorraum 2 durchdringen kann. Der Hohlraum 13 der Spritze ist mit Dichtelementen 42, 44 abgedichtet und kann bei Atmosphärendruck gehalten, werden, während der Behandlungsbereich, also die Bereiche der Reaktorkammer 2, welche den Spritzenkörper 10 umgeben, evakuiert wird.

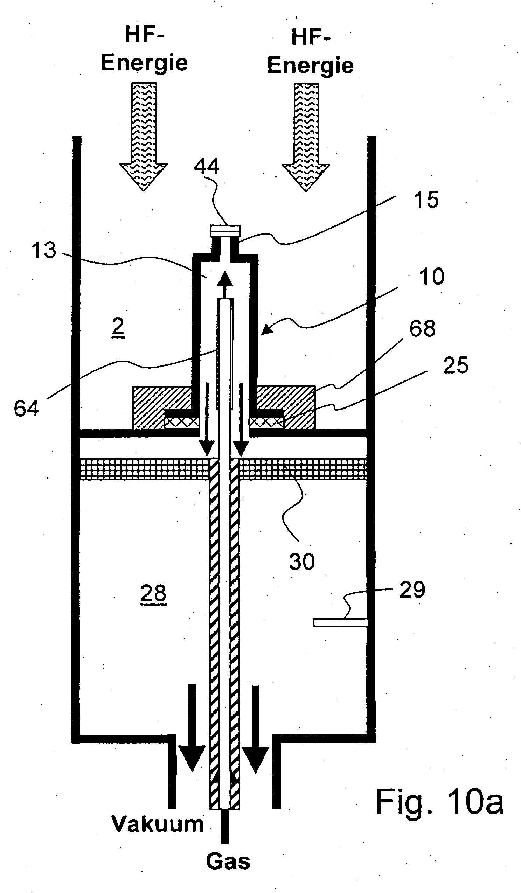

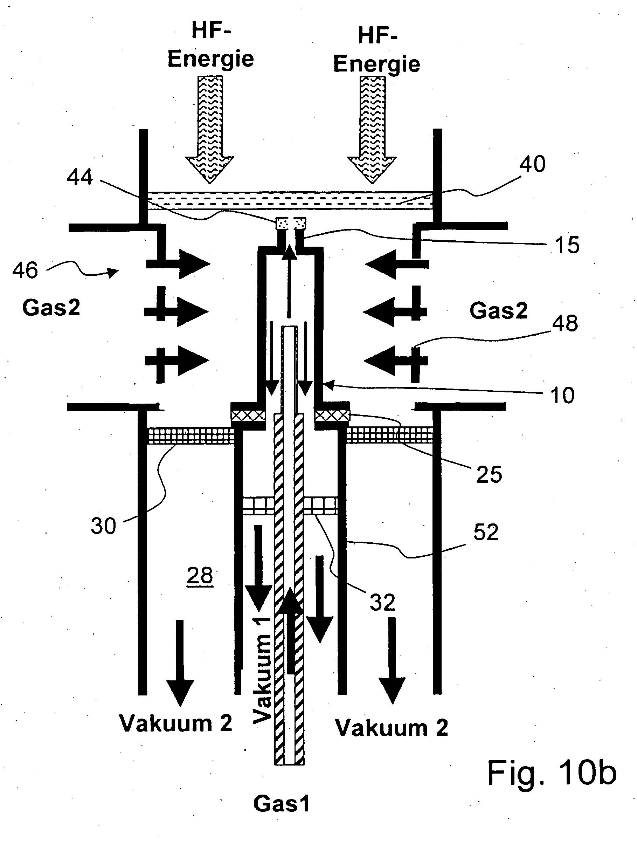

Die Fig. 10a und 10b zeigen zwei Varianten von Umkehrströmungsreaktoren. Der in Fig. 10a gezeigte Reaktor ist vom Aufbau dem in Fig. 1 gezeigten Durchflußreaktor ähnlich. Im Unterschied zu dem in Fig. 1 gezeigten Beispiel wird das Prozeßgas in den Hohlraum 13 jedoch nicht durch den Luer-Konus 15 eingelassen. Der Luer-Konus ist in diesem Beispiel vielmehr mit einem Dichtelement gegenüber der übrigen Reaktorkammer 2 abgedichtet. Die Zuführung von Prozeßgas erfolgt hier über eine Kanüle 64, welche durch die Kolbenöffnung 12 in den Hohlraum 13 hineinragt. Die Kanüle ragt dabei zumindest 3/4, vorzugsweise 9/10, besonders bevorzugt 95/100 der Längserstreckung des Hohlraums 13 in den Spritzenkörper hinein.

Zusätzlich wird mittels einer den Fuß des Spritzenkörpers mit der Kolbenöffnung umgebenden metallischen Abschirmung die eingestrahlte elektromagnetische Energie lokal von Bereichen des Hohlraums 13 zumindest teilweise mittels abgeschirmt. Damit wird verhindert, daß sich lokal an dieser Stelle ein besonders heiß brennendes Plasma bilden kann, welches den Spritzenkörper 10 beschädigen kann. Diese Maßnahme kann selbstverständlich auch bei den übrigen in den Figuren dargestellten Ausführungsformen eingesetzt werden.

Das in Fig. 10b gezeigte Beispiel zeigt einen Reaktor, welcher für eine Innen- und Außenbeschichtung von Spritzenkörpern 10 ausgelegt ist. Der Reaktor ähnelt in seinem Aufbau dem in Fig. 7 gezeigten Beispiel, wobei in dem in Fig. 10b gezeigten Beispiel das Prozeßgas für dien Inenbehandlung durch eine in den Hohlraum 13 hineinragende Kanüle 64 zugeführt wird.

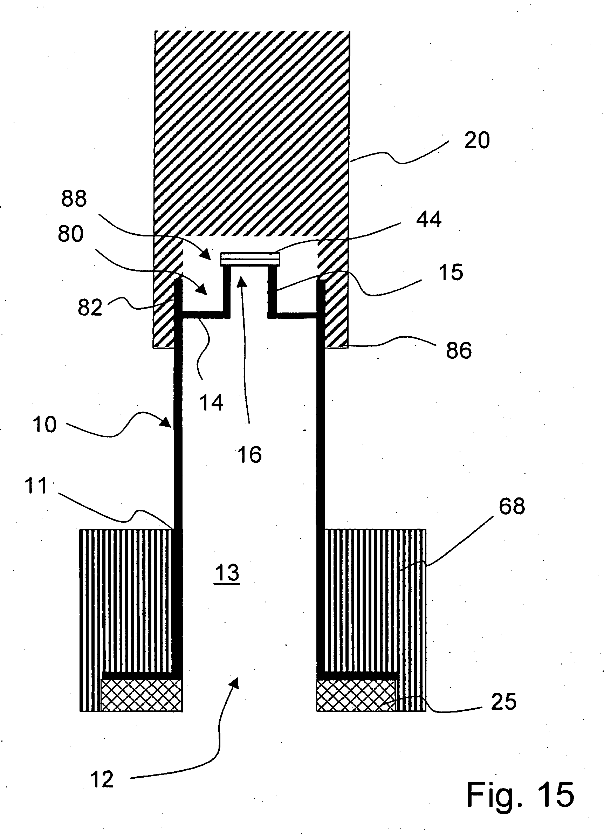

Fig. 15 zeigt Details eines Reaktors mit Zuführung elektromagnetischer Energie über einen Koaxialleiter. Der Außenleiter ist der Einfachheit halber nicht dargestellt. Der Innenleiter 20 weist einen axial verlaufenden Kanal 70 auf, durch den Prozeßgas über die Öffnung 16 in den Hohl- oder Innenraum 13 des Spritzenkörpers 10 eingeleitet werden kann. Zur Herstellung eines dichtenden Anschlusses an die Öffnung 16 des Luer-Konus 15 ist ein innenseitiges, den Kanal 70 abschließendes Dichtelement 72 vorgesehen. Dieses, wie auch die anderen Dichtelemente sind bevorzugt aus flexiblem Material, insbesondere aus Elastomermaterial, wie Silikon-Gummi, Bromobutyl - Elastomer, oder Polyisoprene-Bromobutyl-Elastomer gefertigt.

Ein solcher Koaxialleiter kann dann beispielsweise für den in Fig. 1 dargestellten Reaktor verwendet werden. Ebenso kann aber auch der Behandlungsbereich durch den Koaxialleiter evakuierbar sein, wobei dann der axial verlaufende Kanal 70 an eine Evakuierungseinrichtung angeschlossen ist.

Der Spritzenkörper 10 weist in diesem Beispiel noch einen weiteren Hohlraum 80 auf, welcher zwischen einem auf dem Deckelelement 14 des Spritzenkörpers umlaufenden Rand 82 und dem Luer-Konus 15 gebildet wird. Dieser Hohlraum kann nur schwer abgepumpt werden. Dadurch kann sich auch in diesem Hohlraum 80 bei Einstrahlung elektromagnetischer Wellen für die Plasmabeschichtung ein unerwünschtes Plasma bilden. Um dies zu vermeiden, weist der Innenleiter 20 einen integrierten Füllkörper 84 auf, welcher beim Aufsetzen des Innenleiters 20 und der Fixierung des Spritzenkörpers 10 in den Hohlraum 80 eingeführt wird und diesen zumindest teilweise ausfüllt. Der Füllkörper 84 kann beispielsweise aus dielektrischem Material, wie Kunststoff, beziehungsweise Polymeren oder Keramik oder auch metallischem Material sein, um hochfrequente elektromagnetische Energie zu absorbieren oder zu reflektieren und so eine Zündung eines Plasmas in unmittelbarer Umgebung des ausgefüllten Bereichs zu verhindern. Durch den Füllkörper 84 wird die Temperaturverteilung auf dem Werkstück während und nach der Plasmabehandlung gleichmäßiger, verglichen mit einer Plasmabehandlung ohne einen solchen Füllkörper.

Der Innenleiter 20 weist außerdem noch einen Kragen 86 auf, welcher den Zylinder 11 des Spritzenkörpers 10 entlang eines Teils seiner axialen Länge umgibt. Dieser Kragen wirkt als Abschirmung, um eingestrahlte elektromagnetische Energie lokal von Bereichen des Hohlraums des Werkstücks abzuschirmen. Damit wird verhindert, daß im engen Luer-Konus 15 ein zu heißes Plasma brennt, welches das Werkstück beschädigen kann.

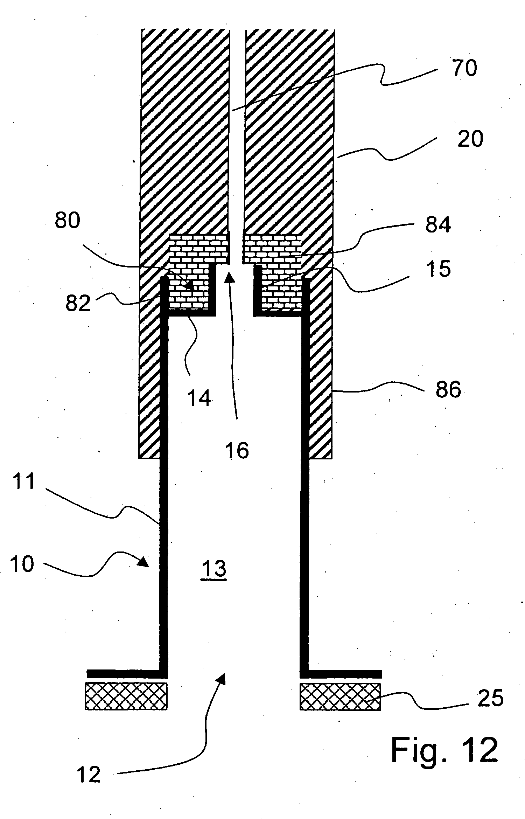

Bei der in Fig. 12 dargestellten Variante bildet der Füllkörper 84 gleichzeitig ein Dichtelement zur Abdichtung des Hohlraums 13 und eines dichtenden Anschlusses an den Kanal 70. Vorzugsweise ist der Füllkörper 84 in diesem Fall aus elastomerem Material, insbesondere Silikon-Kautschuk, Bromobutyl - Elastomer, oder Polyisoprene-Bromobutyl-Elastomer gefertigt.

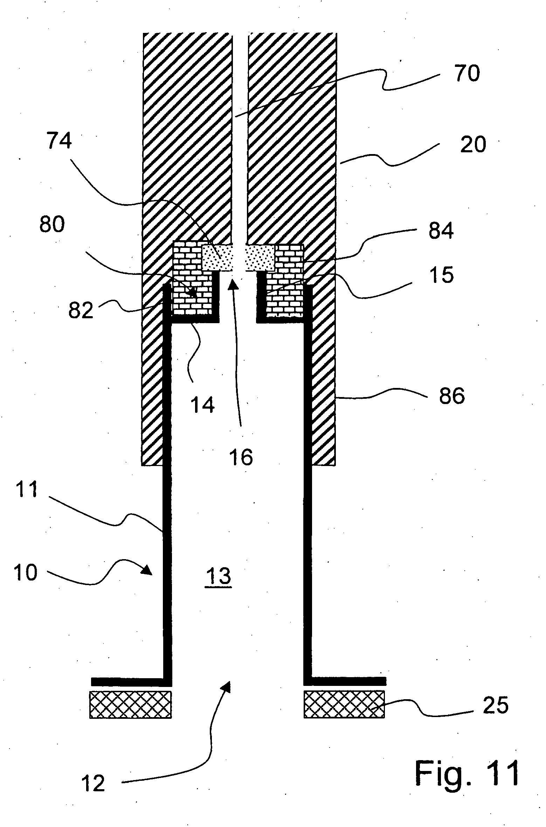

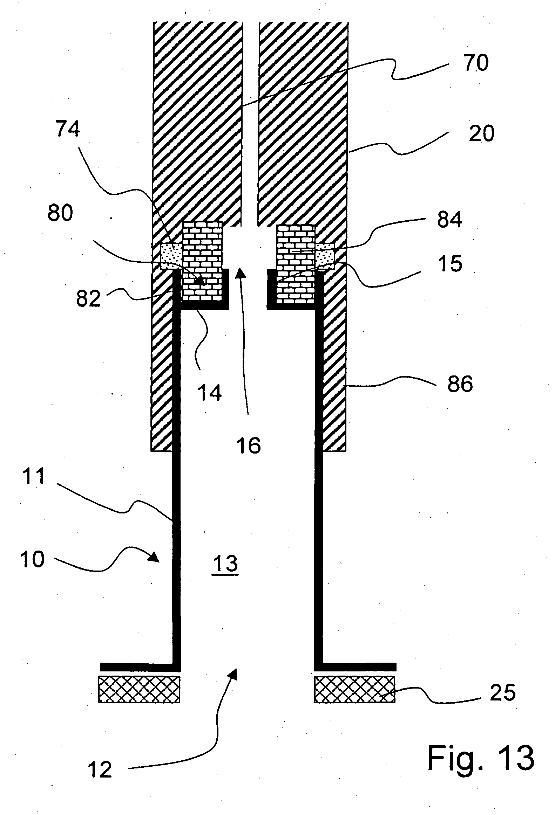

Bei der in Fig. 13 gezeigten weiteren Variante ist ähnlich zu dem in Fig. 11 dargestellten Beispiel ein separates Dichtelement 74 vorgesehen. Im Unterschied zu dem in Fig. 11 gezeigten Beispiel setzt das ringförmige Dichtelement 74 hier jedoch nicht auf den Luer-Konus 15, sondern auf dem umlaufenden Rand 82 auf.

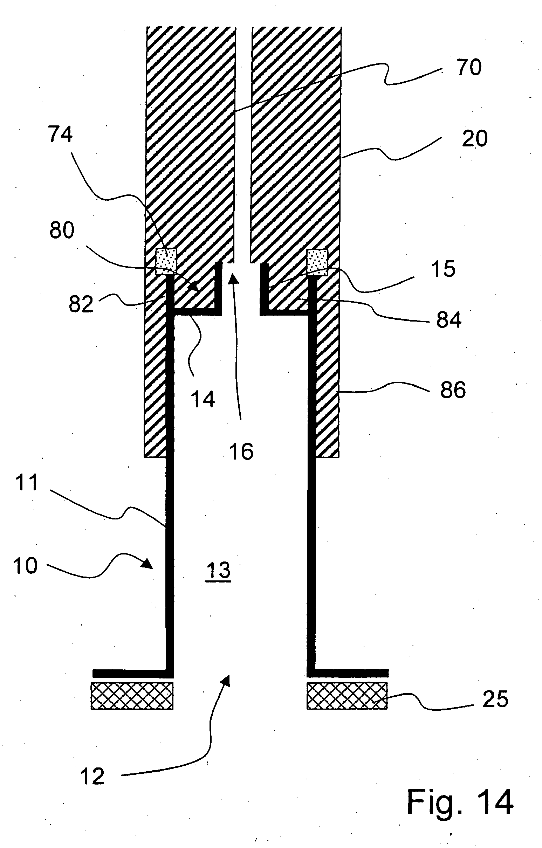

Bei der in Fig. 14 gezeigten Variante ist der Füllkörper 84 kein separates Teil, sondern wird aus einem Abschnitt des Innenleiter-Materials selbst gebildet.

Fig. 15 zeigt ein Ausführungsbeispiel für eine Beschichtung mit einem Umkehrströmungsreaktor, wie er beispielsweise in Fig. 10a dargestellt ist. Die Kanüle zur Zuführung des Prozeßgases ist in diesem Beispiel der Einfachheit halber nicht dargestellt.

Der Innenleiter weist einen Hohlraum 88 auf, welcher wie bei den vorangegangenen Beispielen durch einen Kragen 86 gebildet wird. Der Spritzenkörper 10 wird mit dem Luer-Konus 15 in den Hohlraum eingeführt, so daß der Kragen 86 den Zylinder 11 teilweise umgibt und den Bereich des Hohlraumes 13 im Luer-Konus 15 teilweise abschirmt. Die Öffnung 16 im Luer-Konus 15 ist wie bei dem in Fig. 10a gezeigten Beispiel mit einem Dichtelement 44 abgedichtet. Eine Ausfüllung des Hohlraumes 80 kann bei diesem Beispiel entfallen, da die Umgebung des Spritzenkörpers 10 auf Atmosphärendruck verbleibt und nur innenseitig evakuiert wird.

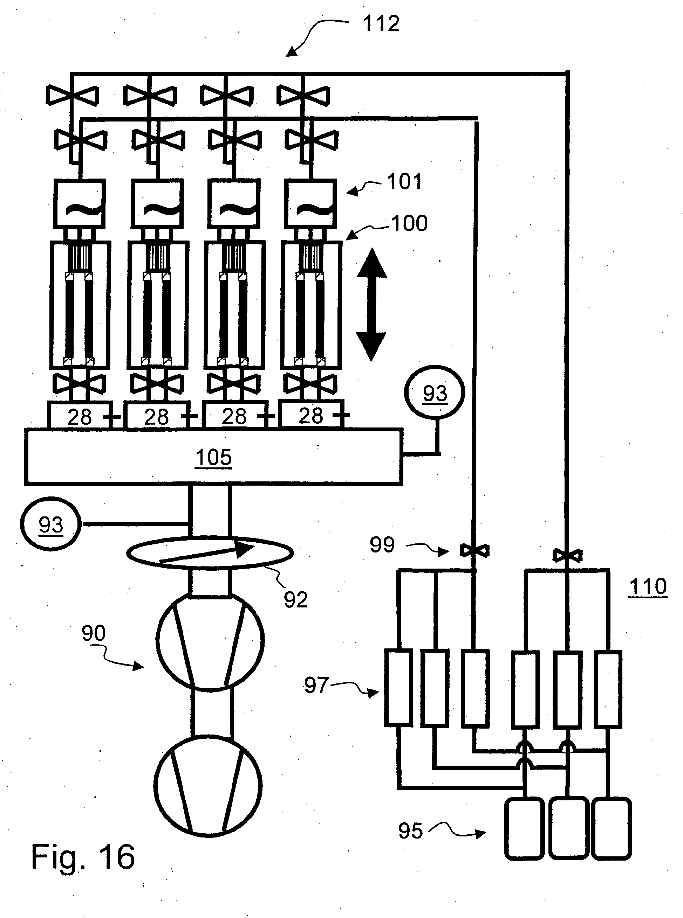

Fig. 16 zeigt ein Ausführungsbeispiel einer als Mehrplatz-Beschichtungsanlage ausgebildeten erfindungsgemäßen Vorrichtung. Eine Mehrplatz-Beschichtungsanlage, wie,sie als Beispiel in Fig. 16 dargestellt ist, kann für eine gleichzeitige Beschichtung mehrerer Werkstücke eingerichtet sein. Das in Fig. 16 gezeigte Beispiel weist im Speziellen vier Reaktoren 100 auf, jedoch können auch beispielsweise zwei oder mehr Reaktoren eingesetzt werden. Die Reaktoren sind vorzugsweise als Durchflußreaktoren ausgebildet. Die Anlage weist eine Versorgungsquelle 110 mit Steuereinrichtung zum Bereitstellen eines Strömungsmittels oder Strömungsmittelgemisches, vorzugsweise von zwei unterscheidbaren Strömungsmittel-, beziehungsweise Prozeßgasgemischen auf. Damit können beispielsweise sequentiell eine Haftvermittler- und eine Barrierebeschichtung mittels Plasmabeschichtung abgeschieden werden. Über die Ventile 112 an den Reaktoren können die von der Versorgungsquelle 110 bereitgestellten Gase oder Gasgemische separat in die Reaktoren 100 eingelassen werden. Zur Bereitstellung der Strömungsmittelgemische weist die Versorgungseinrichtung mehrere Gasbehälter 95 auf, welche über Massenflußregler 97 mit zwei Steuerventilen 99 verbunden sind. Die Reaktoren 100 mit den Beschichtungsplätzen weisen jeweils separate Energiequellen 101 auf. Dies vermeidet ein übersprechendes Verhalten bei der gleichzeitigen Beschichtung. Weiterhin ist für jeden Reaktor 100 ein separater Vorraum 28 mit nicht dargestellter Zündeinrichtung vorgesehen. Die Zündeinrichtung ist vorzugsweise eine wie in fig. 1 dargestellte Zündelektrode. Dabei sind die Zündeinrichtungen ebenfalls wieder mit jeweils separaten Energiequellen zur Anregung der Glimmentladung in den jeweiligen Vorräumen ausgestattet. Auch dies verhindert ein Übersprechen zwischen den Reaktoren. Die Vorräume 28 und damit auch die Reaktoren 100 sind über eine weitere Kammer 105 gemeinsam mit einer Vakuumerzeugungseinrichtung verbunden, was den apparativen Aufwand senkt, ohne ein übersprechendes Verhalten bei einer gleichzeitigen Beschichtung hervorzurufen. Eine Regeleinrichtung 92 regelt die Pumpleistung der Einrichtung 90. Zur Überwachung der Evakuierung und des Prozeßgas-Anfalls sind in der gemeinsamen Kammer 105 und in der Zuleitung zur Vakuumerzeugungseinrichtung 90 Druckmesser 93 vorgesehen.

Die Erfindung wird nachfolgend weiter anhand von Ausführungsbeispielen für Beschichtungsverfahren erläutert.

Bei den im folgenden dargestellten Ausführungsbeispielen wird zunächst in einem Unterraum eine Glimmentladung gezündet, durch die noch keine Schichtabscheidung auf dem Substrat erfolgt. Erst durch Einkopplung von hochfrequenter Energie in den Beschichtungsreaktor wird mittels dieser Glimmentladung das Plasma im Beschichtungsreaktor gezündet. Für die Glimmentladung wird dabei bei den genannten Beispielen ein Strom im Bereich von 5mA~50mA und eine Frequenz im Bereich von 10-25 kHz verwendet. Die Glimmentladung ist stromgeregelt. Die verwendete Hochspannung liegt zwischen 0,5-2kV.

Ausführungsbeispiel 1a: PECVD-Verfahren, Innenbeschichtung mit Durchfluß-Reaktor

Eine Spritze aus COC (Cyclic Olefinic Copolymer), 1 ml Volumen mit einer Zylinderhöhe von 54mm und einem Zylinderinnendurchmesser von 6,5mm, einer Gesamthöhe von 64,5mm und einem Luer-Konus nach DIN 594 mit einer Länge von 10mm und mit einem inneren Öffnungsdurchmesser von 2 mm wird in den in Fig. 1 beschriebenen Reaktor mit dem großen Querschnitt nach unten und dem engen Querschnitt (Luer-Konus) nach oben zugeführt. Dabei liegt die Spritze zunächst auf der Unterseite des Reaktors auf der Dichtfläche auf. Anschließend wird die Oberseite des Reaktors zugefahren und beim Schließen des Reaktors wird die Spritze an der Oberseite vakuumdicht abgedichtet. Der Gegendruck stellt sicher, dass die Spritze auch untenseitig vakuumdicht aufliegt. Anschließend wird der Innenraum der Spritze evakuiert bis ein Basisdruck < 0,05mbar erreicht wird. Der Außenraum bleibt während des gesamten Behandlungsvorgangs auf Atmosphärendruck. Während untenseitig die Verbindung zum Vakuum beibehalten bleibt, wird das Gaseinlass-Ventil geöffnet und über die Seite mit dem engen Querschnitt, d.h. beim Luer-Konus der Spritze, ein erstes Gasgemisch aus Sauerstoff und Hexamethyldisiloxan mit einem HMDSO-Fluss von 3,4 sccm und einem Sauerstoff-Fluss von 16,6 sccm bei einem Druck von 0,55 mbar eingeleitet. In diesem Durchfluss-Betrieb stellt sich ein kontinuierlicher Fluss ein, bei dem das Gas parallel zur Symmetrieachse vom engen Querschnitt bis zum weiten Querschnitt strömt. Mittels der Zündvorrichtung wird im Unterraum eine Glimmentladung gezündet, wodurch aber noch keine Schichtabscheidung auf der Spritzen-Innenseite erfolgt. Erst ab dem Zeitpunkt, sobald gepulste Mikrowellen-Energie von der Mikrowellenquelle mit einer Frequenz von 2,45 GHz mit einer mittleren Pulsleistung von 57 Watt über den Wellenleiter in den Reaktorraum eingekoppelt wird, zündet im Innenraum der Spritze ein Plasma, während außenseitig aufgrund des Atmosphärendrucks kein Plasma zündet.

Die Spritze wird, während des Vorgangs innenseitig mit einer ersten Haftvermittler-Schicht für eine erste Beschichtungsdauer von 1,0 s und mit einer mittleren Schichtdicke von 40 nm beschichtet. Gegen Ende der ersten Beschichtung wird die Mikrowellen-Energie gestoppt. Anschließend folgt eine Gaswechselzeit, in der ein zweites Gasgemisch aus Hexamethyldisiloxan (HMDSO) und Sauerstoff mit einem HMDSO-Fluss von 0,2 sccm und einem Sauerstoff-Fluss von 39,8 sccm bei einem Druck von 0,8 mbar in den Innenraum der Spritze geleitet wird.

Sobald gepulste Mikrowellen-Energie von der Mikrowellenquelle mit einer Frequenz von 2,45 GHz und mit einer mittleren Mikrowellenleistung von 30,8W über den Wellenleiter in den Reaktorraum eingeleitet wird, zündet innen in der Spritze ein Plasma und es wird eine zweite anorganische Barriere-Schicht für eine zweite Beschichtungsdauer von 55,4 s und mit einer mittleren Schichtdicke von 30 nm aufgebracht. Gegen Ende des Beschichtungsvorgangs wird die Mikrowellen-Energie gestoppt, die Zufuhr des Prozessgases wird unterbrochen. In einer Abkühlpause wird die Beschichtung unterbrochen und die Spritze auf Raumtemperatur abgekühlt. Anschließend wird nach erneutem Evakuieren eine 3. anorganische Barriere-Schicht bei gleichen Prozessparametern und mit gleicher mittlerer Schichtdicke von 30nm aufgebracht, so dass die gesamte mittlere Barriere-Dicke 60nm beträgt. Gegen Ende des Prozesses wird der Innenraum der Spritze auf Atmosphärendruck geflutet.

Die beschichteten Spritzen weisen bei 23°C und 50% rel. Luftfeuchtigkeit eine Sauerstoff-Permeation von 0,0018 cm$^3$ / (Pckg d 0,21bar) auf, während unbeschichtete Spritzen eine Sauerstoff-Permeation von 0,0074 cm$^3$ / (Pckg d 0,21bar) besitzen, so dass die Barriere-Verbesserung für Sauerstoff besser als Faktor 4 ist.

Ausführungsbeispiel 1b: Durchfluss-Reaktor, Beschichtung des Luer-Konus:

Analog zu Beispiel 1a wird eine 1ml COC-Spritze innen im Durchfluss-Reaktor beschichtet.

Schritt1:

Dabei wird beim Luer-Konus der Spritze, ein erstes Gasgemisch aus Sauerstoff und Hexamethyldisiloxan mit einem HMDSO-Fluss von 3,4 sccm und einem Sauerstoff-Fluss von 16,6 sccm bei einem Druck von 0,55 mbar eingeleitet. Mittels der Zündvorrichtung wird im Unterraum eine Glimmentladung gezündet, wodurch aber noch keine Schichtabscheidung auf der Spritzen-Innenseite erfolgt. Erst ab dem Zeitpunkt, sobald gepulste Mikrowellen-Energie von der Mikrowellenquelle mit einer Frequenz von 2,45 GHz mit einer mittleren Pulsleistung von 57 Watt über den Wellenleiter in den Reaktorraum eingekoppelt wird, zündet im Innenraum der Spritze ein Plasma, während außenseitig aufgrund des Atmosphärendrucks kein Plasma zündet. Die Spritze wird, während des Vorgangs innenseitig mit einer ersten Haftvermittler-Schicht für eine erste Beschichtungsdauer von 0,9s beschichtet. Gegen Ende der ersten Beschichtung wird die Mikrowellen-Energie gestoppt.

Schritt2:

Anschließend folgt eine Gaswechselzeit, in der ein zweites Gasgemisch aus Hexamethyldisiloxan (HMDSO) und Sauerstoff mit einem HMDSO-Fluss von 0,6 sccm und einem Sauerstoff-Fluss von 39,4 sccm bei einem Druck von 0,15mbar in den Innenraum der Spritze geleitet wird. Sobald gepulste Mikrowellen-Energie von der Mikrowellenquelle mit einer Frequenz von 2,45 GHz und mit einer mittleren Mikrowellenleistung von 30,8 W über den Wellenleiter in den Reaktorraum eingeleitet wird, zündet innen in der Spritze ein Plasma und es wird eine zweite anorganische Barriere-Schicht für eine zweite Beschichtungsdauer von 47s aufgebracht.

Gegen Ende des Beschichtungsvorgangs wird die Mikrowellen-Energie gestoppt, die Zufuhr des Prozessgases wird unterbrochen. In einer Abkühlphase wird der Spritzenkörper innenseitig mit Stickstoff geflutet und anschließend wieder evakuiert. Anschließend wird der Schritt2 unter Beibehaltung der gleichen Beschichtungsdauer wiederholt. Gegen Ende des Prozesses wird der Innenraum der Spritze auf Atmosphärendruck geflutet.

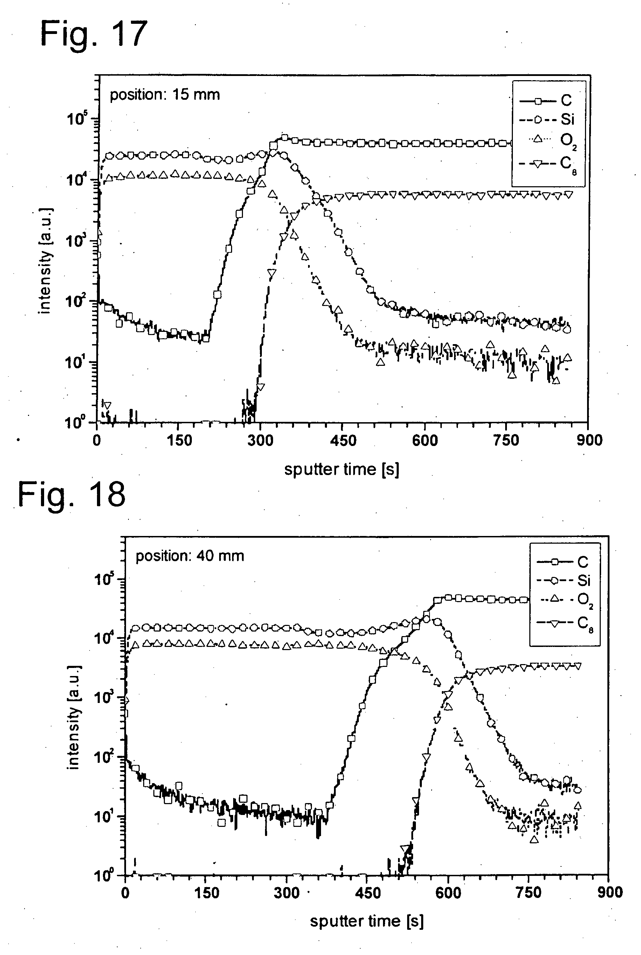

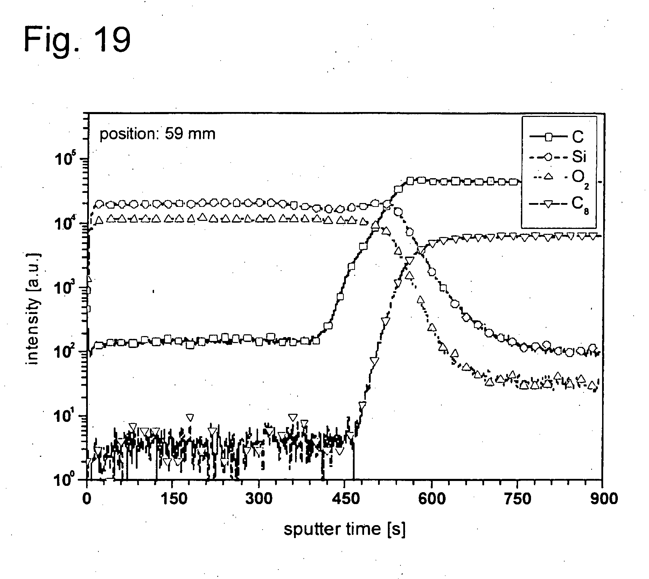

Mittels Sekundärionen-Massenspektrometrie (SIMS) - Tiefenprofilierung wurde der so beschichtete Spritzenkörper an 3 Positionen untersucht. In den Fig. 17 bis 19 sind dazu die SIMS-Intensitäts-Sputterzeitprofile an drei verschiedenen Stellen des beschichteten Spritzenkörpers dargestellt. Dabei zeigt Fig. 17 ein solches Profil im Bereich der Öffnung mit großen Durchmesser ("Position 15mm"), Fig. 18 ein solches Profilim Bereich der Mitte des Spritzenzylinders ("Position 40mm") und Fig. 19 ein solches Profil am engen Kanal des Luer-Konus der Spritze ("Position 59mm"). Dargestellt sind die Verläufe für die Elemente / Verbindungen C, Si, $O_2$ und die Kette C8. Der Übergang vom Schichtsystem zum Substrat ist anhand des Intensitätsabfalls in den Si- und O-Sputterzeitprofilen zu erkennen. Die unterschiedlichen Verläufe für die C- und C8-Sputterzeitprofile sind durch die Kohlenstoff-haltige Haftvermittler-Schicht verursacht.

Basierend auf den Daten der Tiefenprofilierungen, wie sie in den Fig. 17 bis 19 dargestellt sind, wird die relative,lokale Schichtdicke des Gesamtsystems bestimmt. Dazu wird die Sputterzeit $\tau$ ermittelt, in der die Si- bzw. O-SIMS-Sputterzeit-Profile in der Schicht auf die halbe Intensität abgefallen sind. Die relativen, normierten Schichtdicken $d_{rel}$ ergeben sich dabei aus dem Verhältnis der ermittelten Zeiten $\tau_1$ und $\tau_{ref}$:

$$d_{rel} = D_1 / D_{ref} = \tau_1/\tau_{ref,}$$

wobei $D_1$ und $D_{ref}$ den absoluten lokalen Schichtdicken entsprechen. Als Referenz-Position wurde dabei die "Position 40mm" gewählt.

Es ergeben sich als relative Dicken:

| Position | Relative Dicke $d_{rel}$ (%) |
|---|---|
| 15mm (Öffnung) | 60 |
| 40mm (Mitte) | 100 |
| 59mm (Luer-Konus) | 93 |

Insbesondere ist durch diese Analysen gezeigt, dass der enge Luer-Kanal der Spritze innenseitig beschichtet werden kann und dass beim Durchfluss-Reaktor eine sehr gute Schichtuniformität erreicht wird: Der Dickenunterschied zwischen Luer-Konus (59mm) und Zylindermitte (40mm) beträgt nur 93% / 100%.

Ausführungsbeispiel 1c: PECVD-Verfahren, Innenbeschichtung mit Durchfluß-Reaktor, mehrlagige Wechselschichten

i) Schichtsystem I:

Eine Spritze aus COC (Cyclic Olefinic Copolymer), 1 ml Volumen mit einer Zylinderhöhe von 54mm und einem Zylinderinnendurchmesser von 6,5mm, einer Gesamthöhe von 64,5mm und einem Luer-Konus nach DIN 594 mit einer Länge von 10mm und mit einem inneren Öffnungsdurchmesser von 2 mm wird in den in Fig. 1 beschriebenen Reaktor mit dem großen Querschnitt nach unten und dem engen Querschnitt (Luer-Konus) nach oben zugeführt. Dabei liegt die Spritze zunächst auf der Unterseite des Reaktors auf der Dichtfläche auf. Anschließend wird die Oberseite des Reaktors zugefahren und beim Schließen des Reaktors wird die Spritze an der Oberseite vakuumdicht abgedichtet. Der Gegendruck stellt sicher, dass die Spritze auch untenseitig vakuumdicht aufliegt.

Schritt1) Anschließend wird der Innenraum der Spritze evakuiert bis ein Basisdruck < 0,05mbar erreicht wird. Der Außenraum bleibt während des gesamten Behandlungsvorgangs auf Atmosphärendruck. Während untenseitig die Verbindung zum Vakuum beibehalten bleibt, wird das Gaseinlass-Ventil geöffnet und über die Seite mit dem engen Querschnitt, d.h. beim Luer-Konus der Spritze, ein erstes Gasgemisch aus Sauerstoff und Hexamethyldisiloxan mit einem HMDSO-Fluss von 3,4 sccm und einem Sauerstoff-Fluss von 16,6 sccm bei einem Druck von 0,55 mbar eingeleitet. Mittels der Zündvorrichtung wird im Unterraum eine Glimmentladung gezündet, wodurch aber noch keine Schichtabscheidung auf der Spritzen-Innenseite erfolgt. Erst ab dem Zeitpunkt, sobald gepulste Mikrowellen-Energie von der Mikrowellenquelle mit einer Frequenz von 2,45 GHz mit einer mittleren Pulsleistung von 57 Watt über den Wellenleiter in den Reaktorraum eingekoppelt wird, zündet im Innenraum der Spritze ein Plasma, während außenseitig aufgrund des Atmosphärendrucks kein Plasma zündet.

Die Spritze wird, während des Vorgangs innenseitig mit einer ersten Haftvermittler-Schicht mit einer mittleren Schichtdicke von 40 nm beschichtet. Gegen Ende der ersten Beschichtung wird die Mikrowellen-Energie gestoppt.

Schritt2: .

Anschließend folgt eine Gaswechselzeit, in der ein zweites Gasgemisch aus Hexamethyldisiloxan (HMDSO) und Sauerstoff mit einem HMDSO-Fluss von 0,6 sccm und einem Sauerstoff-Fluss von 39,4 sccm bei einem Druck von 0,15 mbar in den Innenraum der Spritze geleitet wird.

Sobald gepulste Mikrowellen-Energie von der Mikrowellenquelle mit einer Frequenz von 2,45 GHz und mit einer mittleren Mikrowellenleistung von 30,8W über den Wellenleiter in den Reaktorraum eingeleitet wird, zündet innen in der Spritze ein Plasma und es wird eine zweite anorganische Barriere-Schicht mit einer mittleren Schichtdicke von 100nm aufgebracht. Gegen Ende des Beschichtungsvorgangs wird die Mikrowellen-Energie gestoppt, die Zufuhr des Prozessgases wird unterbrochen.

Das wie vorstehend beschrieben hergestellte 2-Schichtsystem (40nm / 100nm) zeigt folgende Eigenschaften: Die beschichteten Spritzen weisen bei 23°C und 50% rel. Luftfeuchtigkeit eine Sauerstoff-Permeation von 0,0004 $cm^3$ / (Pckg d 0,21bar) auf, während unbeschichtete Spritzen eine Sauerstoff-Permeation von 0,0074 $cm^3$ / (Pckg d 0,21bar) besitzen, so dass die Barriere-Verbesserung für Sauerstoff bei einem Faktor 20 liegt.

Messungen der Wasserdampf-Permeation bei 38°C, 90% relative Feuchtigkeit ergeben, daß die beschichteten Spritzen eine Wasserdampf-Permeation von 0,05 mg/(Pckg. d) aufweisen, während unbeschichtete Spritzen eine Wasserdampf-Permeation von 0,11 mg/(Pckg. d) besitzen, so dass die Barriere-Verbesserung für Wasserdampf bei einem Faktor 2 liegt.

ii) Schichtsystem II, 6-Schicht-Multilayer (40nm / 100nm / 40nm / 100nm / 40nm / 100nm):

Analog wie beim Schichtsystem I werden die Schichten aufgebracht, jedoch werden die Schritte 1) und 2) noch zweimal wiederholt, so dass ingesamt ein Wechselschichtsystem aus 3 organischen und 3 anorganischen Schichten aufgebracht wird.

Die beschichteten Spritzen weisen bei 23°C und.50% rel. Luftfeuchtigkeit eine Sauerstoff-Permeation von 0,00011 $cm^3$ / (Pckg d 0,21bar) auf, während unbeschichtete Spritzen eine Sauerstoff-Permeation von 0,0074 $cm^3$ / (Pckg d 0,21bar) besitzen, so dass die Barriere-Verbesserung für Sauerstoff bei einem Faktor 70 liegt. Folglich wird durch die Multilayer-Beschichtung mit 6 Schichten des Schichtsystems II die Sauerstoff-Barriere wesentlich höher verbessert als beim Schichtsystem I, das aus 2 Schichten besteht.

Messungen der Wasserdampf-Permeation bei 38°C, 90% relativer Feuchtigkeit ergeben, daß die beschichteten Spritzen eine Wasserdampf-Permeation von 0,041 mg/(Pckg. d) aufweisen. Demgegenüber zeigen unbeschichtete Spritzen eine Wasserdampf-Permeation von 0,11 mg/(Pckg. d), so dass die Barriere-Verbesserung für Wasserdampf bei einem Faktor 2,7 liegt.

Ausführungsbeispiel 1d: PECVD-Verfahren, Innenbeschichtung mit Durchfluß-Reaktor, niedriger Fluss, höhere Wasserdampfbarriere

Eine Spritze aus COC (Cyclic Olefinic Copolymer), 1 ml Volumen mit einer Zylinderhöhe von 54mm und einem Zylinderinnendurchmesser von 6,5mm, einer Gesamthöhe von 64,5mm und einem Luer-Konus nach DIN 594 mit einer Länge von 10mm und mit einem inneren Öffnungsdurchmesser von 2 mm wird in den in Fig. 1 beschriebenen Reaktor mit dem großen Querschnitt nach unten und dem engen Querschnitt (Luer-Konus) nach oben zugeführt. Dabei liegt die Spritze zunächst auf der Unterseite des Reaktors auf der Dichtfläche auf. Anschließend wird die Oberseite des Reaktors zugefahren und beim Schließen des Reaktors wird die Spritze an der Oberseite vakuumdicht abgedichtet. Der Gegendruck stellt sicher, dass die Spritze auch untenseitig vakuumdicht aufliegt.

Schritt1: Anschließend wird der Innenraum der Spritze evakuiert bis ein Basisdruck < 0,05mbar erreicht wird. Der Außenraum bleibt während des gesamten Behandlungsvorgangs auf Atmosphärendruck. Während untenseitig die Verbindung zum Vakuum beibehalten bleibt, wird das Gaseinlass-Ventil geöffnet und über die Seite mit dem engen Querschnitt, d.h. beim Luer-Konus der Spritze, ein erstes Gasgemisch aus Sauerstoff und Hexamethyldisiloxan mit einem HMDSO-Fluss von 3,4 sccm und einem Sauerstoff-Fluss von 16,6 sccm bei einem Druck von 0,55 mbar eingeleitet. Mittels der Zündvorrichtung wird im Unterraum eine Glimmentladung gezündet, wodurch aber noch keine Schichtabscheidung auf der Spritzen-Innenseite erfolgt. Erst ab dem Zeitpunkt, sobald gepulste Mikrowellen-Energie von der Mikrowellenquelle mit einer Frequenz von 2,45 GHz mit einer mittleren Pulsleistung von 57 Watt über den Wellenleiter in den Reaktorraum eingekoppelt wird, zündet im Innenraum der Spritze ein Plasma, während außenseitig aufgrund des Atmosphärendrucks kein Plasma zündet. Die Spritze wird während des Vorgangs innenseitig mit einer ersten Haftvermittler-Schicht mit einer mittleren Schichtdicke von 40 nm beschichtet. Gegen Ende der ersten Beschichtung wird die Mikrowellen-Energie gestoppt.

Schritt2:

Anschließend folgt eine Gaswechselzeit, in der ein zweites Gasgemisch aus Hexamethyldisiloxan (HMDSO) und Sauerstoff mit einem HMDSO-Fluss von 0,3 sccm und einem Sauerstoff-Fluss von 19,7 sccm bei einem Druck von 0,15 mbar in den Innenraum der Spritze geleitet wird.
Sobald gepulste Mikrowellen-Energie von der Mikrowellenquelle mit einer Frequenz von 2,45 GHz und mit einer mittleren Mikrowellenleistung von 30,8W über den Wellenleiter in den Reaktorraum eingeleitet wird, zündet innen in der Spritze ein Plasma und es wird eine zweite anorganische Barriere-Schicht mit einer mittleren Schichtdicke von 100nm während einer Beschichtungsdauer von 245,4s aufgebracht. Gegen Ende des Beschichtungsvorgangs wird die Mikrowellen-Energie gestoppt, die Zufuhr des Prozessgases wird unterbrochen.

Schritt3:

Ein drittes Gasgemisch aus Sauerstoff und Hexamethyldisiloxan wird mit einem HMDSO-Fluss von 14 sccm und einem Sauerstoff-Fluss von 6 sccm bei einem Druck von 0,55 mbar eingeleitet. Mittels der Zündvorrichtung wird im Unterraum eine Glimmentladung gezündet, wodurch aber noch keine Schichtabscheidung auf der Spritzen-Innenseite erfolgt. Erst ab dem Zeitpunkt, sobald gepulste Mikrowellen-Energie von der Mikrowellenquelle mit einer Frequenz von 2,45 GHz mit einer mittleren Pulsleistung von 57 Watt über den Wellenleiter in den Reaktorraum eingekoppelt wird, zündet im Innenraum der Spritze ein Plasma, während außenseitig aufgrund des Atmosphärendrucks kein Plasma zündet.
Die Spritze wird während des Vorgangs innenseitig mit einer dritten Silizium-organischen Schicht mit einer mittleren Schichtdicke von 100 nm beschichtet. Gegen Ende der ersten Beschichtung wird die Mikrowellen-Energie gestoppt.
Die beschichteten Spritzen weisen bei 23°C und 50% rel. Luftfeuchtigkeit eine Sauerstoff-Permeation von 0,0016 cm$^3$ / (Pckg d 0,21bar) auf, während unbeschichtete Spritzen eine Sauerstoff-Permeation von 0,0074 cm$^3$ / (Pckg d 0,21bar) haben, so dass die Barriere-Verbesserung für Sauerstoff bei einem Faktor 4,8 liegt.
Messungen der Wasserdampf-Permeation bei 38°C, 90% relativer Feuchtigkeit ergeben, daß die beschichteten Spritzen eine Wasserdampf-Permeation von 0,02 mg/(Pckg. d) aufweisen, während unbeschichtete Spritzen eine Wasserdampf-Permeation von 0,11 mg/(Pckg. d) besitzen, so dass die Barriere-Verbesserung für Wasserdampf bei einem Faktor 5,5 liegt.
Als weitere Referenz wurden Spritzen genauso wie in diesem Ausführungsbeispiel beschichtet, jedoch wurde beim Schritt2 die zweite anorganische Barriereschicht bei 40sccm Gesamtfluss unter Beibehaltung der gleichen HMDSO-Konzentration und unter Beibehaltung der Schichtdicke abgeschieden. Bei 38°C, 90% relativer Feuchtigkeit liegt die Wasserdampf-Permeation dieser Schicht bei 0,05mg/(Pckg. d). Somit ist die Wasserdampf-Barriere deutlich schlechter als bei der Barriere-Beschichtung mit dem geringeren Gesamtfluss von 20sccm im zweiten Prozessschritt.

Ausführungsbeispiel 1e: PECVD-Verfahren, Herstellung einer Barriere aus Tetramethyldisiloxan (TMDSO), Haftvermittler und einer dritten Schicht mittels Hexamethyldisiloxan (HMDSO):

Eine Spritze aus COC (Cyclic Olefinic Copolymer), 1 ml Volumen mit einer Zylinderhöhe von 54mm und einem Zylinderinnendurchmesser von 6,5mm, einer Gesamthöhe von 64,5mm und einem Luer-Konus nach DIN 594 mit einer Länge von 10mm und mit einem inneren Öffnungsdurchmesser von 2 mm wird in den in Fig. 1 beschriebenen Reaktor mit dem großen Querschnitt nach unten und dem engen Querschnitt (Luer-Konus) nach oben zugeführt. Dabei liegt die Spritze zunächst auf der Unterseite des Reaktors auf der Dichtfläche auf. Anschließend wird die Oberseite des Reaktors zugefahren und beim Schließen des Reaktors wird die Spritze an der Oberseite vakuumdicht abgedichtet. Der Gegendruck stellt sicher, dass die Spritze auch untenseitig vakuumdicht aufliegt.
Schritt1: Anschließend wird der Innenraum der Spritze evakuiert bis ein Basisdruck < 0,05mbar erreicht wird. Der Außenraum bleibt während des gesamten Behandlungsvorgangs auf Atmosphärendruck. Während untenseitig die Verbindung zum Vakuum beibehalten bleibt, wird das Gaseinlass-Ventil geöffnet und über die Seite mit dem engen Querschnitt, d.h. beim Luer-Konus der Spritze, ein erstes Gasgemisch aus Sauerstoff und Hexamethyldisiloxan mit einem HMDSO-Fluss von 3,4 sccm und einem Sauerstoff-Fluss von 16,6 sccm bei einem Druck von 0,55 mbar eingeleitet. Mittels der Zündvorrichtung wird im Unterraum eine Glimmentladung gezündet, wodurch aber noch keine Schichtabscheidung auf der Spritzen-Innenseite erfolgt. Erst ab dem Zeitpunkt, sobald gepulste Mikrowellen-Energie von der Mikrowellenquelle mit einer Frequenz von 2,45 GHz mit einer mittleren Pulsleistung von 57 Watt über den Wellenleiter in den Reaktorraum eingekoppelt wird, zündet im Innenraum der Spritze ein Plasma, während außenseitig aufgrund des Atmosphärendrucks kein Plasma zündet.

Die Spritze wird während des Vorgangs innenseitig mit einer ersten Haftvermittler-Schicht mit einer mittleren Schichtdicke von 40 nm beschichtet. Gegen Ende der ersten Beschichtung wird die Mikrowellen-Energie gestoppt.

Schritt2:

Anschließend folgt eine Gaswechselzeit, in der ein zweites Gasgemisch aus Tetramethyldisiloxan (TMDSO) und Sauerstoff mit einem TMDSO-Fluss von 0,6 sccm und einem Sauerstoff-Fluss von 39,4 sccm bei einem Druck von 0,15 mbar in den Innenraum der Spritze geleitet wird.

Sobald gepulste Mikrowellen-Energie von der Mikrowellenquelle mit einer Frequenz von 2,45 GHz und mit einer mittleren Mikrowellenleistung von 30,8 W über den Wellenleiter in den Reaktorraum eingeleitet wird, zündet innen in der Spritze ein Plasma und es wird eine zweite anorganische Barriere-Schicht mit einer mittleren Schichtdicke von 100nm während einer Beschichtungsdauer von 133,7s aufgebracht. Gegen Ende des Beschichtungsvorgangs wird die Mikrowellen-Energie gestoppt, die Zufuhr des Prozessgases wird unterbrochen.

Schritt3:

Ein drittes Gasgemisch aus Sauerstoff und Hexamethyldisiloxan mit einem HMDSO-Fluss von 14 sccm und einem Sauerstoff-Fluss von 6 sccm wird bei einem Druck von 0,55 mbar eingeleitet. Mittels der Zündvorrichtung wird im Unterraum eine Glimmentladung gezündet, wodurch aber noch keine Schichtabscheidung auf der Spritzen-Innenseite erfolgt. Erst ab dem Zeitpunkt, sobald gepulste Mikrowellen-Energie von der Mikrowellenquelle mit einer Frequenz von 2,45 GHz mit einer mittleren Pulsleistung von 57 Watt über den Wellenleiter in den Reaktorraum eingekoppelt wird, zündet im Innenraum der Spritze ein Plasma, während außenseitig aufgrund des Atmosphärendrucks kein Plasma zündet. Die Spritze wird, während des Vorgangs innenseitig mit einer dritten Silizium-organischen mit einer mittleren Schichtdicke von 100 nm beschichtet. Gegen Ende der ersten Beschichtung wird die Mikrowellen-Energie gestoppt.

Die beschichteten Spritzen weisen bei 23°C und 50% rel. Luftfeuchtigkeit eine Sauerstoff-Permeation von 0,0017 cm$^3$ / (Pckg d 0,21bar) auf, während unbeschichtete Spritzen eine Sauerstoff-Permeation von 0,0074 cm$^3$ / (Pckg d 0,21bar) haben, so dass die Barriere-Verbesserung für Sauerstoff bei einem Faktor von 4,5 liegt.

Die beschichteten Spritzen weisen bei 38°C, 90% relativer Feuchtigkeit eine Wasserdampf-Permeation von 0,03 mg/(Pckg. d) auf, während unbeschichtete Spritzen eine Wasserdampf-Permeation von 0,11 mg/(Pckg. d) besitzen, so dass die Barriere-Verbesserung für Wasserdampf bei einem Faktor von 3,4 liegt.

Ausführungsbeispiel 1f: PECVD-Verfahren, Herstellung aller Schichten aus Tetramethyldisiloxan (TMDSO), Barriere-Prozess mit kürzerer Prozesszeit:

Eine Spritze aus COC (Cyclic Olefinic Copolymer), 1 ml Volumen mit einer Zylinderhöhe von 54mm und einem Zylinderinnendurchmesser von 6,5mm, einer Gesamthöhe von 64,5mm und einem Luer-Konus nach DIN 594 mit einer Länge von 10mm und mit einem inneren Öffnungsdurchmesser von 2 mm wird in den in Fig. 1 beschriebenen Reaktor mit dem großen Querschnitt nach unten und dem engen Querschnitt (Luer-Konus) nach oben zugeführt. Dabei liegt die Spritze zunächst auf der Unterseite des Reaktors auf der Dichtfläche auf. Anschließend wird die Oberseite des Reaktors zugefahren und beim Schließen des Reaktors wird die Spritze an der Oberseite vakuumdicht abgedichtet. Der Gegendruck stellt sicher, dass die Spritze auch untenseitig vakuumdicht aufliegt.

Schritt1: Anschließend wird der Innenraum der Spritze evakuiert bis ein Basisdruck < 0,05mbar erreicht wird. Der Außenraum bleibt während des gesamten Behandlungsvorgangs auf Atmosphärendruck. Während untenseitig die Verbindung zum Vakuum beibehalten bleibt, wird das Gaseinlass-Ventil geöffnet und über die Seite mit dem engen Querschnitt, d.h. beim Luer-Konus der Spritze, ein erstes Gasgemisch aus Sauerstoff und Tetramethyldisiloxan mit einem TMDSO-Fluss von 3,4 sccm und einem Sauerstoff-Fluss von 16,6 sccm bei einem Druck von 0,55 mbar eingeleitet. Mittels der Zündvorrichtung wird im Unterraum eine Glimmentladung gezündet, wodurch aber noch keine Schichtabscheidung auf der Spritzen-Innenseite erfolgt. Erst ab dem Zeitpunkt, sobald gepulste Mikrowellen-Energie von der Mikrowellenquelle mit einer Frequenz von 2,45 GHz mit einer mittleren Pulsleistung von 57 Watt über den Wellenleiter in den Reaktorraum eingekoppelt wird, zündet im Innenraum der Spritze ein Plasma, während außenseitig aufgrund des Atmosphärendrucks kein Plasma zündet.

Die Spritze wird während des Vorgangs innenseitig mit einer ersten Haftvermittler-Schicht mit einer mittleren Schichtdicke von 40 nm innerhalb einer Beschichtungszeit von 0,8s beschichtet. Gegen Ende der ersten Beschichtung wird die Mikrowellen-Energie gestoppt.

Schritt2:

Anschließend folgt eine Gaswechselzeit, in der ein zweites Gasgemisch aus Tetramethyldisiloxan (TMDSO) und Sauerstoff mit einem TMDSO-Fluss von 1,6 sccm und einem Sauerstoff-Fluss von 78,4 sccm bei einem Druck von 0,15 mbar in den Innenraum der Spritze geleitet wird.

Sobald gepulste Mikrowellen-Energie von der Mikrowellenquelle mit einer Frequenz von 2,45 GHz und mit einer mittleren Mikrowellenleistung von 59,3 W über den Wellenleiter in den Reaktorraum eingeleitet wird, zündet innen in der Spritze ein Plasma und es wird eine zweite anorganische Barriere-Schicht mit einer mittleren Schichtdicke von 100nm während einer Beschichtungsdauer von 36,7s aufgebracht. Gegen Ende des Beschichtungsvorgangs wird die Mikrowellen-Energie gestoppt, die Zufuhr des Prozessgases wird unterbrochen.

Schritt3:

Ein drittes Gasgemisch aus Sauerstoff und Tetramethyldisiloxan wird mit einem TMDSO-Fluss von 14 sccm und einem Sauerstoff-Fluss von 6 sccm bei einem Druck von 0,55 mbar eingeleitet. Mittels der Zündvorrichtung wird im Unterraum eine Glimmentladung gezündet, wodurch aber noch keine Schichtabscheidung auf der Spritzen-Innenseite erfolgt. Erst ab dem Zeitpunkt, sobald gepulste Mikrowellen-Energie von der Mikrowellenquelle mit einer Frequenz von 2,45 GHz mit einer mittleren Pulsleistung von 57 Watt über den Wellenleiter in den Reaktorraum eingekoppelt wird, zündet im Innenraum der Spritze ein Plasma, während außenseitig aufgrund des Atmosphärendrucks kein Plasma zündet.

Die Spritze wird während des Vorgangs innenseitig mit einer dritten Silizium-organischen mit einer mittleren Schichtdicke von 100 nm beschichtet. Gegen Ende der ersten Beschichtung wird die Mikrowellen-Energie gestoppt.

Die beschichteten Spritzen weisen bei 23°C und 50% rel. Luftfeuchtigkeit eine Sauerstoff-Permeation von 0,0015 cm$^3$ / (Pckg d 0,21bar) auf, während unbeschichtete Spritzen eine Sauerstoff-Permeation von 0,0074 cm$^3$ / (Pckg d 0,21bar) besitzen, so dass die Barriere-Verbesserung für Sauerstoff bei einem Faktor >5 liegt.

Ausführungsbeispiel 2: Durchfluss-Reaktor, Innenbeschichtung bei geringer mittlerer Leistung

Analog zu Beispiel 1 wird eine Spritze innen im Durchfluss-Reaktor beschichtet. Dabei wird die gleiche Haftvermittler-Schicht aufgebracht. Dagegen wird aber anschließend eine zweite Barriere-Schicht bei sehr geringer mittlerer Mikrowellen-Leistung abgeschieden:

Nach Aufbringen der 40nm dicken Haftvermittler-Schicht wird in einer Gaswechselzeit ein zweites Gasgemisch aus Hexamethyldisiloxan und Sauerstoff mit einem HMDSO-Fluss von 0,2 sccm und einem Sauerstoff-Fluss von 9,8 sccm bei einem Druck von 0,15 mbar in den Innenraum der Spritze geleitet.

Sobald gepulste Mikrowellen-Energie von der Mikrowellenquelle mit einer Frequenz von 2,45 GHz mit einer mittleren Mikrowellenleistung von 15,7W über den Wellenleiter in den Reaktorraum eingeleitet wird, zündet innen in der Spritze ein Plasma und es wird eine zweite anorganische Barriere-Schicht für eine zweite Beschichtungsdauer von 138,9s und mit einer mittleren Schichtdicke von 60 nm aufgebracht. Gegen Ende des Beschichtungsvorgangs wird die Mikrowellen-Energie gestoppt, die Zufuhr des Prozessgases unterbrochen und der Innenraum der Spritze auf Atmosphärendruck geflutet.

Die beschichteten Spritzen weisen bei 23°C und 50% rel. Luftfeuchtigkeit eine Sauerstoff-Permeation von 0,0020 cm$^3$ / (Pckg d 0,21bar) auf, während unbeschichtete Spritzen eine Sauerstoff-Permeation von 0,0074 cm$^3$/ (Pckg d 0,21 bar) besitzen, so dass die Barriere-Verbesserung für Sauerstoff besser als Faktor 3,5 ist.

Ausführungsbeispiel 3: Durchfluss-Reaktor, Barriere-Beschichtung einer Glasspritze

Eine Spritze aus Fiolax-Glas, 1 ml Volumen, wird.in den in Fig. 2 beschriebenen Reaktor mit dem großen Querschnitt nach oben und dem engen Querschnitt (Luer-Konus) nach unten eingebracht. Dabei liegt die Spritze zunächst auf der Unterseite des Reaktors auf der Dichtfläche auf. Anschließend wird die Oberseite des Reaktors zugefahren und beim Schließen des Reaktors wird die Spritze an der Oberseite vakuumdicht abgedichtet. Der Gegendruck stellt sicher, dass die Spritze auch untenseitig vakuumdicht aufliegt. Anschließend wird der Innenraum der Spritze evakuiert bis ein Basisdruck < 0,05 mbar erreicht wird. Der Außenbereich um den Spritzenkörper innerhalb des Reaktorraumes bleibt während des gesamten Behandlungsvorgangs auf Atmosphärendruck.

Während untenseitig die Verbindung zum Vakuum beibehalten bleibt wird das Gaseinlass-Ventil geöffnet und von unten über die Seite mit dem engen Querschnitt, d.h. beim Luer-Konus der Spritze, ein erstes Gas aus Sauerstoff bei einem Sauerstoff-Fluss von 40 sccm bei einem Druck von 2,5 mbar eingeleitet. In diesem Durchfluss-Betrieb stellt sich ein kontinuierlicher Gasfluss ein, bei dem das Gas parallel zur Symmetrieachse vom engen Querschnitt bis zum weiten Querschnitt strömt.

Mittels der Zündvorrichtung wird im Unterraum eine Glimmentladung gezündet, wodurch aber noch keine Plasmabehandlung auf der Spritzen-Innenseite erfolgt. Erst ab dem Zeitpunkt, sobald gepulste Mikrowellen-Energie von der Mikrowellenquelle mit einer Frequenz von 2,45 GHz mit einer mittleren Pulsleistung von 167 Watt über den Wellenleiter in den Reaktorraum eingekoppelt wird, zündet im Innenraum der Spritze ein Plasma während außenseitig aufgrund des Atmosphärendrucks kein Plasma zündet. Die Spritze wird während des Vorgangs innenseitig während einer Behandlungsdauer von 19 s auf einer Temperatur von 250°C aufgeheizt.

Gegen Ende des Aufheizvorgangs wird die Mikrowellen-Energie gestoppt. Anschließend folgt eine Gaswechselzeit, in der ein zweites Gasgemisch aus Hexamethyldisiloxan und Sauerstoff mit einem HMDSO-Fluss von 1,2 sccm und einem Sauerstoff-Fluss von 40 sccm bei einem Druck von 2,5 mbar in den Innenraum der Spritze geleitet wird. Vor Beginn der Beschichtung hat die Spritze eine Temperatur von 205°C. Sobald gepulste Mikrowellen-Energie von der Mikrowellenquelle mit einer Frequenz von 2,45 GHz mit einer mittleren Mikrowellenleistung von 167W über den Wellenleiter in den Reaktorraum eingeleitet wird, zündet innen in der Spritze ein Plasma und es wird eine anorganische Barriere-Schicht für eine Beschichtungsdauer von 13s und mit einer mittleren Schichtdicke von 100 nm aufgebracht. Gegen Ende des Beschichtungsvorgangs wird die Mikrowellen-Energie gestoppt und die Zufuhr des Prozessgases unterbrochen. Gegen Ende des Prozesses wird der Innenraum der Spritze auf Atmosphärendruck geflutet.

Die beschichteten Spritzen werden mit 0,1 mol HCl befüllt und bei 121°C für 6 Stunden autoklaviert. Nach dem Autoklavieren wird die Natrium-Auslaugung gemessen. Im Vergleich zu unbeschichteten Glasspritzen ist die Natrium-Auslaugung deutlich reduziert und liegt unterhalb von 0,3 ppm.

Ausführungsbeispiel 4a: Umkehrströmungs-Reaktor, Spritzenbeschichtung

Ein Spritzenkörper aus COC (Cyclic Olefinic Copolymer), 1 ml Volumen, mit einer Zylinderhöhe von 54mm und einem Zylinderinnendurchmesser von 6,5mm, einer Gesamthöhe von 64,5mm und einem Luer-Konus nach DIN 594 mit einer Länge von 10mm und mit einem inneren Öffnungsdurchmesser von 2 mm wird in den in Fig. 10a beschriebenen Reaktor mit dem großen Querschnitt nach unten und dem engen Querschnitt (Luer-Konus) nach oben zugeführt. Dabei liegt die Spritze zunächst auf der Unterseite des Reaktors auf der Dichtfläche auf und in die Spritze ragt eine Gaszuführung (Versorgungskanüle) bestehend aus Edelstahl, mit einem Außendurchmesser von 2 mm, einem Innendurchmesser von 1,5 mm herein und einer Eintauchtiefe von 34,5 mm. Die Spritzen wird auf der Seite mit dem engen Querschnitt (Luer-Konus) mit Dichtmaterial vakuumdicht verschlossen. Anschließend wird die Oberseite des Reaktors zugefahren und durch einen mechanischen Gegendruck sichergestellt, dass die Spritze untenseitig vakuumdicht aufliegt. Anschließend wird der Innenraum der Spritze evakuiert bis ein Basisdruck < 0,05 mbar erreicht wird. Der Außenraum bleibt während des gesamten Behandlungsvorgangs auf Atmosphärendruck. Während untenseitig die Verbindung zum Vakuum beibehalten bleibt, wird das Gaseinlass-Ventil geöffnet und über die Gaszuführung ein erstes Gasgemisch aus Sauerstoff und Hexamethyldisiloxan mit einem HMDSO-Fluss von 3,4 sccm und einem Sauerstoff-Fluss von 16,6 sccm bei einem Druck von 0,4 mbar eingeleitet. Es stellt sich dabei ein kontinuierlicher Fluss ein. Mittels der Zündvorrichtung wird im Unterraum eine Glimmentladung gezündet, wodurch aber noch keine Schichtabscheidung auf der Spritzen-Innenseite erfolgt. Erst ab dem Zeitpunkt, sobald gepulste Mikrowellen-Energie von der Mikrowellenquelle mit einer Frequenz von 2,45 GHz mit einer Pulsleistung von 57W über den Wellenleiter in den Reaktorraum eingekoppelt wird, zündet im Innenraum der Spritze ein Plasma während außenseitig aufgrund des Atmosphärendrucks kein Plasma zündet. Die Spritze wird während des Vorgangs innenseitig mit einer ersten Haftvermittler-Schicht für eine erste Beschichtungsdauer von 1,2s und mit einer Dicke von 40 nm beschichtet. Gegen Ende der ersten Beschichtung wird die Mikrowellen-Energie gestoppt. Anschließend folgt eine Gaswechselzeit, in der ein zweites Gasgemisch aus Hexamethyldisiloxan und Sauerstoff mit einem HMDSO-Fluss von 0,44 sccm und einem Sauerstoff-Fluss von 39,6 sccm bei einem Druck von 0,4 mbar in den Innenraum der Spritze geleitet wird. Sobald gepulste Mikrowellen-Energie von der Mikrowellenquelle mit einer Frequenz von 2,45 GHz mit einer mittleren Mikrowellenleistung von 84,9W über den Wellenleiter in den Reaktorraum eingeleitet wird, zündet innen in der Spritze ein Plasma und es wird für eine zweite Beschichtungsdauer von 15,3 s und mit einer mittleren Dicke von 20 nm eine zweite anorganische Barriere-Schicht aufgebracht. Gegen Ende des Beschichtungsvorgangs wird die Mikrowellen-Energie gestoppt, die Zufuhr des Prozessgases wird unterbrochen. Nachfolgend wird das Substrat in einer Abkühlpause abgekühlt und anschließend wird nach Evakuieren der Beschichtungsvorgang für die Barriere-Schicht drei mal wiederholt, wobei gleiche Prozessparameter verwendet und gleich dicke Barriereschichten wie in Schritt2 abgeschieden werden. Die gesamte Barriere-Dicke der 3 hintereinander aufgebrachten Barriere-Schichten beträgt 60nm. Gegen Ende des Prozesses wird der Innenraum der Spritze auf Atmosphärendruck geflutet.

Die beschichteten Spritzen weisen bei 23°C und 50% rel. Luftfeuchtigkeit eine Sauerstoff-Permeation von 0,0033 cm$^3$ / (Pckg d 0,21bar) auf, während unbeschichtete Spritzen eine Sauerstoff-Permeation von 0,0074 cm$^3$ / (Pckg d 0,21bar) besitzen. Der Barriere-Verbesserungsfaktor für Sauerstoff ist somit besser als Faktor 2,5.

Ausführungsbeispiel 4b: Umkehrströmungs-Reaktor, Spritzenbeschichtung

Ein Spritzenkörper aus COC (Cyclic Olefinic Copolymer), 1 ml Volumen, mit einer Zylinderhöhe von 54mm und einem Zylinderinnendurchmesser von 6,5mm, einer Gesamthöhe von 64,5mm und einem Luer-Konus nach DIN 594 mit einer Länge von 10mm und mit einem inneren Öffnungsdurchmesser von 2 mm wird in den in Fig. 10a beschriebenen Reaktor mit dem großen Querschnitt nach unten und dem engen Querschnitt (Luer-Konus) nach oben zugeführt. Dabei liegt die Spritze zunächst auf der Unterseite des Reaktors auf der Dichtfläche auf und in die Spritze ragt eine Gaszuführung (Versorgungskanüle) bestehend aus Keramik, mit einem Außendurchmesser von 2 mm, einem Innendurchmesser von 1,5 mm mit einer Eintauchtiefe von 17,5 mm herein. Die Spritzen wird auf der Seite mit dem engen Querschnitt (Luer-Konus) mit Dichtmaterial vakuumdicht verschlossen. Anschließend wird die Oberseite des Reaktors zugefahren und durch einen mechanischen Gegendruck sichergestellt, dass die Spritze untenseitig vakuumdicht aufliegt. Anschließend wird der Innenraum der Spritze evakuiert bis ein Basisdruck < 0,05 mbar erreicht wird. Der Außenraum bleibt während des gesamten Behandlungsvorgangs auf Atmosphärendruck. Während untenseitig die Verbindung zum Vakuum beibehalten bleibt, wird das Gaseinlass-Ventil geöffnet,und über die Gaszuführung ein erstes Gasgemisch aus Sauerstoff und Hexamethyldisiloxan mit einem HMDSO-Fluss von 3,4 sccm und einem Sauerstoff-Fluss von 16,6 sccm bei einem Druck von 0,4 mbar eingeleitet. Es stellt sich dabei ein kontinuierlicher Fluss ein. Mittels der Zündvorrichtung wird im Unterraum eine Glimmentladung gezündet, wodurch aber noch keine Schichtabscheidung auf der Spritzen-Innenseite erfolgt. Erst ab dem Zeitpunkt, sobald gepulste Mikrowellen-Energie von der Mikrowellenquelle mit einer Frequenz von 2,45 GHz mit einer Pulsleistung von 57W über den Wellenleiter in den Reaktorraum eingekoppelt wird, zündet im Innenraum der Spritze ein Plasma während außenseitig aufgrund des Atmosphärendrucks kein Plasma zündet. Die Spritze wird während des Vorgangs innenseitig mit einer ersten Haftvermittler-Schicht für eine erste Beschichtungsdauer von 2,1s und mit einer Dicke von 40 nm beschichtet. Gegen Ende der ersten Beschichtung wird die Mikrowellen-Energie gestoppt. Anschließend folgt eine Gaswechselzeit, in der ein zweites Gasgemisch aus Hexamethyldisiloxan und Sauerstoff mit einem HMDSO-Fluss von 0,38 sccm und einem Sauerstoff-Fluss von 24,6 sccm bei einem Druck von 0,4 mbar in den Innenraum der Spritze geleitet wird. Sobald gepulste Mikrowellen-Energie von der Mikrowellenquelle mit einer Frequenz von 2,45 GHz mit einer mittleren Mikrowellenleistung von 214W über den Wellenleiter in den Reaktorraum eingeleitet wird, zündet innen in der Spritze ein Plasma und es wird für eine zweite Beschichtungsdauer von 3s und mit einer mittleren Dicke von 6,4 nm eine zweite anorganische Barriere-Schicht aufgebracht. Gegen Ende des Beschichtungsvorgangs wird die Mikrowellen-Energie gestoppt, die Zufuhr des Prozessgases wird unterbrochen. Nachfolgend wird das Substrat in einer Abkühlpause abgekühlt und anschließend wird nach Evakuieren der Beschichtungsvorgang für die Barriere-Schicht zehn mal wiederholt, wobei gleiche Prozessparameter verwendet und gleich dicke Barriereschichten wie in Schritt2 abgeschieden werden. Die gesamte Barriere-Dicke der 11 hintereinander aufgebrachten Barriere-Schichten beträgt 70nm. Gegen Ende des Prozesses wird der Innenraum der Spritze auf Atmosphärendruck geflutet.

Die beschichteten Spritzen weisen bei 23°C und 50% rel. Luftfeuchtigkeit eine Sauerstoff-Permeation von 0,0012 cm3 / (Pckg d 0,21bar) auf, während unbeschichtete Spritzen eine Sauerstoff-Permeation von 0,0074 cm3 / (Pckg d 0,21bar) besitzen. Der Barriere-Verbesserungsfaktor für Sauerstoff ist somit besser als Faktor 6.

Ausführungsbeispiel 5: Umkehrströmungs-Reaktor, Beschichtung von Vials

Ein Vial aus COC (Cyclic Olefinic Copolymer), 12 ml Volumen, wird in den in Fig. 10a beschriebenen Reaktor eingesetzt. Dabei liegt das Vial zunächst auf der Unterseite des Reaktors auf der Dichtfläche auf und in das Vial ragt eine Gaszuführung aus Metall herein. Anschließend wird die Oberseite des Reaktors zugefahren und der Innenraum des Vials evakuiert bis ein Basisdruck < 0,05 mbar erreicht wird. Der das Vial umgebende Außenbereich der Reaktorkammer bleibt während des gesamten Behandlungsvorgangs auf Atmosphärendruck.

Während untenseitig die Verbindung zum Vakuum beibehalten bleibt, wird das Gaseinlass-Ventil geöffnet und über die Gaszuführung ein erstes Gasgemisch aus Sauerstoff und Hexamethyldisiloxan mit einem HMDSO-Fluss von 4,25 sccm und einem Sauerstoff-Fluss von 20,75 sccm bei einem Druck von 0,4 mbar eingeleitet. Es stellt sich dabei ein kontinuierlicher Fluss ein, bei dem das Gas axial-symmetrisch verteilt ist. Mittels der Zündvorrichtung wird im Vorraum eine Glimmentladung gezündet, wodurch aber noch keine Schichtabscheidung auf der Spritzen-Innenseite erfolgt. Erst ab dem Zeitpunkt, sobald gepulste Mikrowellen-Energie von der Mikrowellenquelle mit einer Frequenz von 2,45 GHz mit mittleren Mikrowellenleistung von 57W über den Wellenleiter in den Reaktorraum eingekoppelt wird, zündet im Innenraum des Vials ein Plasma während außenseitig aufgrund des Atmosphärendrucks kein Plasma zündet.

Das Vial wird während des Vorgangs innenseitig mit einer ersten Haftvermittler-Schicht für eine erste Beschichtungsdauer von 0,4 s und mit einer Dicke von 20 nm beschichtet. Gegen Ende der ersten Beschichtung wird die Mikrowellen-Energie gestoppt. Anschließend folgt eine Gaswechselzeit, in der ein zweites Gasgemisch aus Hexamethyldisiloxan und Sauerstoff mit einem HMDSO-Fluss von 0,75sccm und einem Sauerstoff-Fluss von 50 sccm bei einem Druck von 0,4 mbar in den Innenraum des Vials geleitet wird.

Sobald gepulste Mikrowellen-Energie von der Mikrowellenquelle mit einer Frequenz von 2,45 GHz mit einer mittleren Mikrowellenleistung von 214 W über den Wellenleiter in den Reaktorraum eingeleitet wird, zündet innen im Vial ein Plasma und es wird für eine zweite Beschichtungsdauer von 34s und mit einer Schichtdicke von 100 nm eine zweite anorganische Barriere-Schicht aufgebracht. Gegen Ende des Beschichtungsvorgangs wird die Mikrowellen-Energie gestoppt, die Zufuhr des Prozessgases wird unterbrochen und der Innenraum der Spritze wird bis Atmosphärendruck geflutet.

Die beschichteten Vials weisen bei 23°C und 50% rel. Luftfeuchtigkeit eine Sauerstoff-Permeation kleiner als 0,001 cm$^3$ / (Pckg d 0,21 bar) auf, während unbeschichtete Vials eine Sauerstoff-Permeation von 0,0283 cm$^3$ / (Pckg d 0,21 bar) besitzen. Die Auflösungsgrenze des Permeationsmessgeräts wird erreicht, so dass die erzielte Barriere-Verbesserung für Sauerstoff besser als ein Faktor 28 ist.

Die beschichteten Vials weisen bei 38°C, 90% relativer Feuchtigkeit eine Wasserdampf-Permeation von 0,16 mg / (Pckg d) auf, während unbeschichtete Vials eine Wasserdampf-Permeation von 0,3 mg /·(Pckg d) besitzen. Die erzielte Barriere-Verbesserung für Wasserdampf liegt bei einem Faktor 1,9.

Lagerbeständigkeit:

Bei einem Lagertest werden die Vials mit i) destilliertem Wasser und ii) 0,1 molarer Salzsäure befüllt und 1 Woche lang bei 60 °C gelagert. Nach Entleeren und Trocknen wird erneut die Sauerstoff-Permeation bei 23°C und 50% rel. Luftfeuchtigkeit gemessen. Nach dem Lagertest liegt in beiden Fällen i) und ii) die Sauerstoff-Permeation immer noch an der Auflösungsgrenze von 0,001 cm3 / (Pckg d 0,21 bar). Somit bleibt eine Sauerstoff-Barriere-Verbesserung von einem Faktor größer als 28 erhalten.

Ausführungsbeispiel 6: Innenbeschichtung Spritze mit Barriere-Schicht, Außenbeschichtung mit Kratzschutzschicht

a) Eine COC-Spritze, 1 ml Volumen wird in einem Reaktor entsprechend Fig. 7 beschichtet. Dabei wird die Spritze zunächst unter Verwendung des "Vakuum 1" und der Zuführung von Prozeßgas über "Gas 1" innenseitig gemäß Ausführungsbeispiel 1 mit einer Haftvermittler- und einer Barriere-Schicht beschichtet. Nach Fluten des Innenraums der Spritze auf Atmosphärendruck wird über "Vakuum 2" der Reaktor-Außenraum auf einen Basisdruck < 0,05 mbar evakuiert. Anschließend wird ein Gemisch aus Hexamethyldisiloxan und Sauerstoff über die Gasverteilervorrichtung "Gas 2" in den Außenraum zugeführt und dabei der kontinuierliche Gasstrom über "Vakuum 2" aufrecht erhalten. Anschließend wird mit der Mikrowellen-Quelle gepulste Mikrowellen-Energie mit einer Frequenz von 2,45 GHz in den Reaktorraum eingekoppelt und es wird nur im Außenraum ein Plasma gezündet. Auf der Außenwand des Substrats wird eine 100nm dicke Kratzschutzschicht aufgebracht.

b) Ein COC-Vial, 12 ml Volumen wird in einem Reaktor entsprechend Fig. 10b beschichtet. Dabei wird das Vial zunächst unter Verwendung des "Vakuum 1" und Zuführung von Prozeß über "Gas 1" innenseitig gemäß Ausführungsbeispiel 4 mit einer Haftvermittler- und einer Barriere-Schicht beschichtet. Nach Fluten des Innenraums der Spritze auf Atmosphärendruck wird über "Vakuum 2" der Reaktor-Außenraum auf einen Basisdruck < 0,05 mbar evakuiert. Anschließend wird ein Gemisch aus Hexamethyldisiloxan und Sauerstoff über die Gasverteilervorrichtung "Gas 2" in den Außenraum zugeführt und dabei der kontinuierliche Gasstrom über "Vakuum 2" aufrecht erhalten.

Anschließend wird mit der Mikrowellen-Quelle gepulste Mikrowellen-Energie mit einer Frequenz von 2,45 GHz in den Reaktorraum eingekoppelt und es wird nur im Außenraum ein Plasma gezündet. Auf der Außenwand des Substrats wird eine 100 nm dicke Kratzschutzschicht aufgebracht.

Ausführungsbeispiel 7a: Barriere-Schicht aus amorphem Kohlenstoff auf Silizium-organischer Haftschicht, abgeschieden auf einer COC-Spritze

Eine Spritze aus COC (Cyclic Olefinic Copolymer), 1 ml Volumen, mit einer Zylinderhöhe von 54mm und einem Zylinderinnendurchmesser von 6,5mm, einer Gesamthöhe von 64,5mm und einem Luer-Konus nach DIN 594 mit einer Länge von 10mm und mit einem inneren Öffnungsdurchmesser von 2 mm wird in den in Fig. 1 beschriebenen Reaktor mit dem großen Querschnitt nach unten und dem engen Querschnitt (Luer-Konus) nach oben zugeführt. Dabei liegt die Spritze zunächst auf der Unterseite des Reaktors auf der Dichtfläche auf. Anschließend wird die Oberseite des Reaktors zugefahren und beim Schließen des Reaktors wird die Spritze an der Oberseite vakuumdicht abgedichtet. Der Gegendruck stellt sicher, dass die Spritze auch untenseitig vakuumdicht aufliegt. Anschließend wird der Innenraum der Spritze evakuiert bis ein Basisdruck < 0,05 mbar erreicht wird. Der Außenraum bleibt während des gesamten Behandlungsvorgangs auf Atmosphärendruck.

Schrittl: Während untenseitig die Verbindung zum Vakuum beibehalten bleibt, wird das Gaseinlass-Ventil geöffnet und über die Seite mit dem engen Querschnitt, d.h. beim Luer-Konus der Spritze, ein ein erstes Gasgemisch aus Sauerstoff und Hexamethyldisiloxan mit einem HMDSO-Fluss von 3,4 sccm und einem Sauerstoff-Fluss von 16,6 sccm bei einem Druck von 0,55 mbar eingeleitet. Mittels der Zündvorrichtung wird im Unterraum eine Glimmentladung gezündet, wodurch aber noch keine Schichtabscheidung auf der Spritzen-Innenseite erfolgt. Erst ab dem Zeitpunkt, sobald gepulste Mikrowellen-Energie von der Mikrowellenquelle mit einer Frequenz von 2,45 GHz mit einer mittleren Pulsleistung von 57 Watt über den Wellenleiter in den Reaktorraum eingekoppelt wird, zündet im Innenraum der Spritze ein Plasma, während außenseitig aufgrund des Atmosphärendrucks kein Plasma zündet.

Die Spritze wird, während des Vorgangs innenseitig mit einer ersten Silizium-organischen Haftvermittler-Schicht mit einer mittleren Schichtdicke von 40 nm beschichtet. Gegen Ende der ersten Beschichtung wird die Mikrowellen-Energie gestoppt.

Schritt2: Als nächstes wird während einer Gaswechselzeit Acetylen-Gas bei einem Druck von 0,2 mbar und mit einem Fluss von 40 sccm eingeleitet. Mittels der Zündvorrichtung wird im Unterraum eine Glimmentladung gezündet, wodurch aber noch keine Schichtabscheidung auf der Spritzen-Innenseite erfolgt. Erst ab dem Zeitpunkt, sobald gepulste Mikrowellen-Energie von der Mikrowellenquelle mit einer Frequenz von 2,45 GHz mit einer mittleren Mikrowellen-Leistung von 30,8 W über den Wellenleiter in den Reaktorraum eingekoppelt wird, zündet im Innenraum der Spritze ein Plasma während außenseitig aufgrund des Atmosphärendrucks kein Plasma zündet. Die Spritze wird während des Vorgangs innenseitig mit einer Barriere-Schicht aus amorphem Kohlenstoff für eine Beschichtungsdauer von 10s beschichtet. Gegen Ende des Beschichtungsvorgangs wird die Mikrowellen-Energie gestoppt, die Zufuhr des Prozessgases wird unterbrochen und der Innenraum der Spritze wird bis Atmosphärendruck geflutet.

Gegenüber der unbeschichteten Substrat wird eine Barriere-Verbesserung für Sauerstoff erreicht:

Die beschichteten Spritzen weisen bei 23°C und 50% rel. Luftfeuchtigkeit eine Sauerstoff-Permeation von 0,007 $cm^3$ / (Pckg d 0,21bar) auf, während unbeschichtete Spritzen eine Sauerstoff-Permeation von 0,008 $cm^3$ / (Pckg d 0,21bar) besitzen. Der Barriere-Verbesserungsfaktor für Sauerstoff liegt bei einem Faktor 1,2.

Ausführungsbeispiel 7b: Barriere-Schicht aus amorphem Kohlenstoff auf Silizium-organischer Haftschicht, abgeschieden auf COC-Vials:

Ein Vial aus COC (Cyclic Olefinic Copolymer), 12 ml Volumen, wird in den in Fig. 10a beschriebenen Reaktor eingesetzt. Dabei liegt das Vial zunächst auf der Unterseite des Reaktors auf der Dichtfläche auf und in das Vial ragt eine Gaszuführung aus Metall herein. Anschließend wird die Oberseite des Reaktors zugefahren und der Innenraum des Vials evakuiert bis ein Basisdruck < 0,05 mbar erreicht wird. Der das Vial umgebende Außenbereich der Reaktorkammer bleibt während des gesamten Behandlungsvorgangs auf Atmosphärendruck.

Schritt1: Während untenseitig die Verbindung zum Vakuum beibehalten bleibt, wird das Gaseinlass-Ventil geöffnet und über die Gaszuführung ein erstes Gasgemisch aus Sauerstoff und Hexamethyldisiloxan mit einem HMDSO-Fluss von 4,25 sccm und einem Sauerstoff-Fluss von 20,75 sccm bei einem Druck von 0,4 mbar eingeleitet. Mittels der Zündvorrichtung wird im Vorraum eine Glimmentladung gezündet, wodurch aber noch keine Schichtabscheidung auf der Spritzen-Innenseite erfolgt. Erst ab dem Zeitpunkt, sobald gepulste Mikrowellen-Energie von der Mikrowellenquelle mit einer Frequenz von 2,45 GHz mit einer mittleren Mikrowellenleistung von 57W über den Wellenleiter in den Reaktorraum eingekoppelt wird, zündet im Innenraum des Vials ein Plasma während außenseitig aufgrund des Atmosphärendrucks kein Plasma zündet.

Das Vial wird während des Vorgangs innenseitig mit einer ersten Haftvermittler-Schicht für eine erste Beschichtungsdauer von 0,5s und mit einer Dicke von 20 nm beschichtet. Gegen Ende der ersten Beschichtung wird die Mikrowellen-Energie gestoppt.

Schritt2: Als nächstes wird während einer Gaswechselzeit Acetylen-Gas bei einem Druck von 0,2 mbar und mit einem Fluss von 80 sccm eingeleitet. Mittels der Zündvorrichtung wird im Unterraum eine Glimmentladung gezündet, wodurch aber noch keine Schichtabscheidung auf der Spritzen-Innenseite erfolgt. Erst ab dem Zeitpunkt, sobald gepulste Mikrowellen-Energie von der Mikrowellenquelle mit einer Frequenz von 2,45 GHz mit einer mittleren Mikrowellenleistung von 72,7 W über den Wellenleiter in den Reaktorraum eingekoppelt wird, zündet im Innenraum der Spritze ein Plasma während außenseitig aufgrund des Atmosphärendrucks kein Plasma zündet. Die Spritze wird während des Vorgangs innenseitig mit einer Barriere-Schicht aus amorphem Kohlenstoff für eine Beschichtungsdauer von 10s beschichtet. Gegen Ende des Beschichtungsvorgangs wird die Mikrowellen-Energie gestoppt, die Zufuhr des Prozessgases wird unterbrochen und der Innenraum der Spritze wird bis Atmosphärendruck geflutet.

Die beschichteten Vials weisen bei 23°C und 50% rel. Luftfeuchtigkeit eine Sauerstoff-Permeation 0,0006 $cm^3$ / (Pckg d 0,21 bar) auf, während unbeschichtete Vials eine Sauerstoff-Permeation von 0,0283 $cm^3$ / (Pckg d 0,21 bar) besitzen, so dass die erzielte Barriere-Verbesserung für Sauerstoff besser als Faktor 40 ist. Durch ein hochauflösendes Permeations-Messverfahren konnte dabei diese hohe Barriere-Verbesserung nachgewiesen werden.

Die beschichteten Vials weisen bei 38°C, 90% relativer Feuchtigkeit eine Wasserdampf-Permeation von 0,23 mg / (Pckg d) auf, während unbeschichtete Vials eine Wasserdampf-Permeation von 0,4 mg / (Pckg d) besitzen. Die erzielte Barriere-Verbesserung für Wasserdampf liegt bei einem Faktor von 1,8.

<u>Ausführungsbeispiel 7c: Barriere-Schicht aus amorphem Kohlenstoff auf Silizium-organischer Haftschicht, abgeschieden auf COC-Vials</u>

Ein Vial aus COC (Cyclic Olefinic Copolymer), 12 ml Volumen, wird in den in Fig. 10a beschriebenen Reaktor eingesetzt. Dabei liegt das Vial zunächst auf der Unterseite des Reaktors auf der Dichtfläche auf und in das Vial ragt eine Gaszuführung aus Metall herein. Anschließend wird die Oberseite des Reaktors zugefahren und der Innenraum des Vials evakuiert bis ein Basisdruck < 0,05 mbar erreicht wird. Der das Vial umgebende Außenbereich der Reaktorkammer bleibt während des gesamten Behandlungsvorgangs auf Atmosphärendruck.

Schritt1: Anschließend wird Acetylen-Gas bei einem Druck von 0,2 mbar und mit einem Fluss von 50 sccm eingeleitet. Mittels der Zündvorrichtung wird im Unterraum eine Glimmentladung gezündet, wodurch aber noch keine Schichtabscheidung auf der Spritzen-Innenseite erfolgt. Erst ab dem Zeitpunkt, sobald gepulste Mikrowellen-Energie von der Mikrowellenquelle mit einer Frequenz von 2,45 GHz mit einer mittleren Mikrowellenleistung von 214 W über den Wellenleiter in den Reaktorraum eingekoppelt wird, zündet im Innenraum der Spritze ein Plasma während außenseitig aufgrund des Atmosphärendrucks kein Plasma zündet. Die Spritze wird während des Vorgangs innenseitig mit einer Barriere-Schicht aus amorphem Kohlenstoff für eine Beschichtungsdauer von 30s beschichtet. Gegen Ende des Beschichtungsvorgangs wird die Mikrowellen-Energie gestoppt, die Zufuhr des Prozessgases wird unterbrochen und der Innenraum der Spritze wird bis Atmosphärendruck geflutet.

Die beschichteten Vials weisen bei 23°C und 50% rel. Luftfeuchtigkeit eine Sauerstoff-Permeation 0,0008 $cm^3$ / (Pckg d 0,21 bar) auf, während unbeschichtete Vials eine Sauerstoff-Permeation von 0,0283 $cm^3$ / (Pckg d 0,21 bar) besitzen, so dass die erzielte Barriere-Verbesserung für Sauerstoff besser als Faktor 30 ist. Durch ein hochauflösendes Permeations-Messverfahren konnte dabei diese hohe Barriere-Verbesserung nachgewiesen werden.

Die beschichteten Vials weisen bei 38°C, 90% relativer Feuchtigkeit eine Wasserdampf-Permeation von 0,22 mg / Pckg d auf, während unbeschichtete Vials eine Wasserdampf-Permeation von 0,4 mg / Pckg d besitzen. Die erzielte Barriere-Verbesserung für Wasserdampf liegt bei einem Faktor von 1,8.

<u>Ausführungsbeispiel 8: Außenbeschichtung mit Barriere-Schicht</u>

Eine Spritze aus COC (Cyclic Olefinic Copolymer), 1 ml Volumen, mit einer Zylinderhöhe von 54mm und einem Zylinderinnendurchmesser von 6,5mm, einer Gesamthöhe von 64,5mm und einem Luer-Konus nach DIN 594 mit einer Länge von 10mm und mit einem inneren Öffnungsdurchmesser von 2 mm wird in den in Fig. 4 beschriebenen Reaktor mit dem großen Querschnitt nach unten und dem engen Querschnitt (Luer-Konus) nach oben zugeführt. Dabei wird die Spritze an beiden Öffnungen vakuumdicht verschlossen: Die Spritze zunächst auf der Unterseite des Reaktors auf der Dichtfläche auf und ist unten gegen das Vakuum abgedichtet. Auf der Oberseite wird der enge Querschnitt (Luer-Konus) abgedeckt und ist auch vakuumdicht..

Anschließend wird der Außenraum des Reaktors evakuiert bis ein Basisdruck < 0,05 mbar erreicht wird. Der Innenraum der Spritze bleibt während des gesamten Behandlungsvorgangs auf Atmosphärendruck. Während untenseitig die Verbindung zum Vakuum beibehalten bleibt, wird das Gaseinlass-Ventil geöffnet und über die Gasverteilervorrichtung in den Außenraum ein erstes Gasgemisch aus Sauerstoff und Hexamethyldisiloxan mit einem HMDSO-Fluss von 3,4 sccm und einem Sauerstoff-Fluss von 16,6 sccm bei einem Druck von 0,55mbar eingeleitet. In diesem Durchfluss-Betrieb stellt sich ein kontinuierlicher Fluss ein, bei dem das Gas parallel zur Symmetrieachse strömt. Mittels der Zündvorrichtung wird im Unterraum eine Glimmentladung gezündet, wodurch aber noch keine Schichtabscheidung auf der Spritzen-Innenseite erfolgt. Erst ab dem Zeitpunkt, sobald gepulste Mikrowellen-Energie von der Mikrowellenquelle mit einer Frequenz von 2,45 GHz mit einer mittleren Mikrowellenleistung von 57 W über den Wellenleiter in den Reaktorraum eingekoppelt wird, zündet im Äußenraum des Reaktors ein Plasma während innenseitig aufgrund des Atmosphärendrucks kein Plasma zündet. Die Spritze wird während des Vorgangs außenseitig mit einer ersten Haftvermittler-Schicht für eine erste Beschichtungsdauer von 1,1s und mit einer Dicke von 40nm beschichtet. Gegen Ende der ersten Beschichtung wird die Mikrowellen-Energie gestoppt. Anschließend folgt eine Gaswechselzeit, in der ein zweites Gasgemisch aus Hexamethyldisiloxan und Sauerstoff mit einem HMDSO-Flussvon 0,8 sccm und einem Sauerstoff-Fluss von 39,2 sccm bei einem Druck von 0,8 mbar in den Reaktor-Außenraum geleitet wird. Sobald gepulste Mikrowellen-Energie von der Mikrowellenquelle mit einer Frequenz von 2,45 GHz mit einer Mikrowellenleistung von 76,9W über den Wellenleiter in den Reaktorraum eingeleitet wird, zündet im Außenraum ein Plasma und es wird eine zweite anorganische Barriere-Schicht für eine zweite Beschichtungsdauer von 15,7 s und mit einer Dicke von 15 nm auf der Außenwand der Spritze aufgebracht. Gegen Ende des Beschichtungsvorgangs wird die Mikrowellen-Energie gestoppt, die Zufuhr des Prozessgases wird unterbrochen. Nachfolgend wird das Substrat in einer Abkühlpaüse abgekühlt und anschließend wird nach Evakuieren der Beschichtungsvorgang für die Barriere-Schicht vier mal wiederholt, wobei gleiche Prozessparameter verwendet und gleich dicke Barriereschichten wie in Schritt2 abgeschieden werden. Die gesamte Barriere-Dicke der vier hintereinander aufgebrachten Barriere-Schichten beträgt 60nm. Gegen Ende des Prozesses wird der Innenraum der Spritze auf Atmosphärendruck geflutet. Im Vergleich zur unbeschichteten Spritze hat die beschichtete Spritze eine Barriere-Verbesserung für Sauerstoff.

Ausführungsbeispiel 9: Innenbeschichtung mit dekorativer Schicht (Schicht mit selektiver Reflexion im sichtbaren Wellenlängenbereich)

Eine Spritze aus COC (Cyclic Olefinic Copolymer), 1 ml Volumen, mit einer Zylinderhöhe von 54mm und einem Zylinderinnendurchmesser von 6,5mm, einer Gesamthöhe von 64,5mm und einem Luer-Konus nach DIN 594 mit einer Länge von 10mm und mit einem inneren Öffnungsdurchmesser von 2 mm wird in den in Fig. 1 beschriebenen Reaktor mit dem großen Querschnitt nach unten und dem engen Querschnitt (Luer-Konus) nach oben zugeführt. Dabei liegt die Spritze zunächst auf der Unterseite des Reaktors auf der Dichtfläche auf. Anschließend wird die Oberseite des Reaktors zugefahren und beim Schließen des Reaktors wird die Spritze an der Oberseite vakuumdicht abgedichtet. Der Gegendruck stellt sicher, dass die Spritze auch untenseitig vakuumdicht aufliegt. Anschließend wird der Innenraum der Spritze evakuiert bis ein Basisdruck < 0,05mbar erreicht wird.
Der Außenraum bleibt während des gesamten Behandlungsvorgangs auf Atmosphärendruck.

Schritt 1: Abscheidung einer hoch brechenden Schicht

Während untenseitig die Verbindung zum Vakuum beibehalten bleibt wird das Gaseinlass-Ventil geöffnet und über die Seite mit dem engen Querschnitt, d.h. beim Luer-Konus der Spritze, ein erstes Gasgemisch aus Titanchlorid und Sauerstoff mit einem $TiCl_4$-Fluss von 0,2 sccm und einem Sauerstoff-Fluss von 19,8 sccm bei einem Druck von 0,2 mbar in den Innenraum der Spritze geleitet wird. Sobald gepulste Mikrowellen-Energie von der Mikrowellenquelle mit einer Frequenz von 2,45 GHz mit einer mittleren Mikrowellenleistung von 90W über den Wellenleiter in den Reaktorraum eingeleitet wird, zündet innen in der Spritze ein Plasma und es wird eine erste hochbrechende Schicht für eine erste Beschichtungsdauer von 27 s und mit einer Dicke von 30 nm aufgebracht.

Schritt 2): Abscheidung niedrig brechender Schicht

Anschließend folgt eine Gaswechselzeit, in der ein zweites Gasgemisch aus Hexamethyldisiloxan und Sauerstoff mit einem HMDSO-Fluss von 0,2 sccm und einem Sauerstoff-Fluss von 9,8 sccm bei einem Druck von 0,15 mbar in den Innenraum der Spritze geleitet wird. Sobald gepulste Mikrowellen-Energie von der Mikrowellenquelle mit einer Frequenz von 2,45 GHz mit einer mittleren Mikrowellenleistung von 15,7W über den Wellenleiter in den Reaktorraum eingeleitet wird, zündet innen in der Spritze ein Plasma und es wird eine zweite anorganische Barriere-Schicht für eine zweite Beschichtungsdauer von 93s und mit einer mittleren Schichtdicke von 40 nm aufgebracht.
Die Schritte 1 und 2 werden 8 mal wiederholt, wobei die Schichtdicken und Beschichtungszeiten für das Schichtdesign angepasst werden.
Gegen Ende des Beschichtungsvorgangs wird die Mikrowellen-Energie gestoppt, die Zufuhr des Prozessgases wird unterbrochen und der Innenraum der Spritze wird bis Atmosphärendruck geflutet.
Durch das Wechselschichtsystem aus hoch- und niedrigbrechenden Schichten wird ein dekorativer Effekt erreicht: Die Schicht reflektiert selektiv (d.h. Wellenlängen-abhängig) das eingestrahlte Licht. Das Schicht-Design ist so angepasst, dass das Schichtsystem bläulich wirkt.
Ferner ist aufgrund der zusätzlichen Barriere-Wirkung der Titanoxid-Schicht die Barriereverbesserung für Sauerstoff deutlich besser als in Ausführungsbeispiel 2.

Ausführungsbeispiel 10: Verspiegelung

Die Schichten werden analog wie in Ausführungsbeispiel 9 aufgebracht..Es werden aber 12 Schichten verwendet und das Design ist so angepasst, dass selektiv dass sichtbare Lichtspektrum reflektiert wird.

Ausführungsbeispiel 11: Schicht mit selektiver Reflexion im infraroten Wellenlängenbereich

Die Schichten werden analog wie in Ausführungsbeispiel 10 aufgebracht. Es werden aber 14 Schichten verwendet und das Design ist so angepasst, dass selektiv Licht des infraroten Wellenlängenbereichs reflektiert wird.

Ausführungsbeispiel 12: Schicht mit selektiver Reflexion im infraroten Wellenlängenbereich

Die Schichten werden analog wie in Ausführungsbeispiel 10 aufgebracht. Es werden aber 14 Schichten verwendet und das Design ist so angepasst, dass selektiv Licht des infraroten Wellenlängenbereichs reflektiert wird

Ausführungsbeispiel 13: Außenbeschichtung mit UV-Reflexions-Schicht und Kratzschutz.schicht

Die UV-Reflexions-Schicht ist eine Schicht mit selektiver Reflexion im ultravioletten Wellenlängenbereich Die Schichten werden analog wie in Ausführungsbeispiel 8 abgeschieden, die Schichtabfolge erfolgt analog zu Ausführungsbeispiel 9. Es werden aber 16 Schichten verwendet und das Design ist so angepasst, dass selektiv Licht des ultravioletten Wellenlängenbereichs reflektiert wird. Zusätzlich wird als letzte Schicht eine 100nm dicke Kratzschutzschicht, vom Beschichtungsprozess analog dem Ausführungsbeispiel 6 aufgebracht.

Ausführungsbeispiel 14: Außenbeschichtung mit dekorativer Schicht

Analog dem Ausführungsbeispiel 9, und mit dem Reaktor entsprechend Ausführungsbeispiel 8 und anlog dem Verfahren entsprechend Ausführungsbeispiel 9 wird eine dekorative Schicht auf der Außenseite aufgebracht. /

Es ist dem Fachmann ersichtlich, dass die Erfindung nicht auf die vorstehend beschriebenen beispielhaften Ausführungsformen beschränkt ist, sondern vielmehr in vielfältiger Weise variiert werden kann. Insbesondere können die Merkmale der einzelnen Ausführungsbeispiele auch miteinander kombiniert werden.

**Patentansprüche**

1. Verfahren zur Plasmabehandlung von hohlkörperförmigen Werkstücken, bei welchem in einer Reaktorkammer ein Behandlungsbereich wenigstens teilweise evakuiert, ein Prozessgas in den Behandlungsbereich, insbesondere in den Hohlraum des Werkstücks eingeleitet und mittels eingestrahlter elektromagnetischer Energie ein Plasma in der Umgebung zumindest eines Teils der Oberfläche des Werkstücks erzeugt wird, **dadurch gekennzeichnet, dass** das Plasma während einer Anregung von Gas durch eine Glimmentladung in einem von der Reaktorkammer (2) separierten Raum (28) durch Einstrahlen von elektromagnetischer Energie ins eingeleitete Prozessgas gezündet wird, und dass das Prozessgas während der Plasmabehandlung den Behandlungsbereich zwischen gegenüberliegenden Enden des Bereichs durchströmt.

2. Verfahren Anspruch 1, **dadurch gekennzeichnet, dass** die Plasmabehandlung ausschließlich auf der Innenseite (13) des Hohlkörpers (10) durchgeführt wird.

3. Verfahren gemäß Anspruch 1 oder 2, **dadurch gekennzeichnet, dass** die Plasmabehandlung ausschließlich auf der Außenseite des Werkstücks (10) durchgeführt wird.

4. Verfahren gemäß einem der Ansprüche 1 bis 3, **dadurch gekennzeichnet, dass** die Plasmabehandlung sowohl auf der Innenseite (13) als auch auf der Außenseite des Hohlkörpers (10) durchgeführt wird und dass vorzugsweise die Plasmabehandlungen auf der Innenseite (13) und der Außenseite des Hohlkörpers (10) verschieden sind oder sich verschiedenartig auf die Oberflächen auswirken.

5. Verfahren gemäß einem der vorstehenden Ansprüche, **dadurch gekennzeichnet, dass** das Werkstück (10)

   i) zylinderförmig oder zylinderähnlich geformt ist und einen maximalen Außendurchmesser zwischen 1mm bis 50mm, vorzugsweise zwischen 3mm bis 30mm, besonders bevorzugt von 5mm bis 20mm und eine Höhe von 10mm bis 200mm, vorzugsweise von 30mm bis 150mm, besonders bevorzugt von 50mm bis 100mm hat, oder
   ii) einen maximalen Innen-Durchmesser zwischen 1mm bis 50mm, vorzugsweise zwischen 2mm bis 29mm, besonders bevorzugt von 4mm bis 20mm und eine Höhe von 10mm bis 200mm, vorzugsweise von 30mm bis 150mm, besonders bevorzugt von 50mm bis 100mm hat und eine Wandstärke von 0,2mm bis 10mm, vorzugsweise von 0,3mm bis 8mm, besonders bevorzugt von 2mm bis 5mm aufweist, oder
   iii), dass das Werkstück eine zweite zylindrische- oder Zylinder-ähnliche Ausformung (15) mit kleinerem Durchmesser und kleinerer Länge umfasst, die wenigstens um 20% kleiner, vorzugsweise um 50% kleiner als der maximale Durchmesser und die Höhe sind, oder
   iv) dass das Werkstück (10) eine zweite zylindrische- oder Zylinder-ähnliche Ausformung (15) mit kleinerem Durchmesser und kleinerer Länge umfasst, die einen vorzugsweise engen, kanülenartigen Innendurchmesser zwischen 0,01 und 15mm, besonders bevorzugt zwischen 0,05 und 4mm hat, oder

v) ein Volumen im Bereich von 0,1 - 100ml, vorzugsweise im Bereich von 0,2 - 40ml, besonders bevorzugt von 0,5 - 20ml hat.

6. Verfahren gemäß einem der vorstehenden Ansprüche, **dadurch gekennzeichnet, dass** das Werkstück (10)zylinderförmig oder Zylinder-ähnlich, mit einer ersten zylindrischen oder Zylinder-ähnlichen Fläche geformt ist und eine zylindrische- oder Zylinder-ähnliche Ausformung (11) mit einer zweiten zylindrischen oder Zylinderähnlichen Fläche (15) aufweist, wobei auf der ersten zylindrischen oder Zylinder-ähnlichen Fläche wenigstens eine dünne Schicht mit einer Schichtdicke D1 und auf der zweiten Zylinder-ähnlichen Fläche die Schicht mit einer Dicke D2 aufgebracht wird, wobei für das Verhältnis der Dicken D1 und D2 $0,2 \leq D2/D1 \leq 5$ , vorzugsweise $0,4 \leq D2/D1 \leq 1,5$, besonders bevorzugt $0,7 \leq D2/D1 \leq 1,2$ erfüllt ist.

7. Verfahren gemäß einem der vorstehenden Ansprüche, **dadurch gekennzeichnet, dass** das Prözessgas über wenigstens eine Kanüle (64) in den Behandlungsbereich eingelassen wird, deren innerer Öffnungsdurchmesser zwischen 0,1 und 5,0mm, vorzugsweise zwischen 0,2mm und 3,0mm, besonders bevorzugt zwischen 0,3mm und 2,0mm liegt und deren Wandstärke zwischen 0,05mm und 3,0mm, vorzugsweise zwischen 0,1mm und 2,0mm, besonders bevorzugt zwischen 0,15mm und 1,0mm liegt.

8. Verfahren gemäß einem der vorstehenden Ansprüche, **dadurch gekennzeichnet, dass** das Werkstück (10) durch eine Öffnung (12) an einem ersten Ende evakuiert und das Prozessgas durch eine weitere Öffnung (16) an einem zweiten Ende (15) des Werkstücks (10), welches dem ersten Ende gegenüberliegt, eingeleitet wird und dass vorzugsweise elektromagnetische Energie in axialer Richtung, besonders bevorzugt axial-symmetrisch zum Werkstück (10) eingekoppelt wird.

9. Verfahren gemäß einem der vorstehenden Ansprüche, **dadurch gekennzeichnet, dass** Spritzenkörper (10) innenseitig plasmabehandelt werden.

10. Verfahren gemäß Anspruch 9, bei welchem der Hohlraum (13)der Spritze (10) durch deren Kolbenöffnung (12) evakuiert wird.

11. Verfahren gemäß Anspruch 9 oder 10, wobei das Prozessgas durch den Luer-Konus (15) des Spritzenkörpers (10) zugeführt wird.

12. Verfahren gemäß Anspruch 9 oder 10, wobei das Prozessgas durch die Kolbenöffnung (16) des Spritzenkörpers (10) zugeführt wird.

13. Verfahren gemäß einem der vorstehenden Ansprüche, **dadurch gekennzeichnet, dass** die Plasmabehandlung zumindest einen, vorzugsweise zwei der Schritte Plasmabeschichten, Plasma-Aktivierung, Plasma-Vorbehandlung, Plasma-Reinigung, Plasma-Immersion, Plasma-Modifikation, Plasma-Sterilisation umfasst.

14. Verfahren gemäß einem der vorstehenden Ansprüche, **dadurch gekennzeichnet, dass** wenigstens eine Schicht mit der Plasmabehandlung abgeschieden wird, die

i) eine Barrierewirkung gegen Gase besitzt, oder

ii) eine Barrierewirkung gegen Bestandteile aus dem Werkstück, wie beispielsweise Ausgangs- oder Nebenoder Endverbindungen aus der Herstellung des Werkstücks aufweist, oder dass

iii) eine Barriereschicht mit einer chemischen Barrierewirkung, oder

iv) eine Kratzschutzschicht abgeschieden wird, oder

v) eineUV-reflektierende oder UV-absorbierende Schicht abgeschieden wird, oder

vi) eine farbgebende Schicht, vorzugsweise eine blau erscheinende Schicht abgeschieden wird, oder

vii) eine ver- oder entspiegelnde Schicht abgeschieden wird.

15. Verfahren gemäß einemn der vorstehenden Ansprüche, **dadurch gekennzeichnet, dass** eine Kunststoff-Oberfläche des Werkstücks (10) behandelt wird, welche zumindest eine der nachfolgenden Materialien enthält:

polycyclische Kohlenwasserstoffe, wie z.B. zyklische Polymere oder Copolymere, bevorzugt zyklische polyolefinische Copolymere oder Polymere, besonders bevorzugt COC, insbesondere Topas oder COP, Polycarbonate, bevorzugt autoklavierbare Polycarbonate, Polyethylenterphthalate (PET) oder PETG, Polystyrol, Polyethylen, wie MDPE, insbesondere aber HDPE oder LDPE, Polypropylen, auch orientiertes Polypropylen (o-PP), oder biaxial orientiertes Polypropylen (BOPP), Polymethylmetacrylat, PES, Polyethylene-Naphtalate (PEN), SAN, Fluorhaltige Polymere, vorzugsweise Polychlortriofluorethylene (PCTFE), EVOH, Polyamid, PVC, PVDC, PMMI, PA, ABS, MABS, PMP, PES, PSI.

16. Verfahren gemäß der Ansprüche 1 bis 14, **dadurch gekennzeichnet, dass** ein Glas-, Glaskeramik- oder Keramik-Werkstück (10) plasmabehandelt wird.

17. Verfahren gemäß einem der vorstehenden Ansprüche, **dadurch gekennzeichnet, dass** die elektromagnetische Energie mittels Elektroden (56, 58) in den Hohlraum (13) eingestrahlt wird.

18. Verfahren gemäß einem der vorstehenden Ansprüche, **dadurch gekennzeichnet, dass** ein axialsymmetrischer Fluß des Prozessgases durch den Hohlraum (13) des Werkstücks (10) hergestellt wird und dass vorzugsweise elektromagnetische Energie in axialer Richtung, besonders bevorzugt axialsymmetrisch in den Hohlraum (13) eingekoppelt wird.

19. Verfahren zur Plasmabehandlung von Werkstücken, gemäß einem der vorstehenden Ansprüche, wobei das Plasma über eine Anregung von Gas in einem von der Reaktorkammer (2) separierten Raum (28) gezündet wird, während die elektromagnetische Energie zur Erzeugung des Plasmas im eingeleiteten Prozessgas eingestrahlt wird und bei der Anregung energiereiche Spezies oder Strahlung, wie

   i) Angeregte Elektronen
   ii) Angeregte Ionen
   iii) angeregte Neutralteilchen
   iv) ultraviolette Strahlung entstehen und durch diese die Zündung des Plasmas unterstützt wird.

20. Verfahren gemäß Anspruch 19, **dadurch gekennzeichnet, dass** das Plasma in der Umgebung mittels einer Glimmentladung in dem separierten Raum (28) gezündet wird und dass die Glimmentladung vorzugsweise durch wenigstens einen der folgenden Parameter gezündet wird:

   i) durch eine Hochspannung im Bereich von 0,1 kV - 100 kV
   ii) ein Wechselstrom mit einer Frequenz von 0,2KHz - 100 MHz, vorzugsweise 1KHz - 100 kHz
   iii) ein effektiver Wechselstrom im Bereich von 0,01 mA - 2A, vorzugsweise im Bereich von 0,1mA bis 500 mA.

21. Verfahren gemäß einem der vorstehenden Ansprüche, **dadurch gekennzeichnet, dass** die elektromagnetische Energie durch einen Koaxialleiter (19) und Prozessgas durch den Innenleiter (20) des Koaxialleiters zugeführt wird.

22. Verfahren gemäß einem der vorstehenden Ansprüche, **dadurch gekennzeichnet, dass** die elektromagnetische Energie durch einen Koaxialleiter (19) vorzugsweise in axialer Richtung eingestrahlt und der Behandlungsbereich durch den Koaxialleiter evakuiert wird.

23. Verfahren gemäß einem der vorstehenden Ansprüche, **dadurch gekennzeichnet, dass** eine Funktionsschicht mittels Plasmaabscheidung auf einer Pharmaverpackung, insbesondere einem Spritzenkörper (10), einem Vial, einem Blutentnahmeröhrchen oder einer Karpule, vorzugsweise mit einer mittleren Leistung von höchstens 300 Watt, besonders bevorzugt höchstens 100 Watt abgeschieden wird.

24. Verfahren gemäß einem der vorstehenden Ansprüche, **dadurch gekennzeichnet, dass** durch die Plasmabehandlung eine Schicht abgeschieden wird, welche zumindest einen der Stoffe $SiO_x$, $SiO_xC_y$, $SiO_xN_y$, $SiN_y$, $TiO_x$, $Al_xO_yN_z$, $Al_xN_z$, $Al_xO_y$, $C_xH_y$, $C_xF_y$, $TiN_x$ enthält.

25. Verfahren gemäß einem der vorstehenden Ansprüche **dadurch gekennzeichnet, dass** zumindest ein Füllkörper (84), ein Hohlraum (13) eines zu behandelnden Werkstücks (10) zumindest teilweise ausfüllt und die Temperaturverteilung auf dem Werkstück (10) während und nach der Plasmabehandlung dadurch gleichmäßiger wird.

26. Vorrichtung zur Plasmabehandlung von hohlkörperförmigen Werkstücken, eingerichtet zur Durchführung des Verfahrens gemäß einem der vorstehenden Ansprüche, umfassend eine Reaktorkammer, einen Behandlungsbereich in der Reaktorkammer, eine Einrichtung zum wenigstens teilweise Evakuieren des Behandlungsbereichs in der Reaktorkammer, eine Einrichtung zur Einstrahlung elektromagnetischer Energie in den Behandlungsbereich für die Erzeugung eines Plasmas und eine Einrichtung zur Einleitung von Prozessgas in den Behandlungsbereich, **dadurch gekennzeichnet, dass** die Einrichtung zur Einleitung von Prozessgas und die Einrichtung zum Evakuieren des Behandlungsbereichs so angeordnet sind, dass das Prozessgas im Betrieb den Behandlungsbereich zwischen gegenüberliegenden Enden des Bereichs durchströmt, und **gekennzeichnet durch** eine Einrichtung zur Erzeugung einer Glimmentladung (29) in einem von der Reaktorkammer (2) separierten Raum (28), um angeregte Spezies in der Behandlungszone zur Erzeugung des Plasmas bereitzustellen.

27. Vorrichtung gemäß Anspruch 26, wobei die Einrichtung zur Einleitung von Prozessgas in den Behandlungsbereich wenigstens eine Kanüle (64) umfasst, deren innerer Öffnungsdurchmesser zwischen 0,1 und 5,0mm, vorzugsweise zwischen 0,2mm und 3,0mm, besonders bevorzugt zwischen 0,3mm und 2,0mm liegt und deren Wandstärke zwischen 0,05mm und 3,0mm, vorzugsweise zwischen 0,1mm und 2,0mm, besonders bevorzugt zwischen 0,15mm und 1,0mm liegt.

28. Vorrichtung gemäß Anspruch 26 oder 27, **dadurch gekennzeichnet, dass** die Einrichtung zur Einleitung von Prozessgas eine Einrichtung zur Einleitung des Prozessgases durch eine weitere Öffnung an einem zweiten Ende des Werkstücks (10), welches dem ersten Ende gegenüberliegt, umfasst.

29. Vorrichtung gemäß einem der Ansprüche 26 bis 28, eingerichtet zur innenseitigen Plasmabehandlung von Spritzenkörpern (10).

30. Vorrichtung gemäß Anspruch 29, **gekennzeichnet durch** eine Anschlußeinrichtung zum Anschluß einer Evakuierungseinrichtung (90) zum zumindest teilweisen Evakuieren des Hohlraums (13) des Spritzenkörpers (10) an die Kolbenöffnung (12) der Spritze.

31. Vorrichtung gemäß Anspruch 29 oder 30, **gekennzeichnet durch** eine Einrichtung zur Einleitung des Prozessgases durch den Luer-Konus (15) des Spritzenkörpers (10).

32. Vorrichtung gemäß einem der Ansprüche 27 bis 32, **gekennzeichnet durch** zumindest eine lokale Abschirmung (30, 32), welche das Werkstück (10) umgibt und eingestrahlte elektromagnetische Energie lokal von Bereichen des Hohlraums (13) des Werkstücks (10) abschirmt.

33. Vorrichtung gemäß einem der Ansprüche 26 bis 32, eingerichtet für eine Außenbeschichtung von Werkstücken (10), mit einer Einrichtung (90) zum wenigstens teilweise Evakuieren der Umgebung eines Werkstücks (10) in der Reaktorkammer (2).

34. Vorrichtung gemäß einem der Ansprüche 26 bis 33, **gekennzeichnet durch** entlang eines Transportweges bewegbare Reaktoren (100) zur Plasmabehandlung von Werkstücken (10), einer Zuführposition zur Zuführung der Werkstücke (10) zu den Reaktoren (100), einer Entnahmeposition zur Entnahme der Werkstücke (10) aus den Reaktoren (100), und einer Einrichtung zur Plasmabehandlung zwischen Zuführ- und Entnahmeposition mit einer Einrichtung zur Einstrahlung elektromagnetischer Energie (54) in den Hohlraum (13).

35. Vorrichtung gemäß vorstehendem Anspruch, **dadurch gekennzeichnet, dass** die mehreren Beschichtungsplätze jeweils separate Energiequellen (101) zur Bereitstellung elektromagnetischer Energie, sowie separate Vorräume (28) aufweisen, die mit den Beschichtungsbereichen verbunden sind und an einer gemeinsamen Vakuumerzeugungseinrichtung (90), vorzugsweise über eine weitere Kammer verbunden sind, wobei in den Vorräumen (28) jeweils Einrichtungen zur Anregung des Prozessgases angeordnet sind, die jeweils an separate zweite Energiequellen (101) angeschlossen sind.

36. Vorrichtung gemäß einem der Ansprüche 26 bis 35, **gekennzeichnet durch** eine Abschirmung (30, 32) für die elektromagnetische Energie zur Entkopplung der Zuleitung der Reaktorkammer (2) zur Evakuierungseinrichtung (90).

37. Vorrichtung gemäß einem der Ansprüche 26 bis 36, **gekennzeichnet durch** einen Vorraum (28) zum Reaktorraum (2), wobei die Einrichtung zum Evakuieren (90) an den Vorraum (28) angeschlossen ist.

38. Vorrichtung zur Plasmabehandlung von Werkstücken, gemäß einem der Ansprüche 26 bis 37, mit einer Reaktorkammer (2) zur Aufnahme eines zu beschichtenden Werkstücks (10), einer Einrichtung zum zumindest teilweisen Evakuieren (90) wenigstens eines Bereichs der Reaktorkammer (2), einer Einrichtung zur Einstrahlung elektromagnetischer Energie (54) in die Reaktorkammer (2), sowie einem von der Reaktorkammer (2) separierten Raum, und einer Zündeinrichtung für ein Plasma in der Reaktorkammer (2), wobei die Zündeinrichtung eine Einrichtung zur Anregung von Gas in dem von der Reaktorkammer (2) separierten Raum (28) umfasst.

39. Vorrichtung gemäß Anspruch 38, **dadurch gekennzeichnet, dass** die Zündeinrichtung eine Einrichtung zur Erzeugung einer Glimmentladung in dem von der Reaktorkammer (2) separierten Raum (28) umfasst.

40. Vorrichtung gemäß Anspruch 39, **gekennzeichnet durch** eine vorzugsweise optische Überwachungseinrichtung (23) für die Glimmentladung.

41. Vorrichtung gemäß einem der Ansprüche 26 bis 40, **dadurch gekennzeichnet, dass** die Einrichtung zur Einstrahlung elektromagnetischer Energie (54) in die Reaktorkammer (2) einen Koaxialleiter (19) umfaßt, wobei der Behandlungsbereich durch den Koaxialleiter (19) evakuierbar ist.

42. Vorrichtung gemäß Anspruch 41 , **dadurch gekennzeichnet, dass** der Koaxialleiter (19) einen axial verlaufenden Kanal aufweist, durch den das Prozessgas zuführbar ist.

43. Vorrichtung gemäß Anspruch 42, **dadurch gekennzeichnet, dass** eine Zündeinrichtung, insbesondere eine Zündelektrode (29) zur Erzeugung einer Glimmentladung im Kanal durch den Innenleiter (20) vorgesehen ist.

44. Vorrichtung gemäß einem der Ansprüche 26 bis 43, **gekennzeichnet durch** einen Füllkörper (84), welcher einen Hohlraum (13) eines zu behandelnden Werkstücks (10) zumindest teilweise ausfüllt.

45. Vorrichtung gemäß Anspruch 44, **gekennzeichnet dadurch, dass** der Füllkörper (84) hochfrequente elektromagnetische Energie absorbiert oder reflektiert.

46. Vorrichtung gemäß Anspruch 44 oder 45, **gekennzeichnet dadurch, dass** der Füllkörper (84) eine Zündung eines Plasmas in unmittelbarer Umgebung des ausgefüllten Bereichs verhindert.

47. Vorrichtung gemäß einem der Ansprüche 42 bis 44, **dadurch gekennzeichnet, dass** der Füllkörper (84) in einen Koaxial-Innenleiter (20) integriert ist.

**Claims**

1. Method for the plasma treatment of hollow body-shaped workpieces, in which a treatment region is at least partially evacuated in a reactor chamber, a process gas is introduced into the treatment region, in particular into the cavity of the workpiece, and a plasma is produced by means of introduced electromagnetic energy in the surrounding area of at least a part of the surface of the workpiece, **characterised in that** the plasma is ignited during an excitation of gas by a glow discharge in a space (28), which is separated from the reactor chamber (2), by introduction of electromagnetic energy into the introduced process gas, and that the process gas flows through the treatment region between opposite ends of the region during the plasma treatment.

2. Method as claimed in claim 1, **characterised in that** the plasma treatment is performed exclusively on the inner side (13) of the hollow body (10).

3. Method as claimed in claim 1 or 2, **characterised in that** the plasma treatment is performed exclusively on the outer side of the workpiece (10).

4. Method as claimed in any one of claims 1 to 3, **characterised in that** the plasma treatment is performed both on the inner side (13) and on the outer side of the hollow body (10) and that preferably the plasma treatments on the inner side (13) and the outer side of the hollow body (10) are different or affect the surfaces in different ways.

5. Method as claimed in any one of the preceding claims, **characterised in that** the workpiece (10)

   i) is shaped cylindrically or quasi-cylindrically and has a maximum external diameter of between 1 mm to 50 mm, preferably between 3 mm to 30 mm, particularly preferably of 5 mm to 20 mm and a height of 10 mm to 200 mm, preferably of 30 mm to 150 mm, particularly preferably of 50 mm to 100 mm, or

ii) has a maximum internal diameter of between 1 mm to 50 mm, preferably between 2 mm to 29 mm, particularly preferably of 4 mm to 20 mm and a height of 10 mm to 200 mm, preferably of 30 mm to 150 mm, particularly preferably of 50 mm to 100 mm and comprises a wall thickness of 0.2 mm to 10 mm, preferably of 0.3 mm to 8 mm, particularly preferably of 2 mm to 5 mm, or

iii) that the workpiece comprises a second cylindrical or quasi-cylindrical formation (15) with a smaller diameter and a shorter length which are at least 20% smaller, preferably 50% smaller than the maximum diameter and the height, or

iv) that the workpiece (10) comprises a second cylindrical or quasi-cylindrical formation (15) with a smaller diameter and shorter length which has a preferably narrow, cannula-like internal diameter of between 0.01 and 15 mm, particularly preferably between 0.05 and 4 mm, or

v) has a volume in the range of 0.1-100 ml, preferably in the range of 0.2-40 ml, particularly preferably of 0.5-20 ml.

6. Method as claimed in any one of the preceding claims, **characterised in that** the workpiece (10) is shaped cylindrically or quasi-cylindrically, having a first cylindrical or quasi-cylindrical surface and comprises a cylindrical or quasi-cylindrical formation (11) with a second cylindrical or quasi-cylindrical surface (15), wherein at least one thin layer with a layer thickness D1 is applied on the first cylindrical or quasi-cylindrical surface and the layer with a thickness D2 is applied on the second quasi-cylindrical surface, wherein the relation $0.2 \leq D2/D1 \leq 5$, preferably $0.4 \leq D2/D1 \leq 1.5$, particularly preferably $0.7 \leq D2/D1 \leq 1.2$ is satisfied for the ratio of the thicknesses D1 and D2.

7. Method as claimed in any one of the preceding claims, **characterised in that** the process gas is let into the treatment region via at least one cannula (64), the internal opening diameter of which is between 0.1 and 5.0 mm, preferably between 0.2 mm and 3.0 mm, particularly preferably between 0.3 mm and 2.0 mm and the wall thickness of which is between 0.05 mm and 3.0 mm, preferably between 0.1 mm and 2.0 mm, particularly preferably between 0.15 mm and 1.0 mm.

8. Method as claimed in any one of the preceding claims, **characterised in that** the workpiece (10) is evacuated through an opening (12) at a first end and the process gas is introduced through a further opening (16) at a second end (15) of the workpiece (10) located opposite the first end, and that preferably electromagnetic energy is coupled-in in the axial direction, particularly preferably in an axially symmetrical manner with respect to the workpiece (10).

9. Method as claimed in any one of the preceding claims, **characterised in that** syringe bodies (10) are plasma-treated on the inner side.

10. Method as claimed in claim 9, wherein the cavity (13) of the syringe (10) is evacuated through its plunger opening (12).

11. Method as claimed in claim 9 or 10, wherein the process gas is fed through the Luer cone (15) of the syringe body (10).

12. Method as claimed in claim 9 or 10, wherein the process gas is fed through the plunger opening (16) of the syringe body (10).

13. Method as claimed in any one of the preceding claims, **characterised in that** the plasma treatment comprises at least one, preferably two, of the steps of plasma coating, plasma activation, plasma pre-treatment, plasma cleaning, plasma immersion, plasma modification, plasma sterilisation.

14. Method as claimed in any one of the preceding claims, **characterised in that** by means of the plasma treatment at least one layer is deposited which

i) has a barrier effect against gases, or

ii) has a barrier effect against constituents from the workpiece, such as e.g. starting compounds, secondary compounds or terminal compounds from the production of the workpiece, or that

iii) a barrier layer with a chemical barrier effect, or

iv) a scratch protection layer is deposited, or

v) a UV-reflecting or UV-absorbing layer is deposited, or

vi) a colouring layer is deposited, preferably a layer which appears blue in colour, or

vii) a reflective or anti-reflective layer is deposited.

15. Method as claimed in any one of the preceding claims, **characterised in that** a synthetic material surface of the workpiece (10) is treated which contains at least one of the following materials:

polycyclic hydrocarbons, such as e.g. cyclic polymers or copolymers, preferably cyclic polyolefinic copolymers or polymers, particularly preferably COC, in particular Topas or COP, polycarbonates, preferably autoclavable polycarbonates, polyethylene terephthalates (PET) or PETG, polystyrene, polyethylene, such as MDPE, but in particular HDPE or LDPE, polypropylene including oriented polypropylene (o-PP), or biaxially oriented polypropylene (BOPP), polymethyl methacrylate, PES, polyethylene naphthalates (PEN), SAN, polymers containing fluorine, preferably Polychlorotrifluoroethylene (PCTFE), EVOH, polyamide, PVC, PVDC, PMMI, PA, ABS, MABS, PMP, PES, PSI.

16. Method as claimed in claims 1 to 14, **characterised in that** a glass, glass-ceramic or ceramic workpiece (10) is plasma-treated.

17. Method as claimed in any one of the preceding claims, **characterised in that** the electromagnetic energy is introduced into the cavity (13) by means of electrodes (56, 58).

18. Method as claimed in any one of the preceding claims, **characterised in that** an axially symmetrical flow of the process gas through the cavity (13) of the workpiece (10) is produced, and that preferably electromagnetic energy is coupled into the cavity (13) in the axial direction, particularly preferably in an axially symmetrical manner.

19. Method for the plasma treatment of workpieces as claimed in any one of the preceding claims, wherein the plasma is ignited by excitation of gas in a space (28) separated from the reactor chamber (2), while the electromagnetic energy for generating the plasma is introduced in the process gas being introduced, and energetic species or radiation, such as

> i) excited electrons
> ii) excited ions
> iii) excited neutral particles
> iv) ultraviolet radiation

are produced during the excitation and the ignition of the plasma is assisted thereby.

20. Method as claimed in claim 19, **characterised in that** the plasma is ignited in the surrounding area by means of a glow discharge in the separated space (28), and that the glow discharge is ignited preferably by at least one of the following parameters:

> i) a high voltage in the range of 0.1 kV-100 kV
> ii) an alternating current with a frequency of 0.2 kHz-100 MHz, preferably 1 kHz-100 kHz
> iii) an effective alternating current in the range of 0.01 mA-2A, preferably in the range of 0.1 mA to 500 mA.

21. Method as claimed in any one of the preceding claims, **characterised in that** the electromagnetic energy is fed through a coaxial conductor (19) and process gas is fed through the inner conductor (20) of the coaxial conductor.

22. Method as claimed in any one of the preceding claims, **characterised in that** the electromagnetic energy is introduced through a coaxial conductor (19) preferably in the axial direction and the treatment region is evacuated through the coaxial conductor.

23. Method as claimed in any one of the preceding claims, **characterised in that** a functional layer is deposited by means of plasma deposition on pharmaceutical packaging, in particular a syringe body (10), a vial, a blood withdrawal tube or a carpule, preferably with an average power of not more than 300 Watt, particularly preferably not more than 100 Watt.

24. Method as claimed in any one of the preceding claims, **characterised in that** a layer containing at least one of the substances $SiO_x$, $SiO_xC_y$, $SiO_xN_y$, $SiN_y$, $TiO_x$, $Al_xO_yN_z$, $Al_xN_z$, $Al_xO_y$, $C_xH_y$, $C_xF_y$, $TiN_x$ is deposited by the plasma treatment.

25. Method as claimed in any one of the preceding claims, **characterised in that** a cavity (13) of a workpiece (10) to be treated is filled at least partially with at least one filler body (84) and the temperature distribution on the workpiece (10) thereby becomes more uniform during and after the plasma treatment.

**26.** Apparatus for the plasma treatment of hollow body-shaped workpieces, adapted for performing the method as claimed in any one of the preceding claims, comprising a reactor chamber, a treatment region in the reactor chamber, a device for at least partially evacuating the treatment region in the reactor chamber, a device for introducing electromagnetic energy into the treatment region in order to generate a plasma and a device for introducing process gas into the treatment region, **characterised in that** the device for introducing process gas and the device for evacuating the treatment region are arranged such that the process gas flows through the treatment region between opposite ends of the region during operation, and **characterised by** a device for generating a glow discharge (29) in a space (28) separated from the reactor chamber (2), in order to provide excited species in the treatment zone for generating the plasma.

**27.** Apparatus as claimed in claim 26, wherein the device for introducing process gas into the treatment region comprises at least one cannula (64), the internal opening diameter of which is between 0.1 and 5.0 mm, preferably between 0.2 mm and 3.0 mm, particularly preferably between 0.3 mm and 2.0 mm and the wall thickness of which is between 0.05 mm and 3.0 mm, preferably between 0.1 mm and 2.0 mm, particularly preferably between 0.15 mm and 1.0 mm.

**28.** Apparatus as claimed in claim 26 or 27, **characterised in that** the device for introducing process gas comprises a device for introducing the process gas through a further opening at a second end of the workpiece (10) located opposite the first end.

**29.** Apparatus as claimed in any one of claims 26 to 28, adapted for the plasma treatment of inner sides of syringe bodies (10).

**30.** Apparatus as claimed in claim 29, **characterised by** a connection device to connect an evacuation device (90) for at least partially evacuating the cavity (13) of the syringe body (10) onto the plunger opening (12) of the syringe.

**31.** Apparatus as claimed in claim 29 or 30, **characterised by** a device for introducing the process gas through the Luer cone (15) of the syringe body (10).

**32.** Apparatus as claimed in any one of claims 27 to 32, **characterised by** at least one local shield (30, 32) which surrounds the workpiece (10) and locally shields regions of the cavity (13) of the workpiece (10) from introduced electromagnetic energy.

**33.** Apparatus as claimed in any one of claims 26 to 32, adapted for an external coating of workpieces (10), having a device (90) for at least partially evacuating the area surrounding a workpiece (10) in the reactor chamber (2).

**34.** Apparatus as claimed in any one of claims 26 to 33, **characterised by** reactors (100) movable along a transport path for the plasma treatment of workpieces (10), a feeding position for feeding the workpieces (10) to the reactors (100), to a removal position for removing the workpieces (10) from the reactors (100), and to a device for the plasma treatment between the feeding and removal positions having a device for introducing electromagnetic energy (54) into the cavity (13).

**35.** Apparatus as claimed in the preceding claim, **characterised in that** the plurality of coating locations comprise in each case separate energy sources (101) for providing electromagnetic energy, as well as separate antechambers (28) which are connected to the coating regions and are connected at a common vacuum generation device (90), preferably via a further chamber, wherein in each case devices for exciting the process gas, which are connected in each case to separate second energy sources (101), are arranged in the antechambers (28).

**36.** Apparatus as claimed in any one of claims 26 to 25, **characterised by** a shield (30, 32) for the electromagnetic energy to decouple the supply line of the reactor chamber (2) to the evacuation device (90).

**37.** Apparatus as claimed in any one of claims 26 to 36, **characterised by** an antechamber (28) leading to the reactor space (2), wherein the device for evacuating (90) is connected to the antechamber (28).

**38.** Apparatus for the plasma treatment of workpieces as claimed in any one of claims 26 to 37, having a reactor chamber (2) for receiving a workpiece (10) to be coated, a device for at least partially evacuating (90) at least one region of the reactor chamber (2), a device for introducing electromagnetic energy (54) into the reactor chamber (2), as well as a space separated from the reactor chamber (2), and a device for igniting a plasma in the reactor chamber (2), wherein the ignition device comprises a device for exciting gas in the space (28) separated from the reactor chamber (2).

**39.** Apparatus as claimed in claim 38, **characterised in that** the ignition device comprises a device for generating a glow discharge in the space (28) separated from the reactor chamber (2).

**40.** Apparatus as claimed in claim 39, **characterised by** a preferably optical monitoring device (23) for the glow discharge.

**41.** Apparatus as claimed in any one of claims 26 to 40, **characterised in that** the device for introducing electromagnetic energy (54) into the reactor chamber (2) comprises a coaxial conductor (19), wherein the treatment region can be evacuated through the coaxial conductor (19).

**42.** Apparatus as claimed in claim 41, **characterised in that** the coaxial conductor (19) comprises an axially extending channel, through which the process gas can be fed.

**43.** Apparatus as claimed in claim 42, **characterised in that** an ignition device, in particular an ignition electrode (29), is provided for generating a glow discharge in the channel through the inner conductor (20).

**44.** Apparatus as claimed in any one of claims 26 to 43, **characterised by** a filler body (84) which at least partially fills a cavity (13) of a workpiece (10) to be treated.

**45.** Apparatus as claimed in claim 44, **characterised in that** the filler body (84) absorbs or reflects high-frequency electromagnetic energy.

**46.** Apparatus as claimed in claim 44 or 45, **characterised in that** the filler body (84) prevents ignition of a plasma in the area immediately surrounding the filled region.

**47.** Apparatus as claimed in any one of claims 42 to 44, **characterised in that** the filler body (84) is integrated into a coaxial inner conductor (20).

**Revendications**

**1.** Procédé pour le traitement par plasma de pièces en forme de corps creux, dans lequel le vide est produit au moins en partie dans une zone de traitement dans une chambre de réacteur, un gaz de processus étant introduit dans la zone de traitement, en particulier dans l'espace creux de la pièce et, au moyen d'une énergie électromagnétique injectée, un plasma étant généré dans l'environnement d'au moins une partie de la surface de la pièce, **caractérisé en ce que**, pendant une excitation du gaz par une décharge luminescente, le plasma est amorcé dans une chambre (28) séparée de la chambre de réacteur (2) par l'injection d'une énergie électromagnétique dans le gaz de processus introduit, et **en ce que**, pendant le traitement par plasma, le gaz de processus circule à travers la zone de traitement entre des extrémités opposées de la zone.

**2.** Procédé selon la revendication 1, **caractérisé en ce que** le traitement par plasma est effectué exclusivement sur la face intérieure (13) du corps creux (10).

**3.** Procédé selon la revendication 1 ou 2, **caractérisé en ce que** le traitement par plasma est effectué exclusivement sur la face extérieure de la pièce (10).

**4.** Procédé selon l'une quelconque des revendications 1 à 3, **caractérisé en ce que** le traitement par plasma est effectué tant sur la face intérieure (13) que sur la face extérieure du corps creux (10) et **en ce que**, de préférence, les traitements par plasma sur la face intérieure (13) et la face extérieure du corps creux (10) sont différents ou influent différemment sur les surfaces.

**5.** Procédé selon l'une quelconque des revendications précédentes, **caractérisé en ce que** la pièce (10) :

i) a une forme cylindrique ou similaire et a un diamètre extérieur maximum entre 1 mm à 50 mm, de préférence entre 3 mm à 30 mm, de manière particulièrement préférée de 5 mm à 20 mm, et une hauteur de 10 mm à 200 mm, de préférence de 30 mm à 150 mm, de manière particulièrement préférée de 50 mm à 100 mm, ou
ii) a un diamètre intérieur maximum entre 1 mm à 50 mm, de préférence entre 2 mm à 29 mm, de manière particulièrement préférée de 4 mm à 20 mm, et une hauteur de 10 mm à 200 mm, de préférence de 30 mm à 150 mm, de manière particulièrement préférée de 50 mm à 100 mm, et une épaisseur de paroi de 0,2 mm à 10 mm, de préférence de 0,3 mm à 8 mm, de manière particulièrement préférée de 2 mm à 5 mm, ou

iii) **en ce que** la pièce comporte une deuxième forme (15) cylindrique ou similaire avec un plus petit diamètre et une plus petite longueur, lesquels sont inférieurs d'au moins 20 %, de préférence inférieurs de 50 % au diamètre maximum et à la hauteur, ou

iv) **en ce que** la pièce (10) comporte une deuxième forme (15) cylindrique ou similaire avec un plus petit diamètre et une plus petite longueur, qui a diamètre intérieur en forme de canule, de préférence étroit, entre 0,01 et 15 mm, de manière particulièrement préférée entre 0,05 et 4 mm, ou

v) a un volume dans une plage de 0,1 à 100 ml, de préférence dans une plage de 0,2 à 40 ml, de manière particulièrement préférée de 0,5 à 20 ml.

6. Procédé selon l'une quelconque des revendications précédentes, **caractérisé en ce que** la pièce (10) a une forme cylindrique ou similaire, avec une première surface cylindrique ou similaire et comporte une forme (11) cylindrique ou similaire avec une deuxième surface (15) cylindrique ou similaire, au moins une couche mince avec une épaisseur D1 étant appliquée sur la première surface cylindrique ou similaire et la couche avec une épaisseur D2 étant appliquée sur la deuxième surface à forme cylindrique similaire, la condition $0,2 \leq D2/D1 \leq 5$, de préférence $0,4 \leq D2/D1 \leq 1,5$, de manière particulièrement préférée $0,7 \leq D2/D1 \leq 1,2$ étant remplie pour le rapport entre l'épaisseur D1 et l'épaisseur D2.

7. Procédé selon l'une quelconque des revendications précédentes, **caractérisé en ce que** le gaz de processus est introduit dans la zone de traitement par l'intermédiaire d'au moins une canule (64), dont le diamètre d'ouverture intérieur se situe entre 0,1 et 5,0 mm, de préférence entre 0,2 mm et 3,0 mm, de manière particulièrement préférée entre 0,3 mm et 2,0 mm, et dont l'épaisseur de paroi se situe entre 0,05 mm et 3,0 mm, de préférence entre 0,1 mm et 2,0 mm, de manière particulièrement préférée entre 0,15 mm et 1,0 mm.

8. Procédé selon l'une quelconque des revendications précédentes, **caractérisé en ce que** le vide est produit dans la pièce (10) par l'intermédiaire d'une ouverture (12) à une première extrémité et le gaz de processus est introduit par une autre ouverture (16) à une deuxième extrémité (15) de la pièce (10), laquelle est opposée à la première extrémité, et **en ce que**, de préférence, de l'énergie électromagnétique est injectée dans le sens axial, en particulier de préférence axialement et symétriquement à la pièce (10).

9. Procédé selon l'une quelconque des revendications précédentes, **caractérisé en ce que** des corps de seringue (10) sont soumis à un traitement par plasma sur la face intérieure.

10. Procédé selon la revendication 9, dans lequel le vide est produit dans l'espace creux (13) de la seringue (10) par l'intermédiaire de l'ouverture du piston (12).

11. Procédé selon la revendication 9 ou 10, dans lequel le gaz de processus est introduit par un cône Luer (15) du corps de seringue (10).

12. Procédé selon la revendication 9 ou 10, dans lequel le gaz de processus est introduit par l'intermédiaire de l'ouverture du piston (16) du corps de seringue (10).

13. Procédé selon l'une quelconque des revendications précédentes, **caractérisé en ce que** le traitement par plasma comporte au moins une, de préférence deux, des étapes revêtement plasma, activation par plasma, traitement préliminaire par plasma, nettoyage par plasma, immersion plasma, modification par plasma, stérilisation par plasma.

14. Procédé selon l'une quelconque des revendications précédentes, **caractérisé en ce qu'**au moins une couche est déposée par le traitement par plasma, laquelle :

i) possède un effet barrière contre les gaz, ou

ii) comporte un effet barrière contre des composants issus de la pièce, tels que des composés initiaux ou secondaires ou finaux provenant de la fabrication de la pièce, ou **en ce que** :

iii) une couche barrière avec un effet barrière chimique est déposée, ou

iv) une couche de protection contre les griffures est déposée, ou

v) une couche réfléchissant les UV ou absorbant les UV est déposée, ou

vi) une couche colorante, de préférence une couche paraissant bleue, est déposée, ou

vii) une couche polie ou dépolie est déposée.

15. Procédé selon l'une quelconque des revendications précédentes, **caractérisé en ce que** le traitement est appliqué sur une surface en matière plastique de la pièce (10), qui comporte au moins un des matériaux suivantes :

des carbones polycycliques, tels des polymères ou copolymères cycliques, de préférence des copolymères ou polymères polyoléfiniques cycliques, de manière particulièrement préférée des copolymères de cyclooléfines, en particulier des topas ou polymères de cyclooléfines, des polycarbonates, de préférence des polycarbonates autoclavables,

des polytéréphtalates d'éthylène (PET) ou PETG, du polystyrène, du polyéthylène, tel que MDPE, mais en particulier HDPE ou LDPE, du polypropylène, également un polypropylène orienté (o-PP), ou un polypropylène bi-orienté (BOPP),

du polyméthacrylate de méthyle, PES, polynaphtalate d'éthylène (PEN), SAN, des polymères fluorés, de préférence le polychlorotrifluoroéthylène (PCTFE), EVOH, polyamide, PVC, PVDC, PMMI, PA, ABS, MABS, PMP, PES, PSI.

16. Procédé selon l'une quelconque des revendications 1 à 14, **caractérisé en ce que** le traitement par plasma est appliqué sur une pièce (10) en verre, en vitrocéramique ou en céramique.

17. Procédé selon l'une quelconque des revendications précédentes, **caractérisé en ce que** l'énergie électro-magnétique est injectée au moyen d'électrodes (56, 58) dans l'espace creux (13).

18. Procédé selon l'une quelconque des revendications précédentes, **caractérisé en ce qu'**un flux axialement symétrique du gaz de processus est établi à travers l'espace creux (13) de la pièce (10), et **en ce que**, de préférence, une énergie électromagnétique est injectée dans le sens axial, de manière particulièrement préférée axialement symétrique dans l'espace creux (13).

19. Procédé pour le traitement par plasma de pièces selon l'une quelconque des revendications précédentes, dans lequel le plasma est amorcé par une excitation du gaz dans une chambre (28) séparée de la chambre de réacteur (2), tandis que l'énergie électromagnétique pour générer le plasma est injectée dans le gaz de processus introduit et lors de l'excitation il se forme des espèces ou un rayonnement riches en énergie, tels que :

i) des électrons excités,
ii) des ions excités,
iii) des particules neutres excitées,
iv) un rayonnement ultraviolet,

et l'amorçage du plasma est favorisé par ceux-ci.

20. Procédé selon la revendication 19, **caractérisé en ce que** le plasma est amorcé dans l'environnement au moyen d'une décharge luminescente dans la chambre (28) séparée et **en ce que** la décharge luminescente est amorcée de préférence par au moins un des paramètres suivantes :

i) par une haute tension dans une plage de 0,1 kV à 100 kV,
ii) un courant alternatif avec une fréquence de 0,2 KHz à 100 MHz, de préférence 1 KHz à 100 KHz,
iii) un courant alternatif effectif dans une plage de 0,01 mA à 2 A, de préférence dans une plage de 0,1 mA à 500 mA.

21. Procédé selon l'une quelconque des revendications précédentes, **caractérisé en ce que** l'énergie électro-magnétique est acheminée via un conducteur coaxial (19) et le gaz de processus est acheminé via un conducteur interne (20) du conducteur coaxial.

22. Procédé selon l'une quelconque des revendications précédentes, **caractérisé en ce que** l'énergie électro-magnétique est injectée via un conducteur coaxial (19), de préférence dans le sens axial, et la production du vide dans la zone de traitement est effectuée via le conducteur coaxial.

23. Procédé selon l'une quelconque des revendications précédentes, **caractérisé en ce qu'**une couche fonctionnelle est déposée au moyen d'une déposition plasma, de préférence avec une puissance moyenne de 300 watts maximum, de manière particulièrement préférée de 100 watts maximum, sur un conditionnement pharmaceutique, en particulier un corps de seringue (10), une fiole, un tube de prélèvement sanguin ou une ampoule cylindrique.

24. Procédé selon l'une quelconque des revendications précédentes, **caractérisé en ce que**, par le traitement par plasma, est déposée une couche qui contient au moins une des substances $SiO_x$, $SiO_xC_y$, $SiO_xN_y$, $SiN_y$, $TiO_x$, $Al_xO_yN_7$, $Al_xN_z$, $Al_xO_y$, $C_xH_y$, $C_xF_y$, $TiN_x$.

25. Procédé selon l'une quelconque des revendications précédentes, **caractérisé en ce qu'**au moins un corps de remplissage (84) occupe au moins en partie un espace creux (13) d'une pièce (10) à traiter, et, de ce fait, la répartition de la température sur la pièce (10) devient plus uniforme pendant et après le traitement par plasma.

26. Dispositif pour le traitement par plasma de pièces en forme de corps creux, configuré pour la mise en oeuvre du procédé selon l'une des revendications précédentes, comportant une chambre de réacteur, une zone de traitement dans la chambre de réacteur, un dispositif pour la production du vide au moins en partie dans la zone de traitement dans la chambre de réacteur, un dispositif pour injecter une énergie électromagnétique dans la zone de traitement pour la production d'un plasma, et un dispositif pour introduire le gaz de processus dans la zone de traitement, **caractérisé en ce que** le dispositif pour introduire le gaz de processus et le dispositif pour la production du vide dans la zone de traitement sont disposés de telle sorte que le gaz de processus, en cours de service, circule à travers la zone de traitement entre des extrémités opposés de la zone, et **caractérisé par** un dispositif pour produire une décharge luminescente (29) dans une chambre (28) séparée de la chambre de réacteur (2), afin de mettre à disposition des espèces excitées dans la zone de traitement pour la production du plasma.

27. Dispositif selon la revendication 26, dans lequel le dispositif pour introduire le gaz de processus dans la zone de traitement comporte au moins une canule (64) dont le diamètre d'ouverture intérieur se situe entre 0,1 et 5,0 mm, de préférence entre 0,2 mm et 3,0 mm, de manière particulièrement préférée entre 0,3 mm et 2,0 mm, et dont l'épaisseur de paroi se situe entre 0,05 mm et 3,0 mm, de préférence entre 0,1 mm et 2,0 mm, de manière particulièrement préférée entre 0,15 mm et 1,0 mm.

28. Dispositif selon la revendication 26 ou 27, **caractérisé en ce que** le dispositif pour introduire le gaz de processus comporte un dispositif pour introduire le gaz de processus par une autre ouverture au niveau d'une deuxième extrémité de la pièce (10), laquelle est opposée à la première extrémité.

29. Dispositif selon l'une quelconque des revendications 26 à 28, configuré pour le traitement par plasma des faces intérieures des corps de seringue (10).

30. Dispositif selon la revendication 29, **caractérisé par** un dispositif de raccordement pour raccorder, à l'ouverture (12) du piston de la seringue, un dispositif de production du vide (90) pour produire le vide au moins en partie dans l'espace creux (13) du corps de seringue (10).

31. Dispositif selon la revendication 29 ou 30, **caractérisé par** un dispositif pour introduire le gaz de processus par l'intermédiaire du cône Luer (15) du corps de seringue (10).

32. Dispositif selon l'une quelconque des revendications 27 à 32, **caractérisé par** au moins un blindage (30, 32) local, qui entoure la pièce (10) et protège localement des zones de l'espace creux (13) de la pièce (10) contre l'énergie électromagnétique injectée.

33. Dispositif selon l'une quelconque des revendications 26 à 32, configuré pour le revêtement extérieur de pièces (10), comportant un dispositif (90) pour produire le vide au moins en partie dans l'environnement d'une pièce (10) dans la chambre de réacteur (2).

34. Dispositif selon l'une quelconque des revendications 26 à 33, **caractérisé par** des réacteurs (100), mobiles le long d'une voie de transport, pour le traitement par plasma de pièces (10), un poste d'acheminement pour acheminer les pièces (10) vers les réacteurs (100), un poste de retrait pour retirer les pièces (10) hors des réacteurs (100), et un dispositif pour le traitement par plasma entre le poste d'acheminement et le poste de retrait, avec un dispositif pour l'injection d'énergie électromagnétique (54) dans l'espace creux (13).

35. Dispositif selon la revendication précédente, **caractérisé en ce que** les différentes zones de revêtement comportent respectivement des sources d'énergie (101) séparées pour la mise à disposition de l'énergie électro-magnétique, ainsi que des préchambres (28) séparées, qui sont reliées aux zones de revêtement et sont reliées à un dispositif de production du vide (90) commun, de préférence par l'intermédiaire d'une chambre supplémentaire, des dispositifs pour l'excitation du gaz de processus, raccordés respectivement à des deuxièmes sources d'énergie (101) séparées, étant disposés respectivement dans les préchambres (28).

**36.** Dispositif selon l'une quelconque des revendications 26 à 35, **caractérisé par** un blindage (30, 32) pour l'énergie électromagnétique en vue du découplage de la conduite d'admission de la chambre de réacteur (2) vers le dispositif de production du vide (90).

**37.** Dispositif selon l'une quelconque des revendications 26 à 36, **caractérisé par** une préchambre (28) vers la chambre de réacteur (2), le dispositif de production du vide (90) étant raccordé à la préchambre (28).

**38.** Dispositif pour le traitement par plasma de pièces selon l'une quelconque des revendications 26 à 37, comportant une chambre de réacteur (2) pour recevoir une pièce (10) à revêtir, un dispositif pour produire le vide (90) au moins en partie dans au moins une zone de la chambre de réacteur (2), un dispositif pour injecter l'énergie électromagnétique (54) dans la chambre de réacteur (2), ainsi qu'une chambre séparée de la chambre de réacteur (2), et un dispositif d'amorçage pour un plasma dans la chambre de réacteur (2), le dispositif d'amorçage comportant un dispositif pour l'excitation du gaz dans la chambre (28) séparée de la chambre de réacteur (2).

**39.** Dispositif selon la revendication 38, **caractérisé en ce que** le dispositif d'amorçage comporte un dispositif pour générer une décharge luminescente dans la chambre (28) séparée de la chambre de réacteur (2).

**40.** Dispositif selon la revendication 39, **caractérisé par** un dispositif de surveillance (23), de préférence optique, pour la décharge luminescente.

**41.** Dispositif selon l'une quelconque des revendications 26 à 40, **caractérisé en ce que** le dispositif pour injecter l'énergie électromagnétique (54) dans la chambre de réacteur (2) comporte un conducteur coaxial (19), la production du vide dans la zone de traitement étant effectuée via le conducteur coaxial (19).

**42.** Dispositif selon la revendication 41, **caractérisé en ce que** le conducteur coaxial (19) comporte un canal orienté dans le sens axial, à travers lequel peut être acheminé le gaz de processus.

**43.** Dispositif selon la revendication 42, **caractérisé en ce qu'**il est prévu un dispositif d'amorçage, en particulier une électrode d'amorçage (29) pour générer une décharge luminescente dans le canal à travers le conducteur interne (20).

**44.** Dispositif selon l'une quelconque des revendications 26 à 43, **caractérisé par** un corps de remplissage (84) qui occupe au moins en partie un espace creux (13) d'une pièce (10) à traiter.

**45.** Dispositif selon la revendication 44, **caractérisé en ce que** le corps de remplissage (84) absorbe ou réfléchit l'énergie électromagnétique à haute fréquence.

**46.** Dispositif selon la revendication 44 ou 45, **caractérisé en ce que** le corps de remplissage (84) empêche un amorçage d'un plasma dans l'environnement immédiat de la zone occupée.

**47.** Dispositif selon l'une quelconque des revendications 42 à 44, **caractérisé en ce que** le corps de remplissage (84) est intégré dans un conducteur interne coaxial (20).

Fig. 1

Fig. 2

Gas

1

36

24

31

22

11

10   34   33

12

16

HF-
Energie

13

2

26

25

27   28   30

29

23

Fig. 3

Vakuum

**HF-Energie**

**Gas**     **Gas**

38                                40

39

44                                 15

<u>13</u>

10                <u>2</u>         12

42                                  <u>1</u>

30

                                     29

23                     <u>28</u>

**Vakuum**                **Fig. 4.**

**HF-Energy**

Fig. 5

**Vakuum**

Fig. 6

Fig. 7

HF-Energie

54

Gas

60

31

22

15

56

58

1

10

13

25

30

12

23

28

29

**Vakuum**

Fig. 8

**Fig. 9**

HF-
Energie

HF-
Energie

44

15

13

10

2

68

25

64

30

28

29

Vakuum

Gas

Fig. 10a

HF-
Energie

HF-
Energie

44

40

15

46

Gas2

Gas2

48

10

25

30

28

52

32

Vakuum 1

Vakuum 2

Vakuum 2

Gas1

Fig. 10b

Fig. 11

Fig. 12

Fig. 13

Fig. 14

Fig. 15

Fig. 16

## Fig. 17

## Fig. 18

Fig. 19

**IN DER BESCHREIBUNG AUFGEFÜHRTE DOKUMENTE**

**In der Beschreibung aufgeführte Patentdokumente**

- EP 1206389 B1
- EP 1251190 A1
- DE 19629877 C1
- DE 19634795 C2
- DE 4438359 C2

- DE 3116026 A1
- WO 0236850 A2
- WO 2004031438 A1
- EP 0773167 A1
- JP 05255857 A